(19) Europäisches Patentamt / European Patent Office / Office européen des brevets

(11) **EP 1 980 041 B1**

## (12) EUROPEAN PATENT SPECIFICATION

(45) Date of publication and mention
of the grant of the patent:
**09.12.2015  Bulletin 2015/50**

(21) Application number: **07757111.5**

(22) Date of filing: **16.02.2007**

(51) Int Cl.:
*H04B 14/04* (2006.01)     *H03M 13/37* (2006.01)
*H04L 1/00* (2006.01)     *H03M 13/29* (2006.01)
*H03M 13/11* (2006.01)     *H03M 13/19* (2006.01)

(86) International application number:
**PCT/US2007/062302**

(87) International publication number:
**WO 2007/098397 (30.08.2007 Gazette 2007/35)**

(54) **MULTIPLE-FIELD BASED CODE GENERATOR AND DECODER FOR COMMUNICATIONS SYSTEMS**

KODE ERZEUGER MIT MEHREREN FELDERN UND DEKODER FÜR KOMMUNIKATIONSANORDNUNGEN

GÉNÉRATEUR DE CODES ET DÉCODEUR À CHAMPS MULTIPLES POUR SYSTÈMES DE COMMUNICATIONS

(84) Designated Contracting States:
**AT BE BG CH CY CZ DE DK EE ES FI FR GB GR HU IE IS IT LI LT LU LV MC NL PL PT RO SE SI SK TR**

(30) Priority: **21.02.2006  US 775528 P**
**13.02.2007  US 674655**

(43) Date of publication of application:
**15.10.2008  Bulletin 2008/42**

(73) Proprietor: **Digital Fountain, Inc.**
**San Diego, CA 92121 (US)**

(72) Inventors:
• **SHOKROLLAHI, M. Amin**
**San Jose, California 95123 (US)**
• **LUBY, Michael G.**
**Berkeley, California 94708 (US)**
• **WATSON, Mark**
**San Francisco, California 94114 (US)**

• **MINDER, Lorenz**
**1003 Lausanne (CH)**

(74) Representative: **Wagner & Geyer**
**Partnerschaft**
**Patent- und Rechtsanwälte**
**Gewürzmühlstrasse 5**
**80538 München (DE)**

(56) References cited:
**US-A1- 2005 219 070     US-A1- 2005 219 070**
**US-A1- 2006 036 930**

• **AMIN SHOKROLLAHI: "Raptor Codes", INTERNET CITATION, 13 January 2004 (2004-01-13), XP002367883, Retrieved from the Internet: URL:http://www.cs.huji.ac.il/labs/ danss/p2 p/resources/raptor.pdf [retrieved on 2006-02-15]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD OF THE INVENTION

The present invention relates to encoding and decoding data in communications systems and more specifically to communication systems that encode and decode data to account for errors and gaps in communicated data. Communication is used in a broad sense, and includes but is not limited to transmission of digital data of any form through space and/or time.

BACKGROUND OF THE INVENTION

Transmission of files and streams between a sender and a recipient over a communications channel has been the subject of much literature. Preferably, a recipient desires to receive an exact copy of data transmitted over a channel by a sender with some level of certainty. Where the channel does not have perfect fidelity (which covers most all physically realizable systems), one concern is how to deal with data lost or garbled in transmission. Lost data (erasures) are often easier to deal with than corrupted data (errors) because the recipient cannot always tell when corrupted data is data received in error. Many error-correcting codes have been developed to correct for erasures and/or for errors. Typically, the particular code used is chosen based on some information about the infidelities of the channel through which the data is being transmitted and the nature of the data being transmitted. For example, where the channel is known to have long periods of infidelity, a burst error code might be best suited for that application. Where only short, infrequent errors are expected a simple parity code might be best.

Data transmission is straightforward when a transmitter and a receiver have all of the computing power and electrical power needed for communications and the channel between the transmitter and receiver is clean enough to allow for relatively error-free communications. The problem of data transmission becomes more difficult when the channel is in an adverse environment or the transmitter and/or receiver has limited capability.

One solution is the use of forward error correcting (FEC) techniques, wherein data is coded at the transmitter such that a receiver can recover from transmission erasures and errors. Where feasible, a reverse channel from the receiver to the transmitter allows for the receiver to communicate about errors to the transmitter, which can then adjust its transmission process accordingly. Often, however, a reverse channel is not available or feasible or is available only with limited capacity. For example, where the transmitter is transmitting to a large number of receivers, the transmitter might not be able to handle reverse channels from all those receivers. As another example, the communication channel may be a storage medium and thus the transmission of the data is forward through time and, unless someone invents a time travel machine that can go back in time, a reverse channel for this channel is infeasible. As a result, communication protocols often need to be designed without a reverse channel or with a limited capacity reverse channel and, as such, the transmitter may have to deal with widely varying channel conditions without a full view of those channel conditions.

The problem of data transmission between transmitters and receivers is made more difficult when the receivers need to be low-power, small devices that might be portable or mobile and need to receive data at high bandwidths. For example, a wireless network might be set up to deliver files or streams from a stationary transmitter to a large or indeterminate number of portable or mobile receivers either as a broadcast or multicast where the receivers are constrained in their computing power, memory size, available electrical power, antenna size, device size and other design constraints. Another example is in storage applications where the receiver retrieves data from a storage medium which exhibits infidelities in reproduction of the original data. Such receivers are often embedded with the storage medium itself in devices, for example disk drives, which are highly constrained in terms of computing power and electrical power.

In such a system, considerations to be addressed include having little or no reverse channel, limited memory, limited computing cycles, power, mobility and timing. Preferably, the design should minimize the amount of transmission time needed to deliver data to potentially a large population of receivers, where individual receivers and might be turned on and off at unpredictable times, move in and out of range, incur losses due to link errors, mobility, congestion forcing lower priority file or stream packets to be temporarily dropped, etc.

In the case of a packet protocol used for data transport over a channel that can lose packets, a file, stream or other block of data to be transmitted over a packet network is partitioned into equal size input symbols, encoding symbols the same size as the input symbols are generated from the input symbols using an FEC code, and the encoding symbols are placed and sent in packets. The "size" of a symbol can be measured in bits, whether or not the symbol is actually broken into a bit stream, where a symbol has a size of M bits when the symbol is selected from an alphabet of $2^M$ symbols. In such a packet-based communication system, a packet oriented erasure FEC coding scheme might be suitable. A file transmission is called reliable if it allows the intended recipient to recover an exact copy of the original file even in the face of erasures in the network. A stream transmission is called reliable if it allows the intended recipient to recover an exact copy of each part of the stream in a timely manner even in the face of erasures in the network. Both file transmission and stream transmission can also be somewhat reliable, in the sense that some parts of the file or stream are not recoverable or for streaming if some parts of the stream are not recoverable in a timely fashion. Packet loss often occurs because sporadic congestion causes the buffering mechanism in a router to reach its capacity, forcing it to drop incoming packets. Protection against erasures during transport has been the subject of much study.

In the case of a protocol used for data transmission over a noisy channel that can corrupt bits, a block of data to be transmitted over a data transmission channel is partitioned into equal size input symbols, encoding symbols of the same size are generated from the input symbols and the encoding symbols are sent over the channel. For such a noisy channel the size of a symbol is typically one bit or a few bits, whether or not a symbol is actually broken into a bit stream. In such a communication system, a bit-stream oriented error-correction FEC coding scheme might be suitable. A data transmission is called reliable if it allows the intended recipient to recover an exact copy of the original block even in the face of errors (symbol corruption, either detected or undetected in the channel). The transmission can also be somewhat reliable, in the sense that some parts of the block may remain corrupted after recovery. Symbols are often corrupted by sporadic noise, periodic noise, interference, weak signal, blockages in the channel, and a variety of other causes. Protection against data corruption during transport has been the subject of much study.

Chain reaction codes are FEC codes that allow for generation of an arbitrary number of output symbols from the fixed input symbols of a file or stream. Sometimes, they are referred to as fountain or rateless FEC codes, since the code does not have an a priori fixed transmission rate. Chain reaction codes have many uses, including the generation of an arbitrary number of output symbols in an information additive way, as opposed to an information duplicative way, wherein the latter is where output symbols received by a receiver before being able to recover the input symbols duplicate already received information and thus do not provide useful information for recovering the input symbols. Novel techniques for generating, using and operating chain reaction codes are shown, for example, in Luby I, Luby II, Shokrollahi I and Shokrollahi II.

One property of the output symbols produced by a chain reaction encoder is that a receiver is able to recover the original file or block of the original stream as soon as enough output symbols have been received. Specifically, to recover the original K input symbols with a high probability, the receiver needs approximately K+A output symbols. The ratio A/K is called the "relative reception overhead." The relative reception overhead depends on the number K of input symbols, and on the reliability of the decoder.

It is also known to use multi-stage chain reaction ("MSCR") codes, such as those described in Shokrollahi I and/or II and developed by Digital Fountain, Inc. under the trade name "Raptor" codes. Multi-stage chain reaction codes are used, for example, in an encoder that receives input symbols from a source file or source stream, generates intermediate symbols from the input symbols and encodes the intermediate symbols using chain reaction codes. More particularly, a plurality of redundant symbols is generated from an ordered set of input symbols to be communicated. A plurality of output symbols are generated from a combined set of symbols including the input symbols and the redundant symbols, wherein the number of possible output symbols is much larger than the number of symbols in the combined set of symbols, wherein at least one output symbol is generated from more than one symbol in the combined set of symbols and from less than all of the symbols in the combined set of symbols, and such that the ordered set of input symbols can be regenerated to a desired degree of accuracy from any predetermined number, *N*, of the output symbols. It is also known to use the techniques described above to encode and decode systematic codes, in which the input symbols are includes amongst the possible output symbols of the code. This may be achieved as described in Shokrollahi II by first applying a transformation to the input symbols followed by the steps described above, said enhanced process resulting in the first output symbols generated by the code being equal to the input symbols. As will be clear to those of skill in the art of error and erasure coding, the techniques of Shokrollahi II may be applied directly to the codes described or suggested herein.

For some applications, other variations of codes might be more suitable or otherwise preferred.

The MSCR codes and chain reaction codes described above are extremely efficient in terms of their encoding and decoding complexity. One of the reasons for their efficiency is that the operations that are performed are linear operations over the field GF(2), i.e., the simple field over one bit where the operation of adding two field elements is simply the logical XOR operation, and the operation of multiplying two field elements is simply the logical AND operation. Generally these operations are performed over multiple bits concurrently, e.g., 32 bits at a time or 4 bytes at a time, and such operations are supported natively on all modem CPU processors. On the other hand, when used as erasure FEC codes, because the operations are over GF(2), it turns out that the chance that the receiver can decode all the input symbols goes down by at most approximately one-half for each additional symbol received beyond the first K, where K is the number of original input symbols. For example, if K+A encoding symbols are received then the chance that the recover process fails to recover the K original input symbols is at least $2^{-A}$. What would be a more desirable behavior is if the chance of decoding failure decreased more rapidly as a function of A.

There are other erasure and error-correcting FEC codes that operate over larger fields, for example Reed-Solomon codes that operate over GF(4), or over GF(8), or over GF(256), or more generally over $GF(2^L)$ for any L > 1, and also LDPC codes that operate over larger fields. The advantage of such FEC codes is that, for example in the case of erasure FEC codes, the chance of decoding failure decreases much more rapidly as a function of A than FEC codes over GF(2). On the other hand, these FEC codes are typically much less efficient in terms of encoding and decoding complexity, and one of the primary reasons for that is because the operations over larger fields are much more complex and/or are not natively supported on modern CPUs, and the complexity typically grows as the field size grows. Thus, the FEC codes that operate over larger finite fields are often much slower or impractical compared to FEC codes that operate over GF(2).

Thus, what is needed are erasure and error-correcting FEC codes that are extremely efficient in terms of their encoding and decoding complexity with the property that the chance of decoding failure decreases very rapidly as a function of the number of symbols received beyond the minimal number needed by an ideal FEC code to recover the original input symbols.

Attention is drawn again to US 2005/219070 A1 (recited on page 1) which describes an encoder that uses output symbol subsymbols to effect or control a tradeoff of computational effort and overhead efficiency to, for example, greatly reduce computational effort for the cost of a small amount of overhead efficiency. An encoder reads an ordered plurality of input symbols, comprising an input file or input stream, and produces output subsymbol. The ordered plurality of input symbols are each selected from an input alphabet, and the generated output subsymbols comprise selections among an output subsymbol alphabet. An output subsymbol is generated using a function evaluator applied to subsymbols of the input symbols. The encoder may be called one or more times, each time producing an output subsymbol. Output subsymbols can then be assembled into output symbols and transmitted to their destination.; The functions used to generate the output subsymbols from the input subsymbols can be XOR's of some of the input subsymbols and these functions are obtained from a linear code defined over an extension field of GF(2) by transforming each entry in a generator or parity-check matrix of this code into an appropriate binary matrix using a regular representation of the extension field over GF(2). In a decoder, output subsymbols received by the recipient are obtained from output symbols transmitted from one sender that generated those output symbols based on an encoding of an input sequence (file, stream, etc.).

## BRIEF SUMMARY OF THE INVENTION

In accordance with the present invention a method of encoding, and a method of decoding, as set forth in the independent claims, respectively, are provided. Preferred embodiments of the invention are described in the dependent claims.

According to one embodiment of the invention, a method of encoding data for transmissions from a source to a destination over a communications channel is provided. The method operates on an ordered set of input symbols and may generate zero or more redundant symbols from the input symbols, each redundant symbol being equal to a linear combination of a number of the input symbols with coefficients taken from one or more finite fields, wherein the finite field used may differ as between different input symbols and between different redundant symbols. The method includes generation of a plurality of output symbols from the combined set of symbols including the input symbols, and the redundant symbols if there are any redundant symbols, wherein each output symbol may be generated from one or more of the combined input and redundant symbols, wherein each output symbol is generated as a linear combination of a number of the input and redundant symbols with coefficients taken from one or more finite fields wherein the finite field used may differ as between different input and redundant symbols, between different output symbols and between the output symbols and the redundant symbols and such that the ordered set of input symbols can be regenerated to a desired degree of accuracy from any predetermined number of the output symbols.

The methods can also be used to generate output symbols, wherein the number of possible output symbols that can be generated from a fixed set of input symbols may be much larger than the number of input symbols.

According to an example, the method includes receiving at a destination at least some of the output symbols sent from a source over a communications channel, where the transmission over the channel may result in the loss or corruption of some of the sent symbols, and where some of the received symbols may be known to be correctly received and information about the degree of corruption of symbols may also be provided. The method includes regenerating at the destination the ordered set of input symbols to a desired degree of accuracy that depends on how many symbols are received and the knowledge of the corruption of the received symbols.

This example can also include receiving at a destination at least some of the output symbols, wherein the number of possible output symbols that can be received may be much larger than the number of input symbols.

According to another example a method of encoding data for transmission from a source to a destination over a communications channel is provided. The method operates on an ordered set of input symbols and includes generating a plurality of redundant symbols from the input symbols. The method also includes generating a plurality of output symbols from a combined set of symbols including the input symbols and the redundant symbols, wherein the operation applied in the generation of output symbols is over a small finite field (for example GF(2)) and such that the ordered set of input symbols can be regenerated to a desired degree of accuracy from any predetermined number of the output symbols. The plurality of redundant symbols is generated from the ordered set of input symbols, wherein the operations to generate the redundant symbols is over a finite field that is not GF(2) (for example, GF(256)) or is over a mix of more than one finite field (for example, some operations over GF(2), some operations over GF(256)).

According to still another example a system for receiving data transmitted from a source over a communications channel is provided using similar techniques. The system comprises a receive module coupled to a communications channel for receiving output symbols transmitted over the communications channel, wherein each output symbol is generated from at least one symbol in the combined set of symbols including the input symbols and the redundant symbols, wherein the operation applied in the generation of output symbols is over a small finite field (for example GF(2)) and such that the ordered set of input symbols can be regenerated to a desired degree of accuracy from any predetermined number of the output symbols, wherein the input symbols are from an ordered set of input symbols, wherein the redundant symbols are generated from the input symbols and wherein the plurality of redundant symbols is generated from the ordered set of input symbols, wherein the operations to generate the redundant symbols is over a finite field that is not GF(2) (for example, GF(256)) or is over a mix of more than one finite field (for example, some operations over GF(2), some operations over GF(256)).

According to yet another example a computer data signal embodied in a carrier wave is provided.

Numerous benefits are achieved by way of the present invention. For example, in a specific embodiment, the computational expense of encoding data for transmission over a channel is reduced. In another specific embodiment, the computational expense of decoding such data is reduced. In yet another specific embodiment, the error probability of the decoder is reduced, while keeping the computational expense of encoding and decoding low. Depending upon the embodiment, one or more of these benefits may be achieved. These and other benefits are provided in more detail throughout the present specification and more particularly below.

A further understanding of the nature and the advantages of the inventions disclosed herein may be realized by reference to the remaining portions of the specification and the attached drawings.

BRIEF DESCRIPTION OF THE DRAWINGS

Fig. 1 is a block diagram of a communications system according to one embodiment of the present invention.

Fig. 2 is a block diagram an encoder according to one embodiment of the present invention.

Fig. 3 is a simplified block diagram of a method of generating redundant symbols according to one embodiment of the present invention.

Fig. 4 is a simplified block diagram of the basic operation of a static encoder according to one embodiment of the present invention.

Fig. 5 is a simplified block diagram of a dynamic encoder according to one embodiment of the present invention.

Fig. 6 is a simplified block diagram of a basic operation of a dynamic encoder according to one embodiment of the present invention.

Fig. 7 is a simplified block diagram of a static encoder according to one embodiment of the present invention.

Fig. 8 is a simplified block diagram of the basic operation a static encoder according to one embodiment of the present invention.

Fig. 9 is a simplified diagram of a method for calculating encoding parameters according to one specific embodiment of a static encoder.

Fig. 10 is a simplified flow diagram of a static encoder according to another embodiment of the present invention.

Fig. 11 is a simplified block diagram of a decoder according to one embodiment of the present invention.

Fig. 12 is a simplified flow diagram of an operation of a decoder according to one embodiment of the present invention.

Fig. 13 is a simplified flow diagram of an operation of a decoder according to another embodiment of the present invention.

Fig. 14 is a simplified flow diagram of an operation of a decoder according to yet another embodiment of the present invention.

Fig. 15 is a simplified block diagram of a dynamic decoder according to one embodiment of the present invention.

Fig. 16 is a simplified block diagram of a static decoder according to one embodiment of the present invention.

Fig. 17 illustrates source symbol from sub-symbol mappings.

Fig. 18 illustrates possible settings of file download parameters for various file sizes.

Fig. 19 illustrates possible settings of streaming parameters for various source block sizes.

Fig. 20 illustrates a form of a matrix that represents a relationship between source and intermediate symbols.

Fig. 21 illustrates a degree distribution for the degree generator.

Fig. 22 illustrates a form of the matrix A that can be used for decoding.

Fig. 23 illustrates a block decomposition of the matrix **A** that can be used for decoding.

Fig. 24a illustrates a block decomposition of the matrix **X** that can be used for decoding.

Fig. 24b illustrates a block decomposition of the matrix **X** after several steps of the first phase of the decoding process.

Fig. 25 illustrates a block decomposition of the matrix **X** after some elimination steps.

Fig. 26 illustrates a block decomposition of a sub-matrix of **X** after further elimination steps.

Fig. 27 illustrates a block decomposition of the matrix **A** after elimination and deletion steps.

Fig. 28 illustrates a block decomposition of the matrix **A** after further elimination and deletion steps.

Fig. 29 illustrates a block decomposition of the matrix **A** after further elimination steps.

Fig. 30 illustrates a block decomposition of the matrix **A** after yet further elimination steps.

Fig. 31 shows a table of code failure probabilities for a (120,100) code constructed according to one preferred embodiment of the invention.

Fig. 32 shows a table of code failure probabilities for a (1110,100) code constructed according to one preferred embodiment of the invention.

The detailed description is followed by three appendices: Appendix A contains example values for systematic indices $J(K)$; Appendix B.1 contains example values for table $V_0$; and Appendix B.2 contains example values for table $V_1$.

<u>DETAILED DESCRIPTION OF SPECIFIC EMBODIMENTS</u>

The inventions described herein make use of mathematical operations for encoding and decoding based on operations in one or more finite fields. Finite fields are finite algebraic structures for which the four arithmetic operations are defined, and which form a field with respect to these operations. Their theory and their construction are well understood by those of skill in the art.

In the description that follows we shall require a multiplication process to be defined between the elements of a finite field and symbols which represent or are derived from the data to be encoded or decoded. Three distinct types of symbols are considered in this description: input symbols comprise information known to the sender which is to be communicated to the receiver, redundant symbols comprise symbols which are derived from the input symbols and output symbols comprise symbols which are transmitted by the sender to the receiver. Of the many possibilities for defining such a multiplication process, we concentrate on two particular ones: simple transformations, and interleaved transformations.

Simple transformations

In this case, the multiplication process is defined between an element $a$ from a finite field GF($2^M$) and a symbol $S$ that is $M$ bits in length. As used herein, "symbol" refers to a piece of data that is typically smaller than the source block. The size of a symbol can often be measured in bits, where a symbol has the size of $M$ bits and the symbol is selected from an alphabet of $2^M$ symbols. In applications of reliable transmission of information over packet networks, for example, the size of a symbol could be equal to the packet size, or it could be smaller, so that each packet contains one or more symbols.

In the case of simple transformation, the symbol $S$ is interpreted as an element of GF($2^M$), and the multiplication $a*S$ is defined as the normal multiplication in the field GF($2^M$). The operation performed on the symbol is called a "simple transformation" of the symbol. As an illustrative example, consider the field GF(4). Elements of GF(4) can be represented with 2 bits, for example according to their binary expansion. The field GF(4) has four field elements 00, 01, 10, 11, wherein addition is the normal exclusive-or of bit strings, and multiplication is defined via the table:

|    | 00 | 01 | 10 | 11 |
|----|----|----|----|----|
| 00 | 00 | 00 | 00 | 00 |
| 01 | 00 | 10 | 10 | 11 |
| 10 | 00 | 10 | 11 | 10 |
| 11 | 00 | 11 | 10 | 10 |

According to the above multiplication table the result of 10*01 would be 10, since 01 is the multiplicative neutral element (sometimes called the identity element) of the field.

Interleaved transformations

To illustrate interleaved transformations, we will make use of the mathematical concept of a ring. As is well-known to those of ordinary skill in the art, a ring is a set on which two operations, addition and multiplication, are defined such that these operations satisfy the distributive laws. Moreover, the set considered with addition alone forms an abelian group, i.e., the result of an addition is independent of the ordering of the summands, there is a neutral element 0 for addition, and for each element there is another element such that the sum of these elements is 0. The other requirement is that the multiplication has a neutral element 1, such that multiplication of any element with 1 does not change the value of that element. For a general ring, we do not require that any nonzero element has a multiplicative inverse, nor do we require that multiplication is commutative. When both these conditions are satisfied, however, then we call the ring a "field." This notation is a standard one in the area of algebra.

A mapping (symbol-wise sum) is a logical construct implementable in hardware, software, data storage, etc. that maps pairs of symbols of the same size to another symbol of that size. We denote this mapping by $\oplus$, and the image of this map on the pair $(S, T)$ of symbols by $S \oplus T$. An example of such a mapping is the bit-wise exclusive-or (XOR).

Another construct used here is that of the "action" of a special type of sets on symbols. Suppose that $A$ is a set equipped with a commutative addition operation "+" that has a neutral element and that, for every element, contains its additive inverse. Such a set is also commonly called an abelian group. An "action" of this group on the set of symbols is a mapping that maps a pair, comprising a group element $r$ and a symbol $S$, to another symbol. We denote the image by $r*S$ where this mapping respects addition in the group, i.e., for every pair of elements $a$ and $b$ in the group $A$, $(a+b)*S = a*S \oplus b*S$. If $A$ is a ring and the action also respects multiplication in $A$, where the multiplication operator in $A$ is $\bullet$, i.e., $(a \bullet b)*S = a*(b*S)$, then this action is the desired multiplication process between elements of a finite field and symbols. In this setting we say that the field "operates" on the set of symbols. The operation performed on symbols in this way is called an "interleaved transformation."

There are abundant examples of such multiplication processes. A few examples are mentioned below. This list of examples is meant for illustrative purposes only, and should not be considered an exhaustive list, nor should it be construed to limit the scope of this invention.

The field GF(2) with field elements 0 and 1, with addition being exclusive-or (XOR) and multiplication being the logical operation AND, operates on the set of symbols by defining $1 * S = S$, and $0 * S = 0$, wherein S denotes an arbitrary symbol and **0** denotes the symbol that is entirely zeros.

The field GF(4) can operate on symbols of even size in the following way: for such a symbol $S$ we denote by

$S[0]$ and $S[1]$ its first and second half, respectively, so that $S = (S[0],S[1])$ is the concatenation of $S[0]$ and $S[1]$. Then, we define

$$00 * S = \mathbf{0}$$

$$01 * S = S$$

$$10 * S = (S[1], S[0] \oplus S[1])$$

$$11 * S = (S[0] \oplus S[1], S[0]).$$

It can be verified quickly that this is indeed a valid operation. It can be seen that the multiplication table of the field describes an operation that coincides with the operation defined above in the case of 2-bit symbols.

Alternatively, the field GF(4) can operate on symbols of even size in the following way: for such a symbol $S$ we denote by $S[0]$ the concatenation of the bits at even positions within $S$ and similarly we denote by $S[1]$ the concatenation of the bits at odd positions within $S$ (where positions are numbered sequentially starting with zero). For two equal length bit strings $A$ and $B,$ let $(A \mid B)$ be defined to be the bit string $C$ of twice the length where the bit in position $2*i$ of $C$ is the bit in position $i$ of A and the bit in position $2*i+1$ of $C$ is the bit in position $i+1$ of $B$. Then, we define

$$00 * S = \mathbf{0}$$

$$01 * S = S$$

$$10 * S = (S[1] \mid S[0] \oplus S[1])$$

$$11 * S = (S[0] \oplus S[1] \mid S[0]).$$

It can be verified quickly that this is indeed a valid operation. It can be seen that all the operations defined above are the same in the case of 2-bit symbols.

The interleaved transformations described above can be viewed as a particular case of an interleaved transformation in which the binary length of an element of the field coincides with the length of the symbols in bits, and the operation of field elements on symbols is the same as the multiplication in the finite field.

More generally, if $K$ is an extension field of GF(2) of degree $d$, then an operation of the field can be defined on symbols whose size is divisible by $d$. Such an operation is described in the paper "An XOR-based erasure resilient coding scheme", by Bloemer, Kalfane, Karpinksi, Karp, Luby, and Zuckerman, published as Technical Report Number TR-95-048 of the International Computer Science Institute in Berkeley, 1995. This scheme uses the so-called "regular representation" of the field $K$ as $d \times d$ matrices with binary entries.

For these generalizations, the first interleaved transformation partitions $S$, a string that is $d*l$ bits in length, into $d$ equal-size parts, where the first part $S[0]$ is the first $l$ bits of $S$, $S[1]$ is the next $l$ bits of $S$, and $S[d-1]$ is the last $l$ bits of $S$. The transformation operates on the $d$ parts of $S$ and produces $d$ parts that are concatenated together to form the result of the operation. Alternatively, the second interleaved transformation partitions $S$ into $d$ equal-size parts, where the first part $S[0]$ is the concatenation of each $d$th bit of $S$ starting at position 0 in $S$, the second part $S[1]$ is the concatenation of each $d$th bit of $S$ starting at position 1 in $S$, the $d$th part $S[d-1]$ is the concatenation of each $d$th bit of $S$ starting at position $L-1$ in $S$. This second transformation operates on the $d$ parts of $S$ (exactly the same as the first transformation) and produces $d$ parts that are interleaved together to form the result of the operation.

Note that the first interleaved transformation can be computed by XORing consecutive bits of the original string $S$ together, and this is a benefit for software implementations where typically a CPU supports such operations natively. On the other hand, the values of the bits in particular positions in the result of the operation depend on the length of the original string S, and this is somewhat of a disadvantage if one wants to implement the operation in hardware that supports variable length symbols, as the operation of the hardware needs to be different depending on the symbol length. Note that the second interleaved transformation involves XORing non-consecutive bits of the original string together, and this is somewhat of a disadvantage for software implementations where typically a CPU does not support such XORs as a native operation. Nevertheless, software operations that work on the finite field elements of the symbol directly can be implemented rather efficiently in software, and thus the software implementations of the second interleaved transformation are possible. Furthermore, for the second interleaved transformation the values of the bits in particular positions in the result of the operation does not depend on the length of the original string S, and this is a benefit if one wants to implement the operation in hardware that supports variable length symbols, as the operation of the hardware can be independent of the symbol length. Thus, the second interleaved transformation does have some overall advantages over the first interleaved transformation.

Linear transformations

The concept of a "linear transformation" can be defined with reference to the simple or interleaved transformations. For given integers $m$ and $n$, a linear transformation induced by the operation maps vectors of $n$ symbols into vectors of $m$ symbols using the space of matrices with entries in the specified field. A matrix over the field $F$ is a 2-dimensional collection of entries, whose entries belong to $F$. If a matrix has $m$ rows and $n$ columns, then it is commonly referred to as an $m$ x $n$ matrix. The pair $(m,n)$ is called the "format" of the matrix. Matrices of the same format can be added and subtracted, using the addition and subtraction in the underlying field or ring. A matrix of format $(m,n)$ can be multiplied with a matrix of format $(n,k)$ as is commonly known.

In operation, if $B$ denotes a matrix with format $(m,n)$, and $B[j,k]$ denotes the entry of $B$ at position $(j,k)$, and if $S$ denotes the column vector comprising the symbols $S_1$, $S_2$, ..., $S_n$, and $X$ denotes the column vector comprising the symbols $X_1$, $X_2$, ..., $X_m$, then the transformation can be expressed as

$$X = B \otimes S.$$

Thus, the following relationship is valid:

for all $j$ from 1 to $m$, $X_j = B[j,1]^*S_1 \oplus B[j,2]^*S_2 \oplus ... \oplus B[j,n]^*S_n$
wherein "*" denotes either a simple or an interleaved transformation.

The above formula describes a process for calculating $X$ from $B$ and $S$ in an encoder or decoder, referred to as a "simple transformation process" that can be performed by the steps of:

1. Set $j$ to 1, and $X_j$ to **0**.

2. For values of $k$ from 1 to $n$ do $X_j = X_j \oplus B[j,k]^*S_k$.

3. Increment $j$ by 1. If $j$ is larger than $m$, then stop, otherwise go to step 2.

Such linear transformations are commonplace in a variety of applications. For example, when using a linear code to encode a piece of data, or source block, $S$ could be the source symbols of the source block to be encoded, $X$ could be the encoded version of $S$, and $B$ could be a generator matrix for the code. In other applications, for example where the code used is systematic, $X$ could be the redundant symbols of the encoding of $S$, while $B$ could be the matrix describing the dependency of the redundant symbols on the source symbols.

As will be known to those of skill to in the art, methods are known to perform the operations described above either through the provision of instructions executed within a general-purpose processor, through hardware designed specifically to perform such operations or through a combination of both. In all cases, the cost of the operations, in terms of the number of instructions required, the amount of hardware required, the cost of the hardware, the electrical power consumed by the operation and/or the time required to perform the operation is generally larger when larger finite fields are used. In particular, in the case of the field GF(2), the operations required are equivalent to bit-wise AND and XOR operations which are widely provided within general-purpose processors and simple, fast and inexpensive to implement in hardware where required. By contrast, operations using larger finite fields than GF(2) are rarely provided directly in general-purpose processors and require either specialized hardware or a number of processor instructions and memory operations to perform.

Multi-field Erasure and Error Correction Codes

Numerous specific embodiments of multi-field erasure and error correction codes are described herein by reference to a generalized matrix description. This approach is adopted as a descriptive tool only and does not represent a unique way to describe the embodiments described herein, nor should it be construed to limit the scope of this invention. In the generalized description, a matrix is constructed whose elements are taken from one or more finite fields. Different elements may be taken from different finite fields, with the property that there is a single field in which all the fields can be embedded and specific such embeddings are chosen. Some or all of the output symbols may be identical to some of the input or redundant symbols, or may be distinct from the input and redundant symbols depending on the particular embodiment chosen as will be illustrated further below.

A one-to-one correspondence is made between the input symbols of the code and some of the columns of the matrix. A further one-to-one correspondence is made between the redundant symbols of the code and the remaining columns of the matrix. Furthermore, a number of rows of the matrix equal to the number of redundant symbols are designated as static rows. Remaining rows of the matrix are designated as dynamic rows. A one to one correspondence is made between the dynamic rows of the matrix and the output symbols of the code. In this description, static rows represent constraints which are required to hold between the input and the redundant symbols and the static rows fully define the relationship between input and redundant symbols such that knowledge of the input symbols and the static rows is sufficient to construct the redundant symbols. Dynamic rows represent the output symbols which are actually sent on the channel. In many codes, the input and/or redundant symbols themselves are sent and this is represented in this description by adding a dynamic row for each input and redundant symbol that is to be transmitted, said dynamic row having a non-zero entry in the column corresponding to the required input or redundant symbol and zero entries in the remaining columns. In some embodiments, the non-zero entry is the identity. In other embodiments, this non-zero entry need not be the identity element.

A matrix of the form described above may be used to determine a method of encoding data for transmission from a source to a destination over a communications channel, the method comprising generating a plurality of redundant symbols from an ordered set of input symbols, wherein each redundant symbol is generated based on a set of linear constraints over one or more of the input symbols and other redundant symbols with coefficients over finite fields, said linear constraints corresponding to the static rows of the matrix description, generating a plurality of output symbols from the combined set of input and redundant symbols, wherein each output symbol is generated as a linear combination of one or more of the combined set of input and redundant symbols with coefficients chosen from finite fields, said linear constraints corresponding to the dynamic rows of the matrix description and sending at least some of the plurality of generated output symbols.

Conversely, a method comprising the above steps may be described in terms of a matrix of the kind described above in which the static rows correspond to the linear constraints over one or more of the input symbols and redundant symbols and the dynamic rows correspond to the linear combinations of the input and redundant symbols which are used to form the output symbols. In practice, embodiments of the method described above may not involve explicit or implicit representation or construction of the matrix described.

As is well-known, in the case that all elements of the matrix are taken from the field GF(2), then a large class of well-known error-correction and erasure-corrections codes can be described in this way. For example, for the case of Low-Density Parity Check (LDPC) codes, including for example those described in the paper entitled "Design, Evaluation and Comparison of Four Large Block FEC Codecs, LDPC, LDGM, LDGM Staircase and LDGM Triangle, plus a Reed-Solomon Small Block FEC Codec" by V. Roca and C. Neumann published as INRIA Research Report RR-5225, June 2004, available at www.inrialpes.fr (referred to hereinafter as "Roca"), the generalized matrix can be constructed from the parity check matrix by designating every row of the parity check matrix as a static row and adding a further dynamic row for each input and redundant symbol as described above. Another example might use the single-stage chain reaction codes described in Luby I and Luby II, in which the number of static rows in the matrix is zero and the dynamic rows comprise a standard chain reaction matrix. Another example is the use of MSCR codes, in which case the generalized description here is equivalent to the standard matrix presentation of such codes.

Other codes over larger fields can also be described in this way. For example, Reed-Solomon codes such as those derived from Vandermonde matrices in which the input symbols are the source symbols, the generalized matrix is equal to the Vandermonde matrix and all rows are dynamic, where in this case each entry is a finite field element from a field that has at least as many elements in its multiplicative group as there are rows and columns in total, e.g., the finite field GF(256) when the number of rows and columns in total is less than 256. Another example is systematic Reed-Solomon codes over a finite field such as GF(256) which are derived from Vandermonde matrices in which case the input symbols are the source symbols, the redundant symbols are the parity symbols, and the matrix is the rows corresponding to the parity symbols within the systematic form of the Vandermonde matrix with all such rows considered static and additional dynamic rows are added for each source and parity symbol as described above since these are exactly the symbols sent over the channel

As is well-known to those of skill in the art of error and erasure correcting codes, desirable properties of error and erasure correcting include low encoding complexity, low decoding complexity, low decoding error probability and low error floor. The complexity of a code is a measure of the computational resources required to encode or decode the code. Low complexity is of especial value in applications where encoding or decoding is to be performed by resource constrained devices such as mobile terminals, consumer electronics devices, storage devices or devices which may process many encoding or decoding operations simultaneously. Computational complexity is a function in part of the density of the matrix used to encode and decode the code and of the size of the finite field from which the matrix elements are taken. Dense matrices generally result in higher complexity and this has led to many designs of codes based on sparse matrices, for example Low Density Parity Check codes and chain reaction codes. Larger finite fields also result in higher complexity, which has led to many designs of code based on small fields, most commonly GF(2).

Error probability in this context is the probability that completely successful decoding is not possible. Error probability for a given error correcting or erasure correcting code is a function of the information received over the channel, and the specific algorithm used for decoding. In the case of erasure correction codes the error probability is one whenever fewer symbols are received than the number of input symbols. Ideal erasure codes have the property that the error probability is zero whenever the number of symbols received is greater than or equal to the number of input symbols. Other codes have non-zero probability of failure in this case.

It is known that ideal erasure codes can be constructed using dense matrices, in particular Reed-Solomon codes. However, in the case of Reed-Solomon codes the size of the field required is a function of the code size, which is the sum of the number of input and redundant symbols, and this fact, together with the density of the matrix results in generally high computational complexity, especially as the code size grows. Furthermore, in the case of low density codes, it is known that larger finite fields can be used to reduce error probability for error correction codes (as is demonstrated for example in the paper "Low Density Parity Check Codes over GF(q)" by M.C. Davey and D.J.C. MacKay, which has appeared in the IEEE Communications Letters, volume 2, number 6, pages 165-167, 1998) and for erasure codes. Additionally, it is known that introduction of a small number of high density matrix rows or columns into a low density code can improve the error probability, providing a compromise between error probability and complexity [MSCR codes and chain reaction codes]. However, a disadvantage of all such codes is that there is always a significant trade-off between low complexity and low error probability.

For many FEC codes, i.e., LDPC codes and chain reaction codes and MSRC codes, as more output symbols than the number of input symbols are received, the error probability for successful decoding decreases exponentially at some rate. The error floor of such a code is the error probability at which receipt of additional output symbols decreases the error probability at a much slower rate than when the number of received output symbols first exceeds the number of input symbols. It is known that use of a small number of high density rows or columns and/or the use of a larger finite field for the matrix can result in lower error floor at the cost of higher computational complexity. A disadvantage of many known error and erasure correction codes with low complexity is that the error floor is higher than desirable.

Herein, novel methods are described for construction of error correction and erasure correction codes which address some of the disadvantages mentioned above. Methods for efficient encoding and decoding of such codes are presented with relation to specific embodiments described herein by way of example.

The choice of fields for the matrix elements from a set of more than one possible field as described herein permits the design of codes which retain the low computational complexity of codes over small fields with the low error probability and error floor of codes over larger fields and thus represents a significant advantage over the state of the art.

In one preferred embodiment which will be described in more detail below, for the majority of the rows the entries are chosen from GF(2) and for the remainder of the rows the entries are chosen from GF(256). In another embodiment, for each row exactly one entry is chosen from GF(256) and the remaining elements are chosen from GF(2).

There are many other possible embodiments of use of elements from more than one field that result in an improvement in the trade-off between computational complexity and error probability and error floor compared to codes known in the art in which all elements are selected from the same field.

As used herein, the term "file" refers to any data that is stored at one or more sources and is to be delivered as a unit to one or more destinations. Thus, a document, an image, and a file from a file server or computer storage device, are all examples of "files" that can be delivered. Files can be of known size (such as a one megabyte image stored on a hard disk) or can be of unknown size (such as a file taken from the output of a streaming source). Either way, the file is a sequence of input symbols, where each input symbol has a position in the file and a value.

As used herein, the term "stream" refers to any data that is stored or generated at one or more sources and is delivered at a specified rate at each point in time in the order it is generated to one or more destinations. Streams can be fixed rate or variable rate. Thus, an MPEG video stream, AMR audio stream, and a data stream used to control a remote device, are all examples of "streams" that can be delivered. The rate of the stream at each point in time can be known (such as 4 megabits per second) or unknown (such as a variable rate stream where the rate at each point in time is not known in advance). Either way, the stream is a sequence of input symbols, where each input symbol has a position in the stream and a value.

Transmission is the process of transmitting data from one or more senders to one or more recipients through a channel in order to deliver a file or stream. A sender is also sometimes referred to as the encoder. If one sender is connected to any number of recipients by a perfect channel, the received data can be an exact copy of the input file or stream, as all the data will be received correctly. Here, we assume that the channel is not perfect, which is the case for most real-world channels. Of the many channel imperfections, two imperfections of interest are data erasure and data incompleteness (which can be treated as a special case of data erasure). Data erasure occurs when the channel loses or drops data. Data incompleteness occurs when a recipient does not start receiving data until some of the data has already passed it by, the recipient stops receiving data before transmission ends, the recipient chooses to only receive a portion of the transmitted data, and/or the recipient intermittently stops and starts again receiving data. As an example of data incompleteness, a moving satellite sender might be transmitting data representing an input file or stream and start the transmission before a recipient is in range. Once the recipient is in range, data can be received until the satellite moves out of range, at which point the recipient can redirect its satellite dish (during which time it is not receiving data) to start receiving the data about the same input file or stream being transmitted by another satellite that has moved into range. As should be apparent from reading this description, data incompleteness is a special case of data erasure, since the recipient can treat the data incompleteness (and the recipient has the same problems) as if the recipient was in range the entire time, but the channel lost all the data up to the point where the recipient started receiving data. Also, as is well known in communication systems design, detectable errors can be considered equivalent to erasures by simply dropping all data blocks or symbols that have detectable errors.

In some communication systems, a recipient receives data generated by multiple senders, or by one sender using multiple connections. For example, to speed up a download, a recipient might simultaneously connect to more than one sender to transmit data concerning the same file. As another example, in a multicast transmission, multiple multicast data streams might be transmitted to allow recipients to connect to one or more of these streams to match the aggregate transmission rate with the bandwidth of the channel connecting them to the sender. In all such cases, a concern is to ensure that all transmitted data is of independent use to a recipient, i.e., that the multiple source data is not redundant among the streams, even when the transmission rates are vastly different for the different streams, and when there are arbitrary patterns of loss.

In general, a communication channel is that which connects the sender and the recipient for data transmission. The communication channel could be a real-time channel, where the channel moves data from the sender to the recipient as the channel gets the data, or the communication channel might be a storage channel that stores some or all of the data in its transit from the sender to the recipient. An example of the latter is disk storage or other storage device. In that example, a program or device that generates data can be thought of as the sender, transmitting the data to a storage device. The recipient is the program or device that reads the data from the storage device. The mechanisms that the sender uses to get the data onto the storage device, the storage device itself and the mechanisms that the recipient uses to get the data from the storage device collectively form the channel. If there is a chance that those mechanisms or the storage device can lose data, then that would be treated as data erasure in the communication channel.

When the sender and recipient are separated by a communication channel in which symbols can be erased, it is preferable not to transmit an exact copy of an input file or stream, but instead to transmit data generated from the input file or stream (which could include all or parts of the input file or stream itself) that assists with recovery of erasures. An encoder is a circuit, device, module or code segment that handles that task. One way of viewing the operation of the encoder is that the encoder generates output symbols from input symbols, where a sequence of input symbol values represents the input file or a block of the stream. Each input symbol would thus have a position, in the input file or block of the stream, and a value. A decoder is a circuit, device, module or code segment that reconstructs the input symbols from the output symbols received by the recipient. In multi-stage coding, the encoder and the decoder are further divided into sub-modules each performing a different task.

In embodiments of multi-stage coding systems, the encoder and the decoder can be further divided into sub-modules, each performing a different task. For instance, in some embodiments, the encoder comprises what is referred to herein as a static encoder and a dynamic encoder. As used herein, a "static encoder" is an encoder that generates a number of redundant symbols from a set of input symbols, wherein the number of redundant symbols is determined prior to encoding. Examples of static encoding codes include Reed-Solomon codes, Tornado codes, Hamming codes, Low Density Parity Check (LDPC) codes, etc. The term "static decoder" is used herein to refer to a decoder that can decode data that was encoded by a static encoder.

As used herein, a "dynamic encoder" is an encoder that generates output symbols from a set of input symbols and possibly a set of redundant symbols. In one preferred embodiment described here, the number of possible output symbols is orders of magnitude larger than the number of input symbols, and the number of output symbols to be generated need not be fixed. One example of such a dynamic encoder is a chain reaction encoder, such as the encoders described in Luby I and Luby II. The term "dynamic decoder" is used herein to refer to a decoder that can decode data that was encoded by a dynamic encoder.

Embodiments of multi-field coding need not be limited to any particular type of input symbol. Typically, the values for the input symbols are selected from an alphabet of $2^M$ symbols for some positive integer M. In such cases, an input symbol can be represented by a sequence of M bits of data from the input file or stream. The value of M is often determined based on, for example, the uses of the application, the communication channel, and/or the size of the output symbols. Additionally, the size of an output symbol is often determined based on the application, the channel, and/or the size of the input symbols. In some cases, the coding process might be simplified if the output symbol values and the input symbol values were the same size (i.e., representable by the same number of bits or selected from the same alphabet). If that is the case, then the input symbol value size is limited when the output symbol value size is limited. For example, it may be desired to put output symbols in packets of limited size. If some data about a key associated with the output symbols were to be transmitted in order to recover the key at the receiver, the output symbol would preferably be small enough to accommodate, in one packet, the output symbol value and the data about the key.

As an example, if an input file is a multiple megabyte file, the input file might be broken into thousands, tens of thousands, or hundreds of thousands of input symbols with each input symbol encoding thousands, hundreds, or only few bytes. As another example, for a packet-based Internet channel, a packet with a payload of size of 1024 bytes might be appropriate (a byte is 8 bits). In this example, assuming each packet contains one output symbol and 8 bytes of auxiliary information, an output symbol size of 8128 bits ((1024 - 8)*8) would be appropriate. Thus, the input symbol size could be chosen as M=(1024 - 8) * 8, or 8128 bits. As another example, some video distribution systems use the MPEG packet standard, where the payload of each packet comprises 188 bytes. In that example, assuming each packet contains one output symbol and 4 bytes of auxiliary information, an output symbol size of 1472 bits ((188 - 4) * 8), would be appropriate. Thus, the input symbol size could be chosen as M = (188 - 4) * 8, or 1472 bits. In a general-purpose communication system using multi-stage coding, the application-specific parameters, such as the input symbol size (i.e., M, the number of bits encoded by an input symbol), might be variables set by the application.

As another example, for a stream that is sent using variable size source packets, the symbol size might be chosen to be rather small so that each source packet can be covered with an integral number of input symbols that have aggregate size at most slightly larger than the source packet.

Each output symbol has a value. In one preferred embodiment, which we consider below, each output symbol also has associated therewith an identifier called its "key." Preferably, the key of each output symbol can be easily determined by the recipient to allow the recipient to distinguish one output symbol from other output symbols. Preferably, the key of an output symbol is distinct from the keys of all other output symbols. There are various forms of keying discussed in previous art. For example, Luby I describes various forms of keying that can be employed in embodiments described herein.

Multi-field Multi-stage coding is particularly useful where there is an expectation of data erasure or where the recipient does not begin and end reception exactly when a transmission begins and ends. The latter condition is referred to herein as "data incompleteness." Regarding erasure events, multi-stage coding shares many of the benefits of chain reaction coding described in Luby I. In particular, multi-stage codes may be fountain codes, or rateless codes, in which case many times more distinct output symbols than there are input symbols can be generated for a set of fixed-value input symbols, and any suitable number of distinct output symbols can be used to recover the input symbols to a desired degree of accuracy. These conditions do not adversely affect the communication process when multi-field multi-stage coding is used, because the output symbols generated with multi-field multi-stage coding are information additive. For example, if a hundred packets are lost due to a burst of noise causing data erasure, an extra hundred packets can be picked up after the burst to replace the loss of the erased packets. If thousands of packets are lost because a receiver did not tune into a transmitter when it began transmitting, the receiver could just pickup those thousands of packets from any other period of transmission, or even from another transmitter. With multi-field multi-stage coding, a receiver is not constrained to pickup any particular set of packets, so it can receive some packets from one transmitter, switch to another transmitter, lose some packets, miss the beginning or end of a given transmission and still recover an input file or block of a stream. The ability to join and leave a transmission without receiver-transmitter coordination helps to simplify the communication process.

In some embodiments, transmitting a file or stream using multi-field multi-stage coding can include generating, forming or extracting input symbols from an input file or block of a stream, computing redundant symbols, encoding input and redundant symbols into one or more output symbols, where each output symbol is generated based on its key independently of all other output symbols, and transmitting the output symbols to one or more recipients over a channel. Additionally, in some embodiments, receiving (and reconstructing) a copy of the input file or block of a stream using multi-field multi-stage coding can include receiving some set or subset of output symbols from one of more data streams, and decoding the input symbols from the values and keys of the received output symbols.

Suitable FEC erasure codes as described herein can be used to overcome the above-cited difficulties and would find use in a number of fields including multimedia broadcasting and multicasting systems and services. An FEC erasure code hereafter referred to as "a multi-field multi-stage chain reaction code" has properties that meet many of the current and future requirements of such systems and services.

Some basic properties of multi-field multi-stage chain reaction codes are that, for any packet loss conditions and for delivery of source files of any relevant size or streams of any relevant rate: (a) reception overhead of each individual receiver device ("RD") is minimized; (b) the total transmission time needed to deliver source files to any number of RDs can be minimized (c) the quality of the delivered stream to any number of RDs can be maximized for the number of output symbols sent relative to the number of input symbols, with suitable selection of transmission schedules. The RDs might be handheld devices, embedded into a vehicle, portable (i.e., movable but not typically in motion when in use) or fixed to a location.

The amount of working memory needed for decoding is low and can still provide the above properties, and the amount of computation needed to encode and decode is minimal. In this document, we provide a simple and easy to implement description of some variations of multi-field multi-stage chain reaction codes.

Multi-field Multi-stage chain reaction codes are fountain codes, i.e., as many encoding packets as needed can be generated on-the-fly, each containing unique encoding symbols that are equally useful for recovering a source file or block of a stream. There are many advantages to using fountain codes versus other types of FEC codes. One advantage is that, regardless of packet loss conditions and RD availability, fountain codes minimize the number of encoding packets each RD needs to receive to reconstruct a source file or block of a stream. This is true even under harsh packet loss conditions and when, for example, mobile RDs are only intermittently turned-on or available over a long file download session.

Another advantage is the ability to generate exactly as many encoding packets as needed, making the decision on how many encoding packets to generate on-the-fly while the transmission is in progress. This can be useful if for example there is feedback from RDs indicating whether or not they received enough encoding packets to recover a source file or block of a stream. When packet loss conditions are less severe than expected the transmission can be terminated early. When packet loss conditions are more severe than expected or RDs are unavailable more often than expected the transmission can be seamlessly extended.

Another advantage is the ability to inverse multiplex. Inverse multiplexing is when a RD is able to combine received encoding packets generated at independent senders to reconstruct a source file or block of a stream. One practical use of inverse multiplexing is described in below in reference to receiving encoding packets from different senders.

Where future packet loss, RD availability and application conditions are hard to predict, it is important to choose an FEC solution that is as flexible as possible to work well under unpredictable conditions. Multi-stage chain reaction codes provide a degree of flexibility unmatched by other types of FEC codes.

A further advantage of multi-field multi-stage codes is that the error probability and error floor of the codes is much lower than those of previously known codes with equivalent computational complexity. Equally, the computational complexity of multi-field multi-stage chain reaction codes is much lower than that of previously known codes with equivalent error probability and/or error floor.

Another advantage of multi-field multi-stage chain reaction codes is that parameters such as symbol size and field sizes can be chosen flexibly to achieve any desired balance between computational complexity and error probability and/or error floor.

Aspects of the invention will now be described with reference to the figures.

System Overview

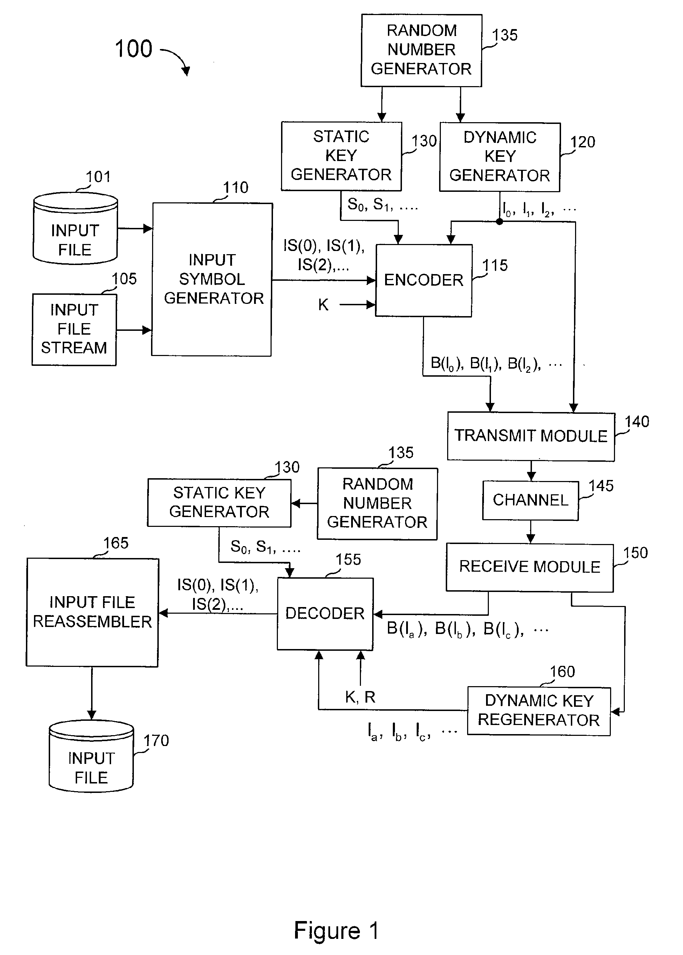

Fig. 1 is a block diagram of a communications system 100 that uses multi-stage coding. In communications system 100, an input file 101, or an input stream 105, is provided to an input symbol generator 110. Input symbol generator 110 generates a sequence of one or more input symbols (IS(0), IS(1), IS(2), ...) from the input file or stream, with each input symbol having a value and a position (denoted in Fig. 1 as a parenthesized integer). As explained above, the possible values for input symbols, i.e., its alphabet, is typically an alphabet of $2^M$ symbols, so that each input symbol codes for M bits of the input file or stream. The value of M is generally determined by the use of communication system 100, but a general purpose system might include a symbol size input for input symbol generator 110 so that M can be varied from use to use. The output of input symbol generator 110 is provided to an encoder 115.

Static key generator 130 produces a stream of static keys $S_0$, $S_1$, .... The number of the static keys generated is generally limited and depends on the specific embodiment of encoder 115. The generation of static keys will be subsequently described in more detail. Dynamic key generator 120 generates a dynamic key for each output symbol to be generated by the encoder 115. Each dynamic key is generated so that a large fraction of the dynamic keys for the same input file or block of a stream are unique. For example, Luby I describes embodiments of key generators that can be used. The outputs of dynamic key generator 120 and the static key generator 130 are provided to encoder 115.

From each key I provided by dynamic key generator 120, encoder 115 generates an output symbol, with a value B(I), from the input symbols provided by the input symbol generator. The operation of encoder 115 will be described in more detail below. The value of each output symbol is generated based on its key, on some function of one or more of the input symbols, and possibly on or more redundant symbols that had been computed from the input symbols. The collection of input symbols and redundant symbols that give rise to a specific output symbol is referred to herein as the output symbol's "associated symbols" or just its "associates". The selection of the function (the "value function") and the associates is done according to a process described in more detail below. Typically, but not always, M is the same for input symbols and output symbols, i.e., they both code for the same number of bits.

In some embodiments, the number K of input symbols is used by the encoder 115 to select the associates. If K is not known in advance, such as where the input is a streaming file, K can be just an estimate. The value K might also be used by encoder 115 to allocate storage for input symbols and any intermediate symbols generated by encoder 115.

Encoder 115 provides output symbols to a transmit module 140. Transmit module 140 is also provided the key of each such output symbol from the dynamic key generator 120. Transmit module 140 transmits the output symbols, and depending on the keying method used, transmit module 140 might also transmit some data about the keys of the transmitted output symbols, over a channel 145 to a receive module 150. Channel 145 is assumed to be an erasure channel, but that is not a requirement for proper operation of communication system 100. Modules 140, 145 and 150 can be any suitable hardware components, software components, physical media, or any combination thereof, so long as transmit module 140 is adapted to transmit output symbols and any needed data about their keys to channel 145 and receive module 150 is adapted to receive symbols and potentially some data about their keys from channel 145. The value of K, if used to determine the associates, can be sent over channel 145, or it may be set ahead of time by agreement of encoder 115 and decoder 155.

As explained above, channel 145 can be a real-time channel, such as a path through the Internet or a broadcast link from a television transmitter to a television recipient or a telephone connection from one point to another, or channel 145 can be a storage channel, such as a CD-ROM, disk drive, Web site, or the like. Channel 145 might even be a combination of a real-time channel and a storage channel, such as a channel formed when one person transmits an input file from a personal computer to an Internet Service Provider (ISP) over a telephone line, the input file is stored on a Web server and is subsequently transmitted to a recipient over the Internet.

Because channel 145 is assumed to be an erasure channel, communications system 100 does not assume a one-to-one correspondence between the output symbols that exit receive module 150 and the output symbols that go into transmit module 140. In fact, where channel 145 comprises a packet network, communications system 100 might not even be able to assume that the relative order of any two or more packets is preserved in transit through channel 145. Therefore, the key of the output symbols is determined using one or more of the keying schemes described above, and not necessarily determined by the order in which the output symbols exit receive module 150.

Receive module 150 provides the output symbols to a decoder 155, and any data receive module 150 receives about the keys of these output symbols is provided to a dynamic key regenerator 160. Dynamic key regenerator 160 regenerates the dynamic keys for the received output symbols and provides these dynamic keys to decoder 155. Static key generator 163 regenerates the static keys $S_0$, $S_1$, ... and provides them to decoder 155. The static key generator has access to random number generator 135 used both during the encoding and the decoding process. This can be in the form of access to the same physical device if the random numbers are generated on such device, or in the form of access to the same algorithm for the generation of random numbers to achieve identical behavior. Decoder 155 uses the keys provided by dynamic key regenerator 160 and static key generator 163 together with the corresponding output symbols, to recover the input symbols (again IS(0), IS(1), IS(2), ...). Decoder 155 provides the recovered input symbols to an input file reassembler 165, which generates a copy 170 of input file 101 or input stream 105.

One property of the output symbols produced by a chain reaction encoder is that a receiver is able to recover the original file or block of the original stream as soon as enough output symbols have been received. Specifically, to recover the original K input symbols with a high probability, the receiver needs approximately K+A output symbols. The ratio A/K is called the "relative reception overhead." The relative reception overhead depends on the number K of input symbols, and on the reliability of the decoder. Luby I, Luby II and Shokrollahi I provide teachings of systems and methods that can be employed in certain embodiments. It is to be understood, however, that these systems and methods are not required of the present invention, and many other variations, modifications, or alternatives can also be used.

<u>An Encoder</u>

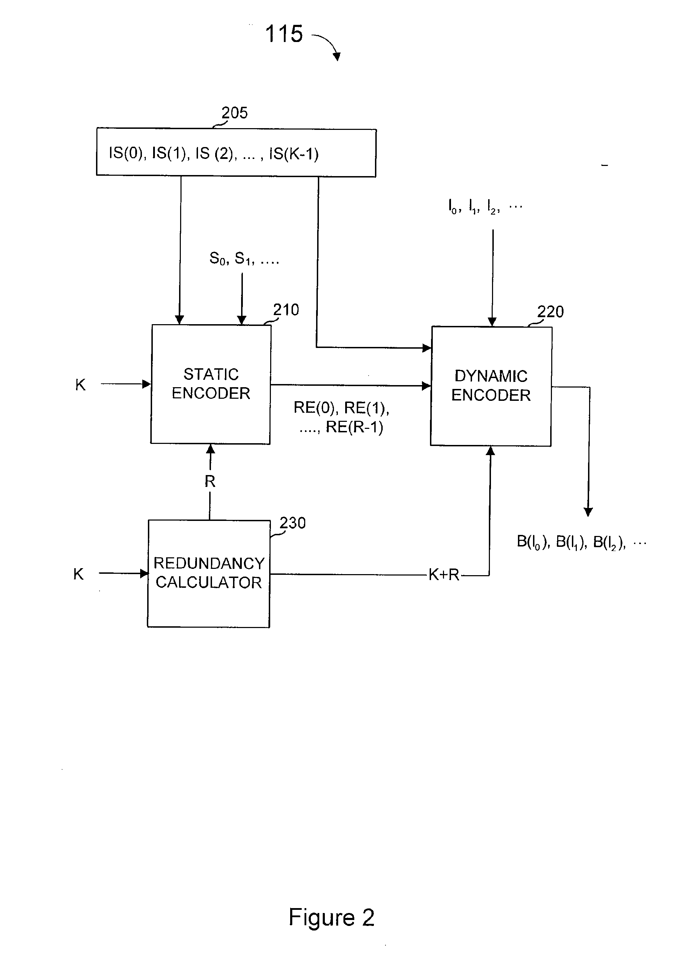

Fig. 2 is a block diagram of one specific embodiment of encoder 115 shown in Fig. 1. Encoder 115 comprises a static encoder 210, a dynamic encoder 220, and a redundancy calculator 230. Static encoder 210 receives the following inputs: a) original input symbols IS(0), IS(1), ..., IS(K-1) provided by the input symbol generator 110 and stored in an input symbol buffer 205; b) the number K of original input symbols; c) static keys $S_0$, $S_1$, provided by the static key generator 130; and d) a number R of redundant symbols. Upon receiving these inputs static encoder 205 computes R redundant symbols RE(0), RE(1), ..., RE(R-1) as will be described below. Typically, but not always, the redundant symbols have the same size as the input symbols. In one specific embodiment, the redundant symbols generated by static encoder 210 are stored in input symbol buffer 205. Input symbol buffer 205 may be only logical, i.e., the file or block of the stream may be physically stored in one place and the positions of the input symbols within symbol buffer 205 could only be renamings of the positions of these symbols within the original file or block of the stream.

Dynamic encoder receives the input symbols and the redundant symbols, and generates output symbols as will be described in further detail below. In one embodiment in which the redundant symbols are stored in input symbol buffer 205, dynamic encoder 220 receives the input symbols and redundant symbols from input symbol buffer 205.

Redundancy calculator 230 computes the number R of redundant symbols from the number K of input symbols. This computation is described in further detail below.

Overview of Static Encoder

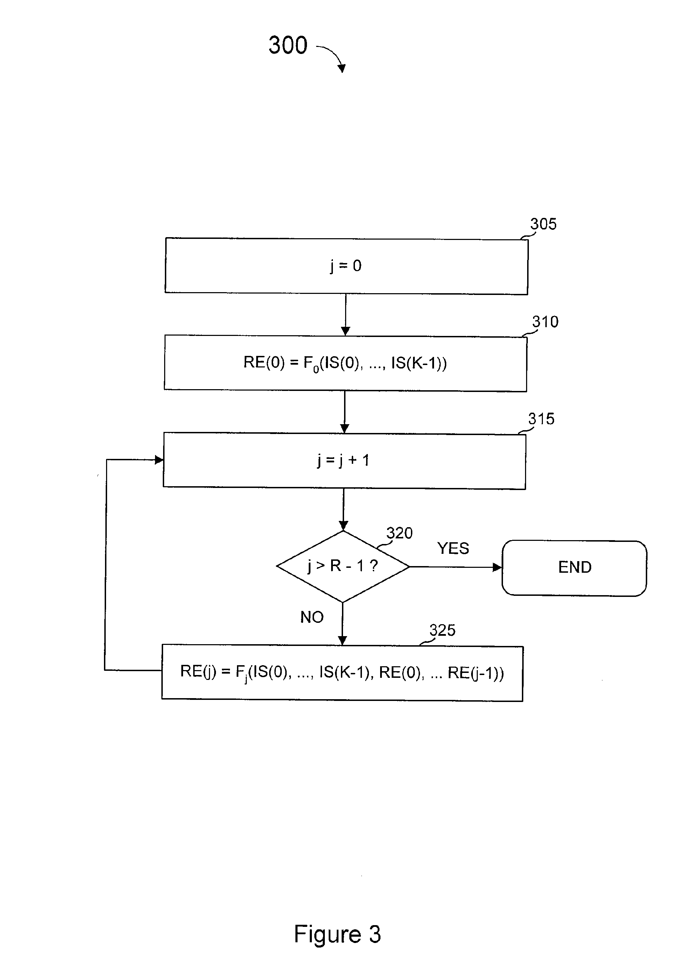

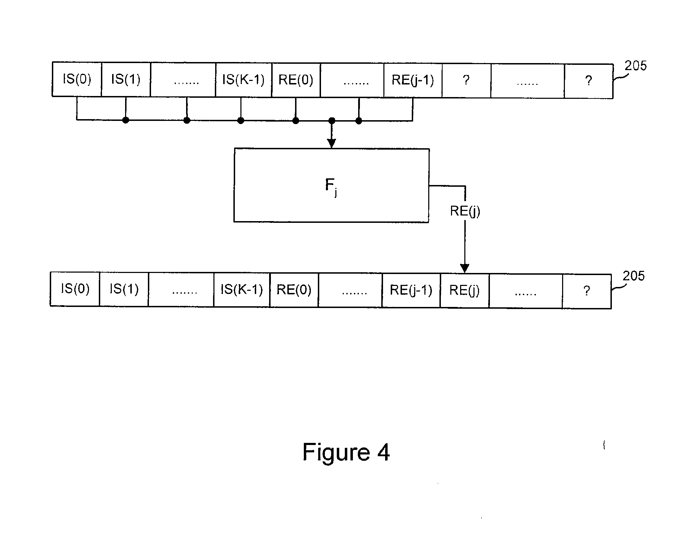

The general operation of static encoder 210 is shown with reference to Figs. 3 and 4. Fig. 3 is a simplified flow diagram illustrating one embodiment of a method of statically encoding. In a step 305, a variable j, which keeps track of how many redundant symbols have been generated, is set to zero. Then, in a step 310, a first redundant symbol RE(0) is computed as a function $F_0$ of at least some of the input symbols IS(0), ..., IS(K-1). Then, in a step 315, the variable j is incremented. Next, in a step 320, it is tested whether all of the redundant symbols have been generated (i.e., is j greater than R-1?). If yes, then the flow ends. Otherwise, the flow proceeds to step 325. In step 325, RE(j) is computed as a function $F_j$ of the input symbols IS(0), ..., IS(K-1) and of the previously generated redundant symbols RE(0), ..., RE(j-1), where $F_j$ need not be a function that depends on every one of the input symbols or every one of the redundant symbols. Steps 315, 320, and 325 are repeated until R redundant symbols have been computed.

Referring again to Figs. 1 and 2, in some embodiments, static encoder 210 receives one or more static keys $S_0$, $S_1$, ... from static key generator 130. In these embodiments, the static encoder 210 uses the static keys to determine some or all of functions $F_0$, $F_1$, ..., $F_{j-j}$. For example, static key So can be used to determine function $F_0$, static key $S_1$ can be used to determine function $F_1$, etc. Or, one or more of static keys $S_0$, $S_1$, ... can be used to determine function $F_0$, one or more of static keys $S_0$, $S_1$, ... can be used to determine function $F_1$, etc. In other embodiments, no static keys are needed, and thus static key generator 130 is not needed.

Referring now to Figs. 2 and 3, in some embodiments, the redundant symbols generated by static encoder 210 can be stored in input symbol buffer 205. Fig. 4 is a simplified illustration of the operation of one embodiment of static encoder 210. Particularly, static encoder 210 generates redundant symbol RE(j) as a function Fj of input symbols IS(0), ..., IS(K-1), RE(0), ..., RE(j-1), received from input symbol buffer 205, and stores it back into input symbol buffer 205. The exact form of the functions $F_0$, $F_1$, ..., $F_{R-1}$ depends on the particular application. Typically, but not always, functions $F_1$, $F_1$, ..., $F_{R-1}$ include an exclusive OR of some or all of their corresponding arguments. As described above, these functions may or may not actually employ static keys generated by static key generator 130 of Fig. 1. For example, in one specific embodiment described below, the first few functions implement a Hamming code and do not make any use of the static keys $S_0$, $S_1$, ..., whereas the remaining functions implement a Low-Density Parity-Check code and make explicit use of the static keys.

Overview of Multi-Stage Encoder

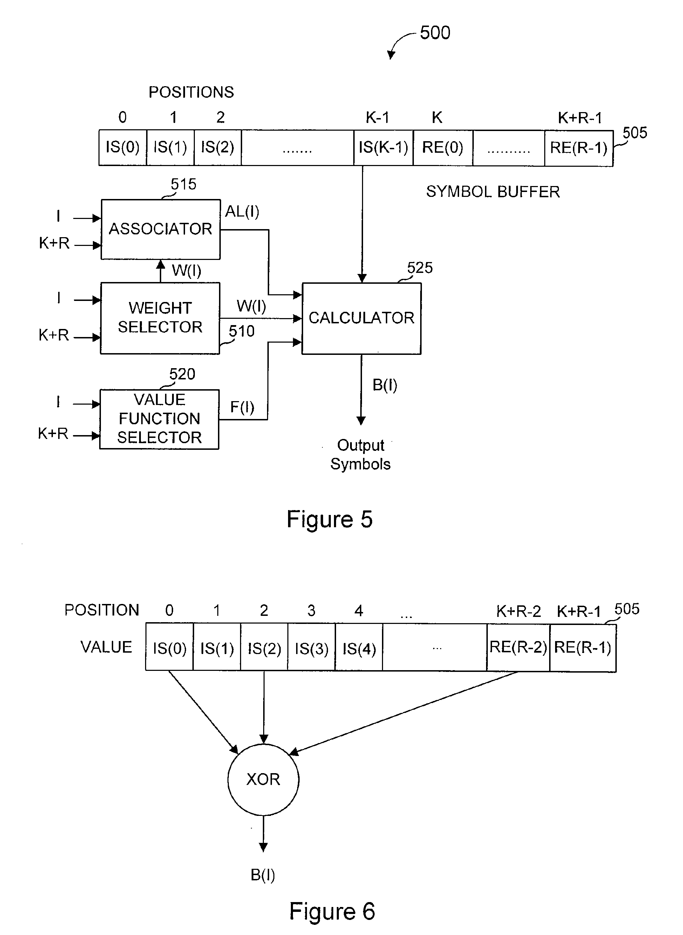

Referring again to Fig. 2, dynamic encoder 220 receives input symbols IS(0),...,IS(K-1) and the redundant symbols RE(0),...,RE(R-1) and a key I for each output symbol it is to generate. The collection comprising the original input symbols and the redundant symbols will be referred to as the collection of "dynamic input symbols" hereafter. Fig. 5 is a simplified block diagram of one embodiment of a dynamic encoder, including a weight selector 510, an associator 515, a value function selector 520 and a calculator 525. As shown in Fig. 5, the K+R dynamic input symbols are stored in a dynamic symbol buffer 505. In effect, dynamic encoder 500 performs the action illustrated in Fig. 6, namely, to generate an output symbol value B(I) as some value function of selected input symbols.

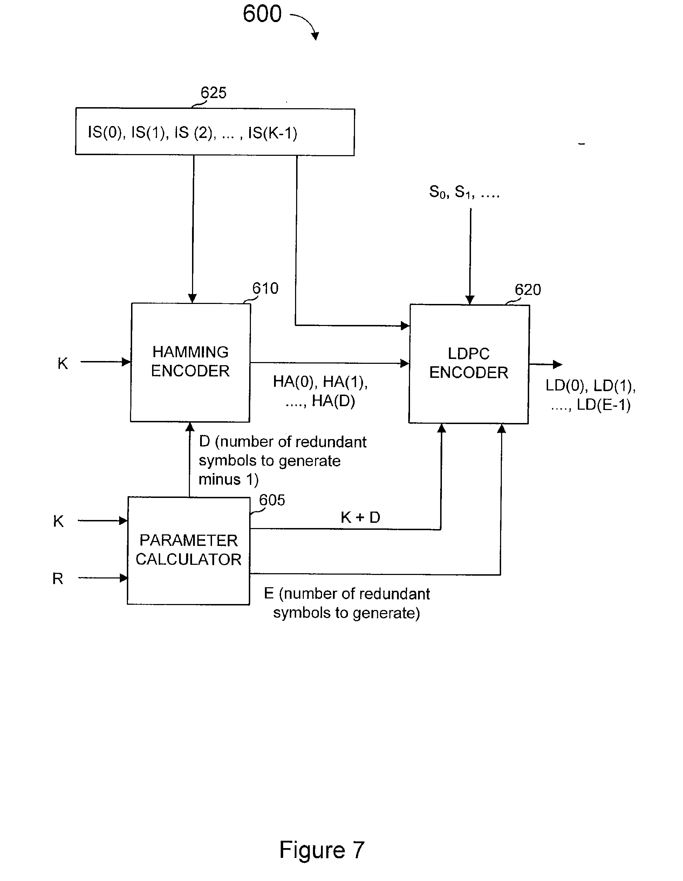

Fig. 7 is a simplified block diagram of one specific embodiment of a static encoder. Static encoder 600 comprises a parameter calculator 605, a Low-density parity-check (LDPC) encoder 610, and a high-density-parity-check (HDPC) encoder 620. LDPC encoder 610 is coupled to receive the input symbols IS(0), ..., IS(K-1) from an input symbol buffer 625, the number K of input symbols, and the parameter E. In response, LDPC encoder 610 generates E redundant symbols LD(0),...,LD(E-1) according to the LDPC code. Next, HDPC encoder 620 is coupled to receive the plurality of K+E symbols IS(0),...,IS(K-1),LD(0),..., LD(E-1) and the parameter D to generate D redundant symbols HA(0), HA(1), ..., HA(D-1) according to the HDPC code.

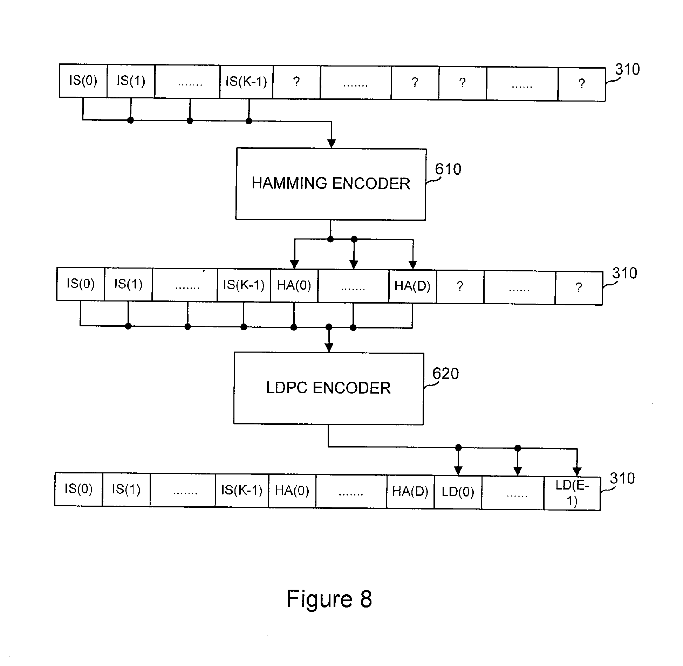

Fig. 8 illustrates the operation of one embodiment that employs the static encoder shown in Fig. 7.

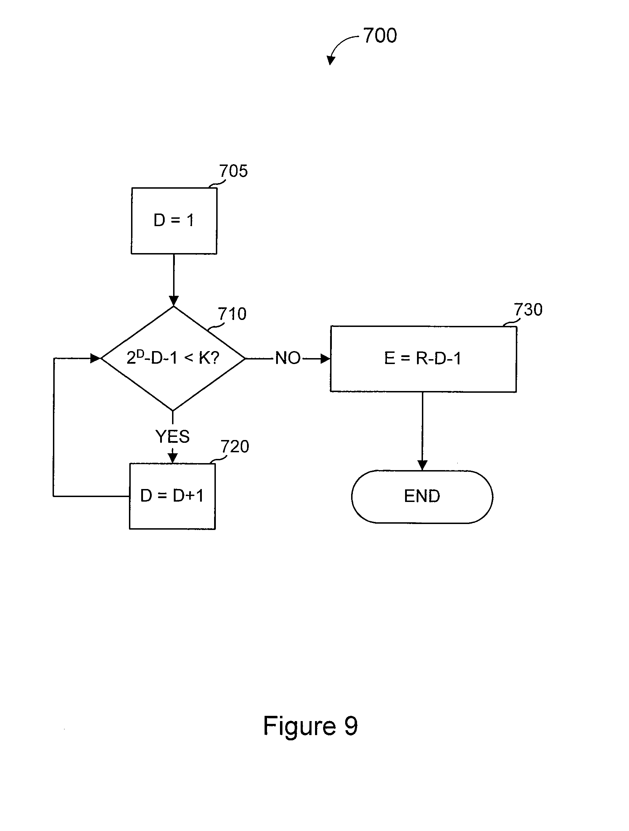

Fig. 9 is a simplified flow diagram illustrating one embodiment of a parameter calculator, such as parameter calculator 605 of Fig. 7, that calculates parameter D and E as described above, when the HDPC code is a Hamming code. First, in a step 705, parameter D is initialized to one. Then, in step 710, it is determined whether $2^D - D - 1$ is less than K. If no, then the flow proceeds to step 730. If yes, the flow proceeds to step 720, where the parameter D is incremented. Then, the flow proceeds back to step 710. Once D has been determined, then, in step 730, the parameter E is calculated as R - D - 1.

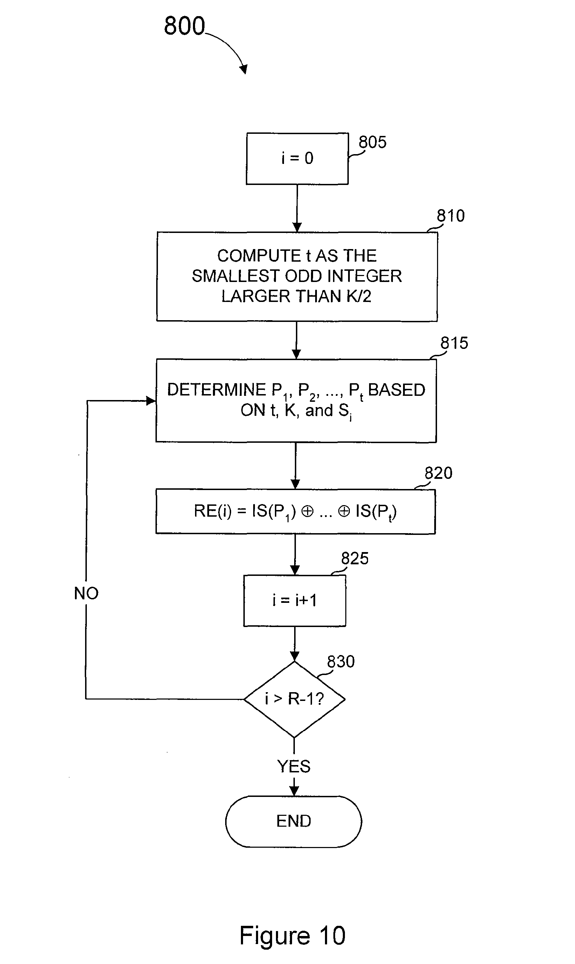

Fig. 10 is a simplified flow diagram of such an encoder according to one embodiment of the present invention, which will now be described. First, in step 805, a variable i is initialized to zero. Variable i keeps track of the number of redundant symbols already generated. In step 810, a number t is calculated as the smallest odd integer greater than or equal to K/2. In step 815, values $P_1$, $P_2$, ..., $P_t$ are generated based on K, t, and a static key $S_i$. The values $P_1$, $P_2$, ..., $P_t$ indicate the positions of input symbols that will be used to generate a redundant symbol. In one particular embodiment, an associator such as associator 515 of Fig. 5 is used to generate $P_1$, $P_2$, ..., $P_t$. In particular, the value t can be provided as the W(I) input, the value K can be provided as the K+R input, and the static key $S_i$ can be provided as the key I input. It should be noted that many different values of t would yield similar coding effects, and thus this particular choice is only an example. In step 820, the value of RE(i) is computed as the XOR of the values $IS(P_1)$, $IS(P_2)$,...,$IS(P_t)$. In step 825, the variable i is incremented by one to prepare computation of the next redundant symbol, and in step 830, it is determined whether all the redundant symbols have been computed. If not, then the flow returns to step 815.

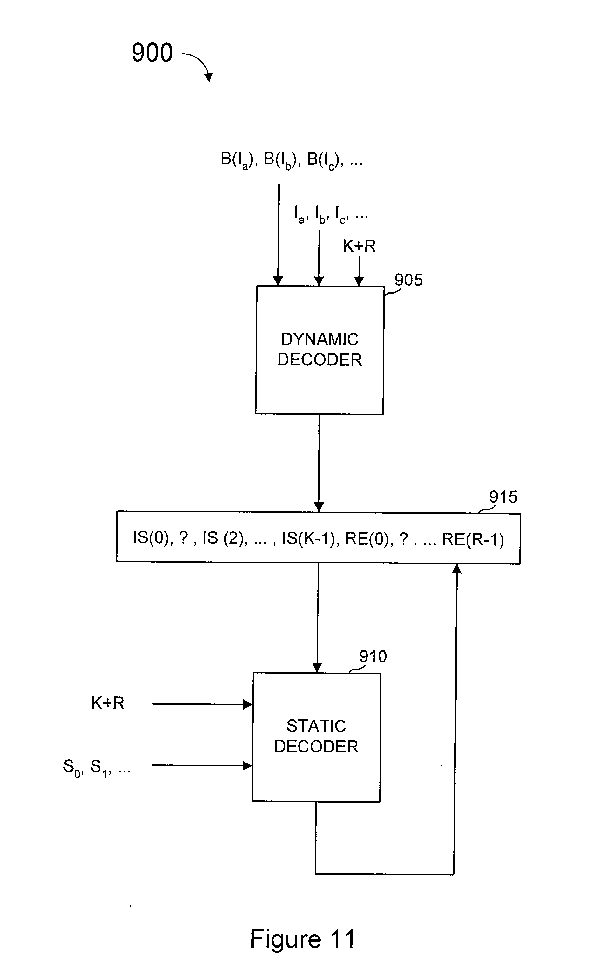

Fig. 11 is a simplified block diagram illustrating one embodiment of a decoder according to the present invention. Decoder 900 can be used, for example, to implement decoder 155 of Fig. 1.

Decoder 900 comprises a dynamic decoder 905 and a static decoder 910. Input symbols and redundant symbols recovered by dynamic decoder 905 are stored in a reconstruction buffer 915. Upon completion of dynamic decoding, static decoder 910 attempts to recover any input symbols not recovered by dynamic decoder 905, if any. In particular, static decoder 910 receives input symbols and redundant symbols from reconstruction buffer 915.

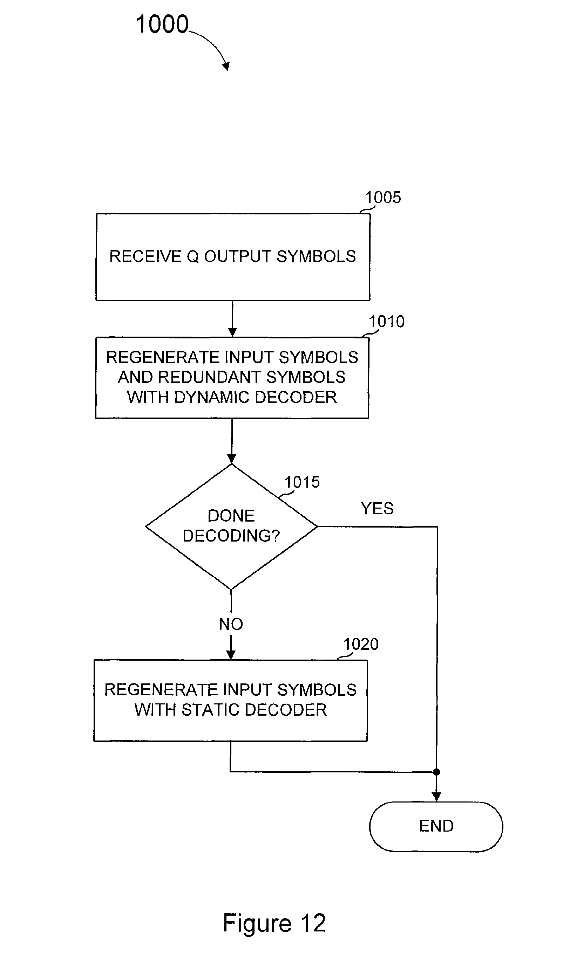

Fig. 12 is a simplified flow diagram illustrating one embodiment of a method for decoding according to the present invention. In step 1005, Q output symbols are received by the decoder. The value of Q can depend on the number of input symbols and the specific dynamic encoder used. The value of Q can also depend on the desired degree of accuracy to which the decoder can recover the input symbols. For example, if it is desired that the decoder can recover all of the input symbols with a high probability, then Q should be chosen to be larger than the number of input symbols. Particularly, in some applications, when the number of input symbols is large, Q can be less than 3% larger than the number of original input symbols. In other applications, when the number of input symbols is small, Q can be at least 10% larger than the number of input symbols. Specifically, Q can be chosen as the number K of input symbols plus a number A, where A is chosen to ensure that the decoder can regenerate all of the input symbols with a high probability. Determination of the number A is described in more detail below. If it is acceptable for the decoder to be unable to decode all of the input symbols (either sometimes or always), then Q can be less than K+A, equal to K, or even less than K. Clearly, one aim of an overall coding system will often be to decrease the number Q as much as possible, while maintaining good probabilistic guarantees on the success of the decoding process with respect to the desired degree of accuracy.

In step 1010, dynamic decoder 905 regenerates input symbols and redundant symbols from the Q received output symbols. It is to be understood, that steps 1005 and 1010 can be performed substantially concurrently. For example, dynamic decoder 905 can begin regenerating input symbols and redundant symbols prior to the decoder receiving Q output symbols.

After dynamic decoder 905 has processed Q output symbols, then it is determined whether the input symbols have been recovered to a desired degree of accuracy. The desired degree of accuracy may be, for example, all of the input symbols, or some number, percentage, etc., less than all of the input symbols. If yes, then the flow ends. If no, then the flow proceeds to step 1020. In step 1020, static decoder 910 attempts to recover any input symbols that dynamic decoder 905 was unable to recover. After static encoder 910 has processed the input symbols and redundant symbols recovered by dynamic encoder 905, then the flow ends.

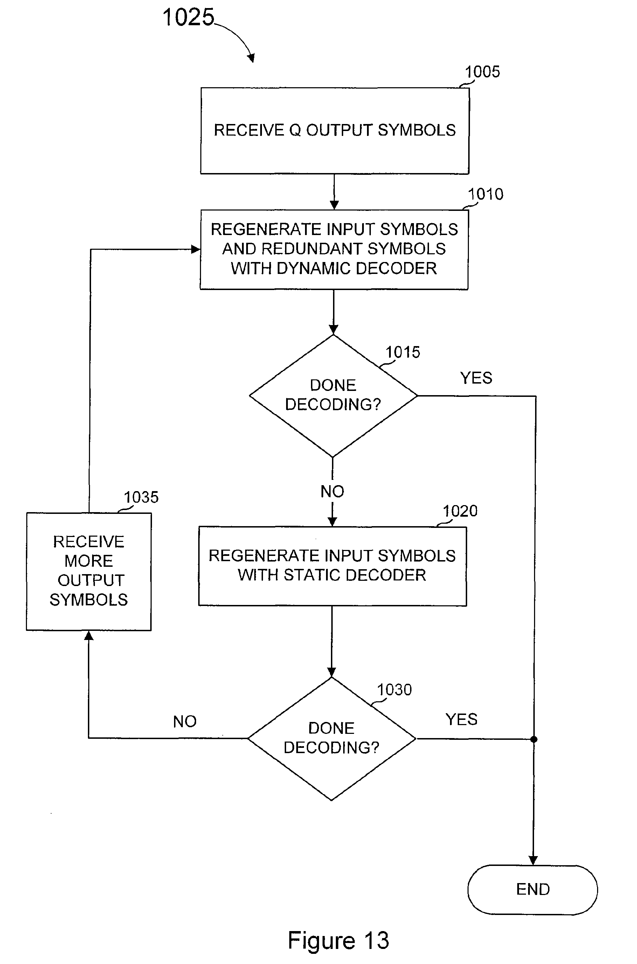

Fig. 13 is a simplified flow diagram illustrating another embodiment of a method for decoding according to the present invention. This embodiment is similar to that described with respect to Fig. 11, and includes steps 1005, 1010, 1015, and 1025 in common. But, after step 1025, the flow proceeds to step 1030, in which it is determined whether the input symbols have been recovered to a desired degree of accuracy. If yes, then the flow ends. If no, then the flow proceeds to step 1035. In step 1035, one or more additional output symbols are received. Then, the flow proceeds back to step 1010, so that dynamic decoder 905 and/or static decoder 910 can attempt to recover the remaining unrecovered input symbols.

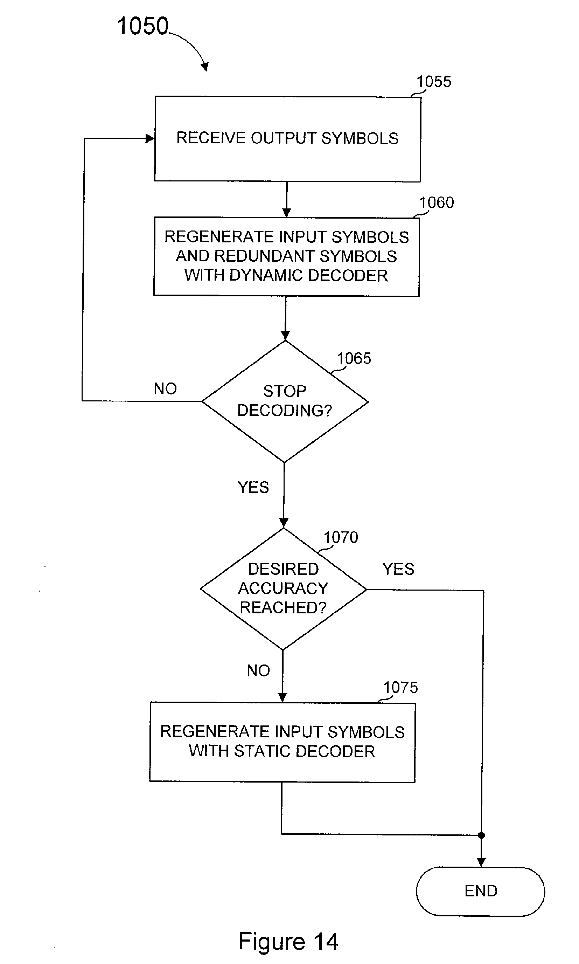

Fig. 14 is a simplified flow diagram illustrating yet another embodiment of a method for decoding according to the present invention. In step 1055, output symbols are received by the decoder, and in step 1060, dynamic decoder 905 regenerates input symbols and redundant symbols from the received output symbols. Then, in step 1065, it is determined whether dynamic decoding should be ended. This determination can be based on one or more of the number of output symbols processed, the number of input symbols recovered, the current rate at which additional input symbols are being recovered, the time spent processing output symbols, etc.

In step 1065, if it is determined that dynamic decoding is not to be stopped, then the flow proceeds back to step 1055. But, if in step 1065, it is determined to end dynamic decoding, then the flow proceeds to step 1070. In step 1070, it is determined whether the input symbols have been recovered to a desired degree of accuracy. If yes, then the flow ends. If no, then the flow proceeds to step 1075. In step 1075, static decoder 910 attempts to recover any input symbols that dynamic decoder 905 was unable to recover. After static encoder 910 has processed the input symbols and redundant symbols recovered by dynamic encoder 905, the flow ends.

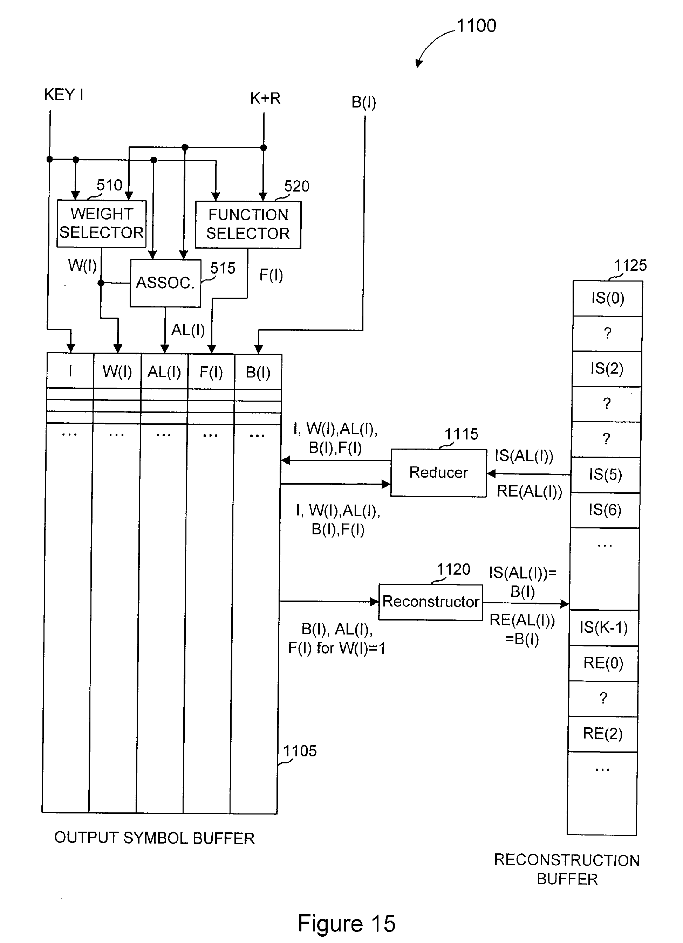

Fig. 15 shows one embodiment of dynamic decoder according to the present invention. Dynamic decoder 1100 includes similar components as those of dynamic encoder 500 shown in Fig. 5. Decoder 1100 is similar to embodiments of chain reaction decoders described in Luby I and Luby II. Dynamic decoder 1100 comprises a weight selector 510, an associator 515, a value function selector 520, an output symbol buffer 1105, a reducer 1115, a reconstructor 1120 and a reconstruction buffer 1125.

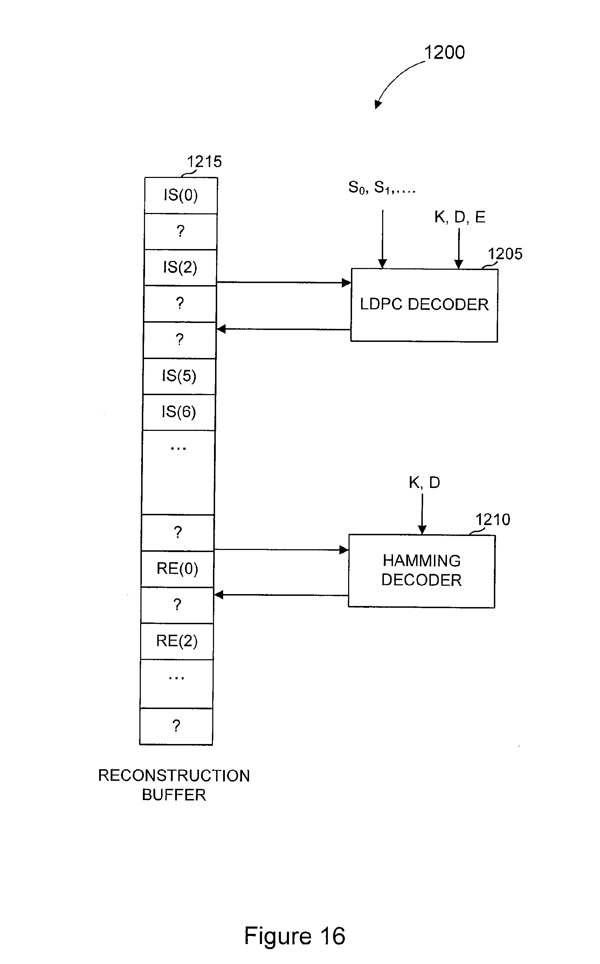

Fig. 16 is a simplified block diagram illustrating one embodiment of a static decoder. This embodiment can be used when the data is encoded with a static encoder such as described with reference to Fig. 7. Static decoder 1200 comprises a LDPC decoder 1205 and a Hamming decoder 1210. The LDPC decoder 1205 receives input symbols and redundant symbols from a reconstruction buffer 1215, and attempts to reconstruct those symbols of reconstruction buffer 1215 unrecovered after the decoding step of the dynamic decoder. In some embodiments, reconstruction buffer 1215 is reconstruction buffer 1125 (Fig. 15).

Many variations of LDPC decoders and HDPC decoders are well known to those skilled in the art, and can be employed in various embodiments according to the present invention. In one specific embodiment, HDPC decoder is implemented using a Gaussian elimination algorithm. Many variations of Gaussian elimination algorithms are well known to those skilled in the art, and can be employed in various embodiments according to the present invention.

A Variation of HDPC coding

Another type of HDPC encoding is now described. In this embodiment of HDPC encoding, the mathematical operation for creating redundant symbols from a given set of data is based on operations in a finite field.

In this embodiment of HDPC coding, the elements of a finite field are used to obtain redundant symbols HD[0],...,HD[D-1]. These symbols are obtained by defining a multiplication process between the symbols IS[0],...,IS[K-1], LD[0],...,LD[E-1] and elements of the finite field as described above.

HDPC coding

When using an HDPC code, the code might be described by a generator matrix over a finite field $GF(2^M)$. Where the code is systematic, which is the case in a preferred embodiment, the generator matrix can be described using only the relationship between the K+E input symbols IS[0],...,IS[K-1],LD[0],...,LD[E-1] and the redundant symbols HD[0],...,HD[D-1]. This matrix, called *G*, is of format Dx(K+E). If *X* denotes the column vector comprising the symbols HD[0],...,HD[D-1] and *S* denotes the column vector comprising the symbols IS[0],...,IS[K-1],LD[0],...,LD[E-1], then we have $X = G \oplus S$. More specific embodiments for the matrix *G* and various methods for efficient computation of the symbols are described below.

Variations

Multi-stage chain reaction codes as described above are not systematic codes, i.e., all of the original source symbols of a source block are not necessarily among the encoding symbols that are sent. However, systematic FEC codes are useful for a file download system or service, and very important for a streaming system or service. As shown in the implementation below, a modified code can be made to be systematic and still maintain the fountain code and other described properties.

One reason why it is easy to construct a variety of supplemental services using multi-stage codes is that it can combine received encoding symbols from multiple senders to reconstruct a source file or stream without coordination among the senders. The only requirement is that the senders use differing sets of keys to generate the encoding symbols that they send in encoding packets to the code. Ways to achieve this include designating different ranges of the key space to be used by each such sender, or generating keys randomly at each sender.

As an example of the use of this capability, consider providing a supplemental service to a file download service that allows multi-stage chain reaction codes that did not receive enough encoding packets to reconstruct a source file from the file download session to request additional encoding packets to be sent from a make-up sender, e.g., via a HTTP session. The make-up sender generates encoding symbols from the source file and sends them, for example using HTTP, and all these encoding symbols can be combined with those received from the file download session to recover the source file. Using this approach allows different senders to provide incremental source file delivery services without coordination between the senders, and ensuring that each individual receiver need receive only a minimal number of encoding packets to recover each source file.

Decoding of multi-stage chain reaction codes as described above may require a relatively large overhead when the number of source symbols is small, for example in the order of hundreds to a few thousands source symbols. In such a case, a different decoder is preferred, for example a decoder disclosed in Shokrollahi III. As shown in the implementation below, a modified decoding algorithm can be designed for the class of codes disclosed herein that uses features of the codes and concepts disclosed in Shokrollahi III, and provides low decoding error probability for very small numbers of source symbols, while maintaining efficiency in the decoding.

Implementations of Various Stagers of Multi-field Multi-Stage Codes

FEC Scheme definition

A packet using these techniques might be represented with header information such as an FEC Payload ID of four octets comprising a Source Block Number (SBN) (16 bit integer identifier for the source block that the encoding symbols within the packet relate to) and an Encoding Symbol ID (ESI) (16 bit integer identifier for the encoding symbols within the packet). One suitable interpretation of the Source Block Number and Encoding Symbol Identifier is defined in Sections B below. FEC Object Transmission information might comprise the FEC Encoding ID, a Transfer Length ($F$) and the parameters $T, Z, N$ and $A$ defined in below. The parameters $T$ and $Z$ are 16 bit unsigned integers, $N$ and $A$ are 8 bit unsigned integers. If needed, other integer sizes might be used.

An FEC encoding scheme for forward error correction is defined in the sections below. It defines two different FEC Payload ID formats, one for FEC source packets and another for FEC repair packets, but variations for nonsystematic codes are also possible.

The Source FEC payload ID might comprise a Source Block Number (SBN) (16 bit integer identifier for the source block that the encoding symbols within the packet relate to) and an Encoding Symbol ID (ESI) (16 bit integer identifier for the encoding symbols within the packet), while the Repair FEC Payload ID might comprise a Source Block Number (SBN) (16 bit integer identifier for the source block that the repair symbols within the packet relate to), an Encoding Symbol ID (ESI) (16 bit integer identifier for the repair symbols within the packet), and a Source Block Length (SBL) (16 bits, representing the number of source symbols in the source block. The interpretation of the Source Block Number, Encoding Symbol Identifier and Source Block Length is defined below.

FEC Object Transmission information might comprise the FEC Encoding ID, the maximum source block length, in symbols, and the symbol size, in bytes. The symbol size and maximum source block length might comprise a four octet field of Symbol Size ($T$) (16 bits representing the size of an encoding symbol, in bytes), and a Maximum Source Block Length (16 bits representing the maximum length of a source block, in symbols).

The sections below specify the systematic multi-field MSCR forward error correction code. Multi-field MSCR codes are fountain codes, i.e., as many encoding symbols as needed can be generated by the encoder on-the-fly from the source symbols of a block. The decoder is able to recover the source block from any set of encoding symbols only slightly more in number than the number of source symbols. The code described in this document is a systematic code, that is, the original source symbols are sent unmodified from sender to receiver, as well as a number of repair symbols.

B.1 Definitions, Symbols and abbreviations

B.1.1 Definitions

For the purposes of this description, the following terms and definitions apply.

**Source block:** a block of $K$ source symbols which are considered together for MSCR encoding purposes.

**Source symbol:** the smallest unit of data used during the encoding process. All source symbols within a source block have the same size.

**Encoding symbol:** a symbol that is included in a data packet. The encoding symbols comprise the source symbols and the repair symbols. Repair symbols generated from a source block have the same size as the source symbols of that source block.

**Systematic code:** a code in which the source symbols are included as part of the encoding symbols sent for a source block.

**Repair symbol:** the encoding symbols sent for a source block that are not the source symbols. The repair symbols are generated based on the source symbols.

**Intermediate symbols:** symbols generated from the source symbols using an inverse encoding process. The repair symbols are then generated directly from the intermediate symbols. The encoding symbols do not include the intermediate symbols, i.e., intermediate symbols are not included in data packets.

**Symbol:** a unit of data. The size, in bytes, of a symbol is known as the symbol size.

**Encoding symbol group:** a group of encoding symbols that are sent together, i.e., within the same packet whose relationship to the source symbols can be derived from a single Encoding Symbol ID.

**Encoding Symbol ID:** information that defines the relationship between the symbols of an encoding symbol group and the source symbols.

**Encoding packet:** data packets that contain encoding symbols

**Sub-block:** a source block is sometime broken into sub-blocks, each of which is sufficiently small to be decoded in working memory. For a source block comprising K source symbols, each sub-block comprises K sub-symbols, each symbol of the source block being composed of one sub-symbol from each sub-block.

**Sub-symbol:** part of a symbol. Each source symbol is composed of as many sub-symbols as there are sub-blocks in the source block.

**Source packet:** data packets that contain source symbols.

**Repair packet:** data packets that contain repair symbols.


B.1.2. Symbols


| | |
|---|---|
| $i, j, x, h, a, b, d, v, m$ | represent positive integers |
| ceil($x$) | denotes the smallest positive integer which is greater than or equal to $x$ |
| choose($i,j$) | denotes the number of ways $j$ objects can be chosen from among $i$ objects without repetition |
| floor($x$) | denotes the largest positive integer which is less than or equal to $x$ |
| $i$ % $j$ | denotes $i$ modulo $j$ |
| $X$ ^ $Y$ | denotes, for equal-length bit strings $X$ and $Y$, the bitwise exclusive-or of $X$ and $Y$ |
| $A$ | denote a symbol alignment parameter. Symbol and sub-symbol sizes are restricted to be multiples of $A$. |
| $\mathbf{A^T}$ | denotes the transposed matrix of matrix $\mathbf{A}$ |
| $\mathbf{A^{-1}}$ | denotes the inverse matrix of matrix $\mathbf{A}$ |
| $K$ | denotes the number of symbols in a single source block |
| $K_{MAX}$ | denotes the maximum number of source symbols that can be in a single source block. Set to 8192. Note that other values might be used. |
| $L$ | denotes the number of pre-coding symbols for a single source block |
| $S$ | denotes the number of LDPC symbols for a single source block |
| $H$ | denotes the number of Half symbols for a single source block |
| $\mathbf{C}$ | denotes an array of intermediate symbols, $C[0], C[1], C[2],..., C[L-1]$ |
| $\mathbf{C'}$ | denotes an array of source symbols, $C'[0], C'[1], C'[2],..., C'[K-1]$ |
| $X$ | a non-negative integer value |
| $V_0, V_1$ | two arrays of 4-byte integers, $V_0[0], V_0[1],..., V_0[255]$; $V_1[0], V_1[1],..., V_1[255]$ |
| Rand[$X, i, m$] | a pseudo-random number generator |
| Deg[$v$] | a degree generator |
| LTEnc[$K, \mathbf{C}$ ,($d, a, b$)] | a LT encoding symbol generator |
| Trip[$K, X$] | a triple generator function |
| $G$ | the number of symbols within an encoding symbol group |
| $N$ | the number of sub-blocks within a source block |
| $T$ | the symbol size in bytes. If the source block is partitioned into sub-blocks, then $T = T' \cdot N$. |
| $T'$ | the sub-symbol size, in bytes. If the source block is not partitioned into sub-blocks then $T'$ is not relevant. |

(continued)

| $i, j, x, h, a, b, d, v, m$ | represent positive integers |
|---|---|
| $F$ | the file size, for file download, in bytes |
| $I$ | the sub-block size in bytes |
| $P$ | for file download, the payload size of each packet, in bytes, that is used in one preferred derivation of the file download transport parameters. For streaming, the payload size of each repair packet, in bytes, that is used in one preferred derivation of the streaming transport parameters. |
| $Q$ | $Q$ = 65521, i.e., $Q$ is the largest prime smaller than $2^{16}$. Note that other values might be used instead of $2^{16}$. |
| $Z$ | the number of source blocks, for file download |
| $J(K)$ | the systematic index associated with $K$ |
| **G** | denotes any generator matrix |
| $\mathbf{I}_S$ | denotes the $SxS$ identity matrix |
| $\mathbf{0}_{SxH}$ | denotes the $SxH$ zero matrix |

B.1.3 Abbreviations

For the purposes of the present document, the following abbreviations apply:

ESI:     Encoding Symbol ID
LDPC:    Low Density Parity Check
LT:      Luby Transform
SBN:     Source Block Number
SBL:     Source Block Length (in units of symbols)

B.2. Overview

The MSCR forward error correction code can be applied to both file delivery and streaming applications. MSCR code aspects which are specific to each of these applications are discussed in Sections B.3 and B.4 of this document.
A component of the systematic MSCR code is the basic encoder described in Section B.5. First, it is described how to derive values for a set of intermediate symbols from the original source symbols such that knowledge of the intermediate symbols is sufficient to reconstruct the source symbols. Secondly, the encoder produces repair symbols which are each the exclusive OR of a number of the intermediate symbols. The encoding symbols are the combination of the source and repair symbols. The repair symbols are produced in such a way that the intermediate symbols and therefore also the source symbols can be recovered from any sufficiently large set of encoding symbols.
This document defines the systematic MSCR code encoder. A number of possible decoding algorithms are possible. An efficient decoding algorithm is provided in Section B.6.
The construction of the intermediate and repair symbols is based in part on a pseudorandom number generator described in Section B.5. This generator is based on a fixed set of 512 random numbers that are available to both sender and receiver. An example set of numbers are those provided in Appendices B.1 and B.2.
Finally, the construction of the intermediate symbols from the source symbols is governed by a "'systematic index". An example set of values for the systematic index is shown in Appendix A for source block sizes from 4 source symbols to $K_{MAX}$ = 8192 source symbols.

B.3. File download

B.3.1. Source block construction

B.3.1.1. General

In order to apply the MSCR encoder to a source file, the file may be broken into $Z \geq 1$ blocks, known as *source*

*blocks.* The MSCR encoder is applied independently to each source block. Each source block is identified by a unique integer Source Block Number (SBN), where the first source block has SBN zero, the second has SBN one, etc. Each source block is divided into a number, $K$, of *source symbols* of size $T$ bytes each. Each source symbol is identified by a unique integer Encoding Symbol Identifier (ESI), where the first source symbol of a source block has ESI zero, the second has ESI one, etc.

Each source block with $K$ source symbols is divided into $N \geq 1$ sub-blocks, which are small enough to be decoded in the working memory. Each sub-block is divided into K sub-symbols of size $T'$.

Note that the value of $K$ is not necessarily the same for each source block of a file and the value of $T'$ may not necessarily be the same for each sub-block of a source block. However, the symbol size $T$ is the same for all source blocks of a file and the number of symbols, $K$ is the same for every sub-block of a source block. Exact partitioning of the file into source blocks and sub-blocks is described in B.3.1.2 below.

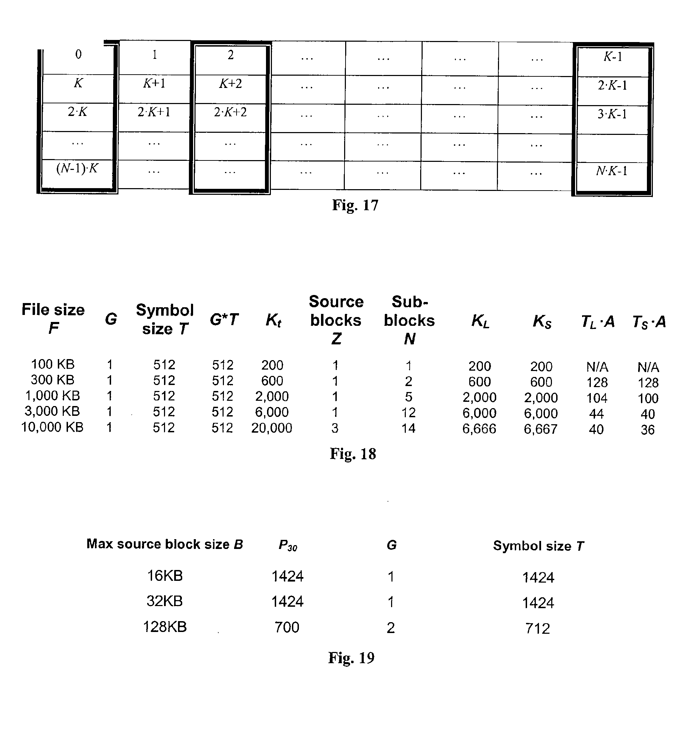

Fig. 17 shows an example source block placed into a two dimensional array, where each entry is a $T'$-byte sub-symbol, each row is a sub-block and each column is a source symbol. In this example, the value of $T'$ is the same for every sub-block. The number shown in each sub-symbol entry indicates their original order within the source block. For example, the sub-symbol numbered $K$ contains bytes $T' \cdot K$ through $T' \cdot (K+1)-1$ of the source block. Then, source symbol $i$ is the concatenation of the $i$th sub-symbol from each of the sub-blocks, which corresponds to the sub-symbols of the source block numbered $i$, $K+i$, $2 \cdot K+i$,..., $(N-1) \cdot K+i$.

B.3.1.2 Source block and sub-block partitioning

The construction of source blocks and sub-blocks is determined based on five input parameters, $F$, $A$, $T$, $Z$ and $N$ and a function Partition[]. The five input parameters are defined as follows:

$F$    the size of the file, in bytes
$A$    a symbol alignment parameter, in bytes
$T$    the symbol size, in bytes, which preferably is a multiple of $A$
$Z$    the number of source blocks
$N$    the number of sub-blocks in each source block

These parameters might be set so that $\text{ceil}(\text{ceil}(F/T)/Z) \leq K_{MAX}$. An example of some suitable derivations of these parameters are provided in Section B.3.4.

The function Partition[] takes a pair of integers $(I, J)$ as input and derives four integers $(I_L, I_S, J_L, J_S)$ as output. Specifically, the value of Partition$[I, J]$ is a sequence of four integers $(I_L, I_S, J_L, J_S)$, where $I_L = \text{ceil}(I/J)$, $I_S = \text{floor}(I/J)$, $J_L = I - I_S \cdot J$ and $J_S = J - J_L$. Partition[] derives parameters for partitioning a block of size $I$ into $J$ approximately equal sized blocks. Specifically, $J_L$ blocks of length $I_L$ and $J_S$ blocks of length $I_S$.

The source file might be partitioned into source blocks and sub-blocks as follows:

Let,

$$K_t = \text{ceil}(F/T)$$

$$(K_L, K_S, Z_L, Z_S) = \text{Partition}[K_t, Z\,]$$

$$(T_L, T_S, N_L, N_S) = \text{Partition}[T/A, N\,]$$

Then, the file might be partitioned into $Z = Z_L + Z_S$ contiguous source blocks, the first $Z_L$ source blocks each having length $K_L \cdot T$ bytes and the remaining $Z_S$ source blocks each having $K_S \cdot T$ bytes.

If $K_t \cdot T > F$ then for encoding purposes, the last symbol might be padded at the end with $K_t \cdot T - F$ zero bytes.

Next, each source block might be divided into $N = N_L + N_S$ contiguous sub-blocks, the first $N_L$ sub-blocks each comprising $K$ contiguous sub-symbols of size of $T_L \cdot A$ and the remaining $N_S$ sub-blocks each comprising $K$ contiguous sub-symbols of size of $T_S \cdot A$. The symbol alignment parameter $A$ ensures that sub-symbols are always a multiple of $A$ bytes.

Finally, the $m$th symbol of a source block comprises the concatenation of the $m$th sub-symbol from each of the $N$ sub-blocks.

B.3.2. Encoding packet construction

B.3.2.1. General

Each encoding packet contains a Source Block Number (SBN), an Encoding Symbol ID (ESI) and encoding symbol(s). Each source block is encoded independently of the others. Source blocks are numbered consecutively from zero. Encoding Symbol ID values from 0 to $K$-1 identify the source symbols. Encoding Symbol IDs from K onwards identify repair symbols.

B.3.2.2 Encoding packet construction

Each encoding packet preferably either contains source symbols (source packet) or contains repair symbols (repair packet). A packet may contain any number of symbols from the same source block. In the case that the last symbol in the packet includes padding bytes added for FEC encoding purposes then these bytes need not be included in the packet. Otherwise, only whole symbols might be included.

The Encoding Symbol ID, $X$, carried in each source packet is the Encoding Symbol ID of the first source symbol carried in that packet. The subsequent source symbols in the packet have Encoding Symbol IDs, $X$+1 to $X$+$G$-1, in sequential order, where $G$ is the number of symbols in the packet.

Similarly, the Encoding Symbol ID, $X$, placed into a repair packet is the Encoding Symbol ID of the first repair symbol in the repair packet and the subsequent repair symbols in the packet have Encoding Symbol IDs $X$+1 to $X$+$G$-1 in sequential order, where $G$ is the number of symbols in the packet.

Note that it is not necessary for the receiver to know the total number of repair packets. The $G$ repair symbol triples ($d$[0], $a$[0], $b$[0]),..., ($d$[$G$-1], $a$[$G$-1], $b$[$G$-1]) for the repair symbols placed into a repair packet with ESI $X$ are computed using the Triple generator defined in B.5.3.4 as follows:

For each $i$ = 0, ..., $G$-1
($d$[$i$], $a$[$i$], $b$[$i$]) = Trip[$K$,$X$+$i$]

The $G$ repair symbols to be placed in repair packet with ESI $X$ are calculated based on the repair symbol triples as described in Section B.5.3 using the intermediate symbols **C** and the LT encoder LTenc[$K$, **C,** ($d$[$i$], $a$[$i$], $b$[$i$])].

B.3.3. Transport

This section describes the information exchange between the MSCR encoder/decoder and any transport protocol making use of MSCR forward error correction for file delivery.

The MSCR encoder and decoder for file delivery require the following information from the transport protocol: the file size, $F$, in bytes, the symbol alignment parameter, $A$, the symbol size, $T$, in bytes, which is a multiple of $A$, the number of source blocks, $Z$, the number of sub-blocks in each source block, $N$. The MSCR encoder for file delivery additionally requires the file to be encoded, $F$ bytes.

The MSCR encoder supplies the transport protocol with encoding packet information comprising, for each packet, the SBN, the ESI and the encoding symbol(s). The transport protocol might communicate this information transparently to the MSCR decoder.

B.3.4. Details of Specific Examples for Parameters

B.3.4.1 Parameter derivation algorithm

This section provides examples for the derivation of the four transport parameters, $A$, $T$, $Z$ and $N$ that provide good results. These are based on the following input parameters:

$F$       the file size, in bytes
$W$      a target on the sub-block size, in bytes
$P$       the maximum packet payload size, in bytes, which is assumed to be a multiple of $A$
$A$       the symbol alignment factor, in bytes
$K_{MAX}$   the maximum number of source symbols per source block.
$K_{MIN}$   a minimum target on the number of symbols per source block
$G_{MAX}$  a maximum target number of symbols per packet

Based on the above inputs, the transport parameters *T, Z* and *N* are calculated as follows:

Let,

$$G = \min\{\mathrm{ceil}(P \cdot K_{MIN}/F),\ P/A,\ G_{MAX}\} \text{ - the approximate number of symbols per packet}$$

$$T = \mathrm{floor}(P/(A \cdot G)) \cdot A$$

$$K_t = \mathrm{ceil}(F/T) \text{ - the total number of symbols in the file}$$

$$Z = \mathrm{ceil}(K_t / K_{MAX})$$

$$N = \min\{\mathrm{ceil}(\mathrm{ceil}(K_t/Z) \cdot T/W),\ T/A\}$$

The values of *G* and *N* derived above should be considered as lower bounds. It may be advantageous to increase these values, for example to the nearest power of two. In particular, the above algorithm does not guarantee that the symbol size, *T*, divides the maximum packet size, *P*, and so it may not be possible to use the packets of size exactly *P*. If, instead, *G* is chosen to be a value which divides *P/A,* then the symbol size, *T,* will be a divisor of *P* and packets of size *P* can be used.

Suitable values for the input parameters might be $W = 256$ KB, $A = 4$, $K_{MIN} = 4$, and $G_{MAX} = 1$.

B.3.4.2 Examples

The above algorithm leads to transport parameters as shown in Fig. 18, assuming the above values for *W, A,* $K_{MIN}$ and $G_{MAX}$ are used and with P = 512.

B.4. Streaming

B.4.1. Source block construction

A source block is constructed by the transport protocol, for example as defined in this document, making use of the Systematic MSCR Forward Error Correction code. The symbol size, *T,* to be used for source block construction and the repair symbol construction are provided by the transport protocol. The parameter *T* might be set so that the number of source symbols in any source block is at most $K_{MAX}$.

An example of parameters that work well are presented in section B.4.4.

B.4.2. Encoding packet construction

As described in B.4.3., each repair packet contains the SBN, ESI, SBL and repair symbol(s). The number of repair symbols contained within a repair packet is computed from the packet length. The ESI values placed into the repair packets and the repair symbol triples used to generate the repair symbols are computed as described in Section B.3.2.2.

B.4.3. Transport

This section describes the information exchange between the MSCR encoder/decoder and any transport protocol making use of MSCR forward error correction for streaming. The MSCR encoder for streaming might use the following information from the transport protocol for each source block: the symbol size, *T,* in bytes, the number of symbols in the source block, *K*, the Source Block Number (SBN) and the source symbols to be encoded, $K \cdot T$ bytes. The MSCR encoder supplies the transport protocol with encoding packet information comprising, for each repair packet, the SBN, the ESI, the SBL and the repair symbol(s). The transport protocol might communicate this information transparently to the MSCR decoder.

B.4.4. Selection of Parameters

A number of methods for parameter selection can be used. Some of those are described below in detail.

B.4.4.1 Parameter derivation algorithm

This section explains a derivation of the transport parameter $T$, based on the following input parameters:

| $B$ | the maximum source block size, in bytes |
|---|---|
| $P_{max}$ | the maximum Source Packet Information size, without padding |
| $P_r$ | the $x$th percentile Source Packet Information size, without padding (i.e. the least number, $n$, such that $x\%$ of the packets are expected to have Source Packet Information size $n$ or less. In one embodiment, the value of $x$ is 30. |
| $A$ | the symbol alignment factor, in bytes |
| $K_{MAX}$ | the maximum number of source symbols per source block. |
| $K_{MIN}$ | a minimum target on the number of symbols per source block |
| $G_{MAX}$ | a maximum target number of symbols per repair packet |

A requirement on these inputs is that $\text{ceil}(B/P) \leq K_{MAX}$. Based on the above inputs, the transport parameter $T$ is calculated as follows:

$$\text{Let } G = \min\{\max \{ \text{ceil}(P \cdot K_{MIN}/B), \text{floor}(P_x/P_{max}) \}, P/A, G_{MAX}\} \quad \text{- the number of symbols per SPI}$$

$$T = \text{floor}(P/(A \cdot G)) \cdot A$$

The value of $T$ derived above should be considered as a guide to the actual value of $T$ used. It may be advantageous to ensure that $T$ divides into $P$, or it may be advantageous to set the value of $T$ smaller to minimize wastage when full size repair symbols are used to recover partial source symbols at the end of lost source packets (as long as the maximum number of source symbols in a source block does not exceed $K_{MAX}$). Furthermore, the choice of $T$ may depend on the source packet size distribution, e.g., if all source packets are the same size then it is advantageous to choose $T$ so that the actual payload size of a repair packet $P'$, where $P'$ is a multiple of $T$, is equal to (or as few bytes as possible larger than) the number of bytes each source packet occupies in the source block.
Suitable values for the input parameters might be $A$ = 16, $K_{MIN}$ = 4 and $G_{MAX}$ = 4.

B.4.4.2 Examples

The above algorithm leads to transport parameters as shown in Fig. 19, assuming the above values for $A$, $K_{MIN}$ and $G_{MAX}$ and assuming $P$ = 1424.

B.5. Systematic Multi-field MSCR encoder

B.5.1. Encoding overview

The systematic MSCR encoder is used to generate *repair symbols* from a source block that comprises *K source symbols.*
Symbols are the fundamental data units of the encoding and decoding process. For each source block (sub-block) all symbols (sub-symbols) are the same size. The atomic operation performed on symbols (sub-symbols) for both encoding and decoding is the exclusive-or operation.
Let $C'[0],..., C'[K-1]$ denote the $K$ source symbols.
Let $C[0],..., C[L-1]$ denote $L$ intermediate symbols.

The first step of encoding is to generate a number, $L > K$, of intermediate symbols from the $K$ source symbols. In this step, $K$ source triples ($d$[0], $a$[0], $b$[0]), ..., ($d$[$K$-1], $a$[$K$-1], $b$[$K$-1]) are generated using the Trip[] generator as described in Section B.5.4.4. The $K$ source triples are associated with the $K$ source symbols and are then used to determine the $L$ intermediate symbols $C$[0], ..., $C$[$L$-1] from the source symbols using an inverse encoding process. This process can be can be realized by a MSCR decoding process.

Certain "pre-coding relationships" preferably hold within the $L$ intermediate symbols. Section B.5.2 describes these relationships and how the intermediate symbols are generated from the source symbols.

Once the intermediate symbols have been generated, repair symbols are produced and one or more repair symbols are placed as a group into a single data packet. Each repair symbol group is associated with an Encoding Symbol ID (ESI) and a number, $G$, of encoding symbols. The ESI is used to generate a triple of three integers, ($d$, $a$, $b$) for each repair symbol, again using the Trip[] generator as described in Section B.5.4.4. This is done as described in Sections B.3 and B.4 using the generators described in Section B.5.4. Then, each ($d$,$a$,$b$)-triple is used to generate the corresponding repair symbol from the intermediate symbols using the LTEnc[$K$, $C$[0],..., $C$[$L$-1], ($d$,$a$,$b$)] generator described in Section B.5.4.3.

B.5.2. First encoding step: Intermediate Symbol Generation

B.5.2.1 General

The first encoding step is a pre-coding step to generate the $L$ intermediate symbols $C$[0], ..., $C$[$L$-1] from the source symbols $C'$[0], ..., $C'$[$K$-1]. The intermediate symbols are uniquely defined by two sets of constraints:

1. The intermediate symbols are related to the source symbols by a set of *source symbol triples.* The generation of the source symbol triples is defined in Section B.5.2.2 using the Trip[] generator as described in Section B.5.4.4.
2. A set of pre-coding relationships hold within the intermediate symbols themselves.

These are defined in Section B.5.2.3. The generation of the $L$ intermediate symbols is then defined in Section 5.2.4.

B.5.2.2 Source symbol triples

Each of *the $K$* source symbols is associated with a triple ($d$[$i$], $a$[$i$], $b$[$i$]) for $0 \leq i < K$. The source symbol triples are determined using the Triple generator defined in Section B.5.4.4 as:

For each $i$, $0 \leq i < K$
($d$[$i$], $a$[$i$], $b$[$i$]) = Trip[$K$, $i$]

B.5.2.3 Pre-coding relationships

The pre-coding relationships amongst the $L$ intermediate symbols are defined by expressing the last $L$-$K$ intermediate symbols in terms of the first $K$ intermediate symbols.

The last $L$-$K$ intermediate symbols $C$[$K$],...,$C$[$L$-1] comprise $S$ LDPC symbols and HHDPC symbols The values of $S$ and $H$ are determined from $K$ as described below. Then $L = K+S+H$.

Let

| | |
|---|---|
| $X$ | be the smallest positive integer such that $X \cdot (X\text{-}1) >= 2 \cdot K$. |
| $S$ | be the smallest prime integer such that $S \geq \text{ceil}(0.01 \cdot K) + X$ |
| $H$ | be the smallest integer such that $\text{choose}(H, \text{ceil}(H/2)) \geq K + S$ |
| $H'$ | $= \text{ceil}(H/2)$ |
| $L$ | $= K+S+H$ |
| $C$[0],..., $C$[$K$-1] | denote the first $K$ intermediate symbols |
| $C$[$K$],..., $C$[$K+S$-1] | denote the $S$ LDPC symbols, initialized to zero |
| $C$[$K+S$],..., $C$[$L$-1] | denote the $H$ HDPC symbols, initialized to zero |

The S LDPC symbols are defined to be the values of $C$[$K$],..., $C$[$K+S$-1] at the end of the following process:

For $i$ = 0, ..., $K$-1 do

$$a = 1 + (\text{floor}(i/S) \, \% \, (S\text{-}1))$$

$$b = i \, \% \, S$$

$$C[K + b] = C[K + b] \wedge C[i]$$

$$b = (b + a) \, \% \, S$$

$$C[K + b] = C[K + b] \wedge C[i]$$

$$b = (b + a) \, \% \, S$$

$$C[K + b] = C[K + b] \wedge C[i]$$

For the construction of the $H$ HDPC symbols, the system uses the field GF(256). The field can be represented with respect to the irreducible polynomial $f = x^8 + x^4 + x^3 + x^2 + 1$ over the field GF(2). Let $\alpha$ denote the element $x$ modulo $f$. As is well-known to those of ordinary skill in the art, the element $\alpha$ is primitive, i.e., the 255 first powers of $\alpha$ coincide with the 255 nonzero elements of GF(256). In one embodiment, the system choose $K+S$ integers $a[0],...,a[K+S\text{-}1]$, and denote by $\beta[0], ..., \beta[K+S\text{-}1]$ the elements $\alpha^{a[0]},..., \alpha^{a[K+S\text{-}1]}$. Further, we choose $H$ further integers $b[0],...,b[H\text{-}1]$ and denote by $\Gamma[0],...,\Gamma[H\text{-}1]$ the elements $\alpha^{b[0]},..., \alpha^{b[H\text{-}1]}$. Further preferred embodiments of the present invention will specify specific choices for these integers. However, it should be noted that are many equivalent choices of these integers. Let $g[i] = i \wedge (\text{floor}(i/2))$ for all positive integers $i$. Note that $g[i]$ is the Gray sequence, in which each element differs from the previous one in a single bit position. Furthermore, let $g[j,k]$ denote the $j^{th}$ element, $j=0, 1,2, ...$, of the subsequence of $g[i]$ whose elements have exactly $k$ non-zero bits in their binary representation. As is well-known to those of skill in the art, the sequence $g[j,k]$ has the property that the binary representations of $g[j,k]$ and $g[j+1,k]$ differ in exactly two positions. We denote these positions by $p[j,k,1]$ and $p[j,k,2]$.

The values of the HDPC symbols are defined as the values of $C[K+S],..., C[L\text{-}1]$ after the following process.

We initialize a symbol $U$ as 0. The size of this symbol is the same as the common size of source, LDPC, and HDPC symbols.

Next, for a variable $h$ ranging from 0 to $K+S\text{-}2$, we perform the following: The variable $U$ is updated as $U = U^* \beta[h] \wedge C[h]$. At the same time, we set $C[K+S+p[j,H',1]] = C[K+S+p[j,H',1]] \wedge U,$ and $C[K+S+p[j,H',2]] = C[K+S+p[j,H',2]] \wedge U.$

In a further step, we transform $U$ into $U^* \beta[K+S\text{-}1] \wedge C[K+S\text{-}1]$.

Next, for a variable $h$ ranging from 0 to $H\text{-}1$ we update $C[K+S+h] = C[K+S+h] \wedge \Gamma[h] * U.$ This completes the description of the HDPC coding process.

In a preferred embodiment, the system chooses the following integers $a[0],...,a[K+S\text{-}1]$, and $b[0],...,b[H\text{-}1]$: $a[0]=a[1]= ... =a[K+S\text{-}1] = 1$ and $b[0]=1, b[1]=2, ... b[i] = i+1$, etc. Advantageously, in this preferred embodiment, the construction of the HDPC symbols can be performed using only the action of the primitive element, $\alpha$, along with bitwise exclusive OR operations between symbols. The choice of irreducible polynomial give above admits highly efficient implementation of the action of $\alpha$, thereby reducing the computational complexity of the HDPC construction algorithm. As will be apparent to those of skill in the art, the construction algorithm described above can easily be adapted to perform the required decoding operations within a multi-stage code decoder, thus realizing the above mentioned reduction in computational complexity at the decoder as well.

B.5.2.4 Intermediate symbols

B.5.2.4.1 Definition

Given the $K$ source symbols $C'[0], C'[1], ..., C'[K\text{-}1]$ the $L$ intermediate symbols $C[0], C[1],..., C[L\text{-}1]$ are the uniquely defined symbol values that satisfy the following conditions:

1. The *K source* symbols $C'[0]$, $C'[1]$, ..., $C'[K-1]$ satisfy the *K* constraints $C'[i] \equiv \text{LTEnc}[K, (C[0], ..., C[L-1]), (d[i], a[i], b[i])]$, for all *i*, $0 \leq i < K$.

2. The *L* intermediate symbols $C[0]$, $C[1]$, *..., $C[L-1]$* satisfy the pre-coding relationships defined in B.5.2.3.

B.5.2.4.2 Calculation of intermediate symbols

This subsection describes a possible method for calculation of the *L* intermediate symbols $C[0]$, $C[1]$,..., $C[L-1]$ satisfying the constraints in B.5.2.4.1

The generator matrix **G** for a code which generates *N* output symbols from *K* input symbols is an *NxK* matrix over *GF*(2), where each row corresponds to one of the output symbols and each column to one of the input symbols and where the $i^{\text{th}}$ output symbol is equal to the sum of those input symbols whose column contains a non-zero entry in row *i*.

Then, the *L* intermediate symbols can be calculated as follows:

Let

**C** denote the column vector of the *L* intermediate symbols, $C[0]$, $C[1]$,..., $C[L-1]$,

**D** denote the column vector comprising *S+H* zero symbols followed by the *K* source symbols $C'[0]$, $C'[1]$, ..., $C'[K-1]$

Then the above constraints define an *LxL* matrix over *GF*(2), **A**, such that:

$$\mathbf{A} \cdot \mathbf{C} = \mathbf{D}$$

The matrix **A** can be constructed as follows:

Let:

$\mathbf{G}_{\text{LDPC}}$ be the *S* x *K* generator matrix of the LDPC symbols. So,

$\mathbf{G}_{\text{LDPC}} \cdot (C[0], ..., C[K-1])^{\text{T}} = (C[K], ..., C[K+S-1])^{\text{T}}$

$\mathbf{G}_{\text{HDPC}}$ be the *H* x (*K+S*) generator matrix of the Half symbols, So,

$\mathbf{G}_{\text{HDPC}} \otimes (C[0], ..., C[S+K-1])^{\text{T}} = (C[K+S], ..., C[K+S+H-1])^{\text{T}}$

$\mathbf{I}_S$ be the *S* x *S* identity matrix

$\mathbf{I}_H$ be the *H* x *H* identity matrix

$\mathbf{0}_{SxH}$ be the *S* x *H* zero matrix

$\mathbf{G}_{\text{LT}}$ be the *KxL* generator matrix of the encoding symbols generated by the LT Encoder. So,

$$\mathbf{G}_{\text{LT}} \cdot (C[0], \ldots, C[L\text{-}1])^{\text{T}} = (C'[0], C'[1], \ldots, C'[K\text{-}1])^{\text{T}}$$

i.e., $\mathbf{G}_{\text{LT}i,j} = 1$ if and only if $C[i]$ is included in the symbols which are XORed to produce $\text{LTEnc}[K, (C[0], ..., C[L-1]), (d[i], a[i], b[i])]$.

Then:

The first *S* rows of **A** are equal to $\mathbf{G}_{\text{LDPC}} | \mathbf{I}_S | \mathbf{Z}_{SxH}$.

The next *H* rows of **A** are equal to $\mathbf{G}_{\text{HDPC}} | \mathbf{I}_H$.

The remaining *K* rows of **A** are equal to $\mathbf{G}_{\text{LT}}$.

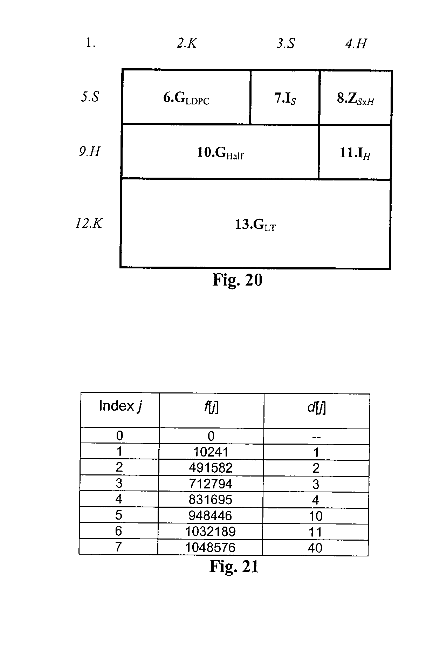

The matrix **A** is depicted in Fig. 20. The intermediate symbols can then be calculated as:

$$\mathbf{C} = \mathbf{A}^{-1} \cdot \mathbf{D}$$

The source triples are generated such that for any *K* matrix **A** has full rank and is therefore invertible. This calculation can be realized by applying a MSCR decoding process to the *K* source symbols $C'[0]$, $C'[1]$, ..., $C'[K-1]$ to produce the *L* intermediate symbols $C[0]$, $C[1]$, ..., $C[L-1]$.

To efficiently generate the intermediate symbols from the source symbols, an efficient decoder implementation such as that described in Section B.6 might be used. The source symbol triples are designed to facilitate efficient decoding of the source symbols using that algorithm.

B.5.3. Second encoding step: Chain reaction encoding

In the second encoding step, the repair symbol with ESI $X$ is generated by applying the generator LTEnc[$K$, ($C$[0], $C$[1], ..., $C$[$L$-1]), ($d, a, b$)] defined in Section B.5.4 to the $L$ intermediate symbols $C$[0], $C$[1], ..., $C$[$L$-1] using the triple ($d, a, b$)=Trip[$K,X$] generated according to Sections B.3.2.2 and B.4.2.

B.5.4. Generators

B.5.4.1 Random Generator

The random number generator Rand[$X$, $i$, $m$] is defined as follows, where $X$ is a non-negative integer, $i$ is a non-negative integer and $m$ is a positive integer and the value produced is an integer between 0 and $m$-1. Let $V_0$ and $V_1$ be arrays of 256 entries each, where each entry is a 4-byte unsigned integer. Suitable arrays of random numbers are provided in Appendices B.1 and B.2 by way of example only and should not be construed to limit the scope of the invention. Given those assumptions, Rand[$X$, $i$, $m$] = ($V_0$[($X$+ $i$) % 256] ^ $V_{-1}$[(floor($X$/256)+ $i$) % 256]) % $m$. As used herein, unless otherwise indicated, "random" should be assumed to include "pseudorandom" and "essentially random".

B.5.4.2 Degree Generator

The degree generator Deg[$v$] is defined as follows, where $v$ is an integer that is at least 0 and less than $2^{20}$ = 1048576.
In Fig. 21, find the index $j$ such that $f[j-1] < v < f[j]$

$$\mathrm{Deg}[v] = d[j]$$

B.5.4.3 Chain reaction Encoding Symbol Generator

The encoding symbol generator LTEnc[$K$, ($C$[0], $C$[1],..., $C$[L-1]), ($d, a, b$)] takes the following inputs:
$K$ is the number of source symbols (or sub-symbols) for the source block (sub-block). Let $L$ be derived *from* $K$ as described in Section B.5.2, and let $L'$ be the smallest prime integer greater than or equal to $L$.
($C$[0], $C$[1],..., $C$[L-1]) is the array of $L$ intermediate symbols (sub-symbols) generated as described in Section B.5.2
($d, a, b$) is a source triple determined using the Triple generator defined in Section B.5.3.4, whereby $d$ is an integer denoting an encoding symbol degree, $a$ is an integer between 1 and $L'$-1 inclusive and $b$ is an integer between 0 and $L'$-1 inclusive.
The encoding symbol generator produces a single encoding symbol as output, according to the following algorithm:

```
While (b ≥ L) do b = (b + a) % L'
LTEnc[K, (C[0], C[1],..., C[L-1]), (d, a, b)] = C[b].
For j = 1,...,min(d-1,L-1) do
b = (b + a) % L'
While (b ≥ L) do b = (b + a) % L'
LTEnc[K, (C[O], C[1],..., C[L-1]), (d, a, b)] = LTEne[K, (C[O], C[1],..., C[L-1]), (d, a, b)] ^ C[b]
```

B.5.4.4 Triple generator

The triple generator Trip[$K,X$] takes the following inputs:

$K$    The number of source symbols
$X$    An encoding symbol ID

Let

*L* be determined from *K* as described in Section B.5.2

*L'* *be* the smallest prime that is greater than or equal to *L*

*Q* = 65521, the largest prime smaller than $2^{16}$.

*J(K)* be the systematic index associated with K. The systematic index is a number chosen such that the process below, together which the remaining processed for construction of the matrix **A** described herein results in a matrix B which is invertible. Suitable systematic indices are provided in Appendix A by way of example only and should not be construed as to limit the scope of the invention.

The output of the triple generator is a triples, (*d, a, b*) determined as follows:

1. $A = (53591 + J(K) \cdot 997) \% Q$

2. $B = 10267 \cdot (J(K)+1) \% Q$

3. $Y = (B + X \cdot A) \% Q$

4. $v = \text{Rand}[Y, 0, 2^{20}]$

5. $d = \text{Deg}[v]$

6. $a = 1 + \text{Rand}[Y, 1, L'-1]$

7. $b = \text{Rand}[Y, 2, L']$

B.6 FEC decoder implementations

B.6.1 General

This section describes an efficient decoding algorithm for the MSCR codes described in this specification. Note that each received encoding symbol can be considered as the value of an equation amongst the intermediate symbols. From these simultaneous equations, and the known pre-coding relationships amongst the intermediate symbols, any algorithm for solving simultaneous equations can successfully decode the intermediate symbols and hence the source symbols. However, the algorithm chosen has a major effect on the computational efficiency of the decoding.

B.6.2 Decoding a source block

B.6.2.1 General

It is assumed that the decoder knows the structure of the source block it is to decode, including the symbol size, *T,* and the number *K* of symbols in the source block.

From the algorithms described in Sections B.5, the MSCR decoder can calculate the total number $L = K+S+H$ of pre-coding symbols and determine how they were generated from the source block to be decoded. In this description it is assumed that the received encoding symbols for the source block to be decoded are passed to the decoder. Furthermore, for each such encoding symbol it is assumed that the number and set of intermediate symbols whose exclusive-or is equal to the encoding symbol is passed to the decoder. In the case of source symbols, the source symbol triples described in Section B.5.2.2 indicate the number and set of intermediate symbols which sum to give each source symbol.

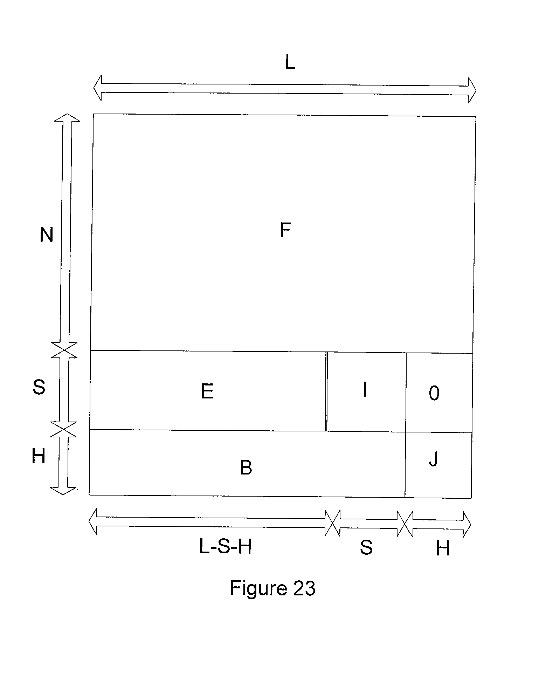

Let $N \geq K$ be the number of received encoding symbols for a source block and let $M = S+H+N$. The following *M* x *L* matrix **A** can be derived from the information passed to the decoder for the source block to be decoded. Let **C** be the column vector of the *L* intermediate symbols, and let **D** be the column vector of *M* symbols with values known to the receiver, where the last *S+H* of the *M* symbols are zero-valued symbols that correspond to LDPC and HDPC symbols (these are check symbols for the LDPC and HDPC symbols, and not the LDPC and HDPC symbols themselves), and the remaining *N* of the *M* symbols are the received encoding symbols for the source block. Then, **A** is the matrix that satisfies **A·C = D,** where here - denotes matrix multiplication over G(256). The matrix **A** has a block structure, as shown in Figure 23. The block structure comprises a matrix **F** with *N* rows and *L* columns, a matrix **E** with *S* rows and *L-S-H* columns, a *S* by *S* identity matrix **I**, a matrix **O** with *S* rows and *H* columns that are entirely zeros, a matrix **B** with *H* rows and *L-H* columns, and a *H* by *H* identity matrix **J**. The submatrix **B** has entries defined over the field GF(256), while the matrices **E** and **F** have 0/1 entries, i.e., entries in the field GF(2). The matrix **F** defines the dynamic coding process, the matrix **E** defines the LDPC coding process described above, and the matrix **B** defines the HDPC coding process. In particular, $\mathbf{F}[i,j] = 1$ if the intermediate symbol corresponding to index *j* is exclusive-ORed into the or encoding symbol corresponding to index *i* in the encoding. For all other *i* and *j*, $\mathbf{F}[i,j] = 0$. Similarly, $\mathbf{E}[i,j] = 1$ if the intermediate symbols corresponding to index *j* is exclusive-ORed into the LDPC symbol corresponding to index *i*. Finally, $\mathbf{B}[i,j] = \beta$ if the result of the action of $\beta$ on the intermediate symbols corresponding to index *j* is exclusive-ORed into the HDPC symbol corresponding to index *i*.

Decoding a source block is equivalent to decoding **C** from known **A** and **D**. It is clear that **C** can be decoded if and only if the rank of **A** over GF(256) is $L$. Once **C** has been decoded, missing source symbols can be obtained by using the source symbol triples to determine the number and set of intermediate symbols which are exclusive-ORed to obtain each missing source symbol.

The first step in decoding **C** is to form a decoding schedule. In this step **A** is converted, using Gaussian elimination (using row operations and row and column reorderings) and after discarding $M$ - $L$ rows, into the $L$ by $L$ identity matrix. The decoding schedule comprises the sequence of row operations and row and column re-orderings during the Gaussian elimination process, and only depends on **A** and not on **D**. The decoding of C from **D** can take place concurrently with the forming of the decoding schedule, or the decoding can take place afterwards based on the decoding schedule.

The correspondence between the decoding schedule and the decoding of C is as follows. Let $c[0] = 0$, $c[1] = 1...,c[L-1] = L$-1 and $d[0] = 0$, $d[1] = 1...,d[M-1] = M$-1 initially.

Each time row $i$ of **A** is exclusive-ORed into row $i'$ in the decoding schedule then in the decoding process symbol $D[d[i]]$ is exclusive-ORed into symbol $D[d[i']]$. We call this operation a GF(2)-row operation.

Each time a multiple $\alpha$ (for some $\alpha$ in GF(256)) of row $i$ of **A** is exclusive-ORed into row $i'$ in the decoding schedule, then in the decoding process symbol $\alpha * D[d[i]]$ is exclusive-ORed into symbol $D[d[i']]$. We call this operation a GF(256)-row operation. Note that a GF(2)-row operation is a particular case of a GF(256)-row operation in which the element $\alpha$ is 1.

Each time row $i$ is exchanged with *row $i'$* in the decoding schedule then in the decoding process the value of $d[i]$ is exchanged with the value of $d[i']$.

Each time column $j$ is exchanged with column $j'$ in the decoding schedule then in the decoding process the value of $c[j]$ is exchanged with the value of $c[j']$.

From this correspondence it is clear that the total number of exclusive-ORs of symbols in the decoding of the source block is related to the number of row operations (not exchanges) in the Gaussian elimination. Since **A** is the $L$ by $L$ identity matrix after the Gaussian elimination and after discarding the last $M$ - $L$ rows, it is clear at the end of successful decoding that the $L$ symbols $D[d[0]]$, $D[d[1]],..., D[d[L-1]]$ are the values of the $L$ symbols $C[c[0]]$, $C[c[1]],..., C[c[L-1]]$.

The order in which Gaussian elimination is performed to form the decoding schedule has no bearing on whether or not the decoding is successful. However, the speed of the decoding depends heavily on the order in which Gaussian elimination is performed. (Furthermore, maintaining a sparse representation of **A** is crucial, although this is not described here). It is also clear that it is more efficient to perform GF(2)-row operations rather than GF(256)-row operations. Therefore, when performing the Gaussian elimination, it is better to pivot on rows of the matrix **A** which with elements taken from the field GF(2). It is also advantageous to leave the elimination of the rows of the matrix corresponding to the HDPC symbols to the end of the Gaussian elimination process. The remainder of this section describes an order in which Gaussian elimination could be performed that is relatively efficient.

### B.6.2.2 First Phase

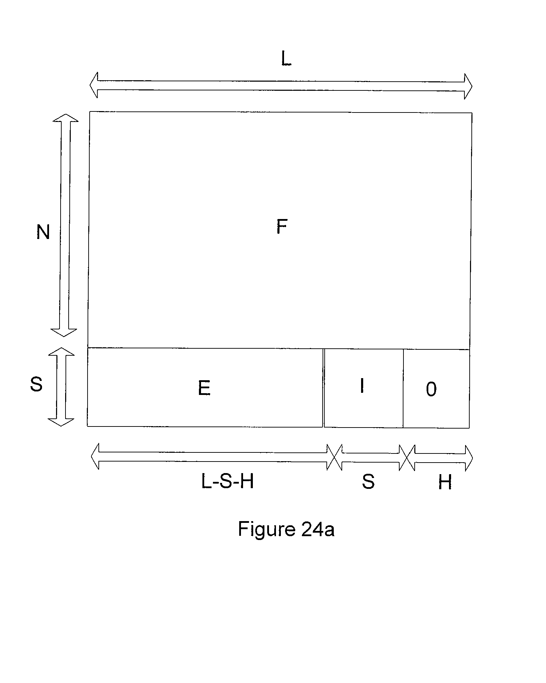

Referring to Figure 23, we denote by **X** the matrix comprising **F, E, I** and **0** as depicted in Figure 24a.

he first phase of the Gaussian elimination the matrix **X** is conceptually partitioned into submatrices. The submatrix sizes are parameterized by non-negative integers $i$ and $u$ which are initialized to 0. The submatrices of **X** are:

(1) The submatrix defined by the intersection of the first $i$ rows and first $i$ columns. This is the identity matrix at the end of each step in the phase.
(2) The submatrix defined by the intersection of the first $i$ rows and all but the first $i$ columns and last $u$ columns. All entries of this submatrix are zero.
(3) The submatrix defined by the intersection of the first $i$ columns and all but the first $i$ rows. All entries of this submatrix are zero.
(4) The submatrix **U** defined by the intersection of all the rows and the last $u$ columns.
(5) The submatrix **V** formed by the intersection of all but the first $i$ columns and the last $u$ columns and all but the first $i$ rows.

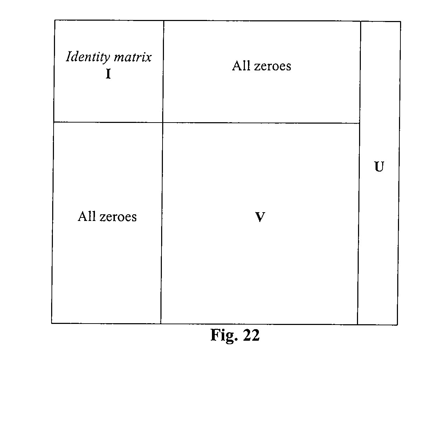

Fig. 22 illustrates the submatrices of **X**. At the beginning of the first phase **V** = **X**. In each step, a row **of X** is chosen. The following graph defined by the structure of **V** is used in determining which row of **X** is chosen. The columns that intersect **V** are the nodes in the graph, and the rows that have exactly 2 ones in **V** are the edges of the graph that connect the two columns (nodes) in the positions of the two ones. A component in this graph is a maximal set of nodes (columns) and edges (rows) such that there is a path between each pair of nodes/edges in the graph. The size of a component is the number of nodes (columns) in the component. The graph is denoted by $Y$ *in* the following.

There are at most $L$ steps in the first phase. The phase ends when **V** either disappears or becomes the zero matrix-. In each step, a row of **X** is chosen as follows:

If all entries of **V** are zero then no row is chosen and the first phase ends.

therwise, let $r$ be the minimum integer such that at least one row of **X** has exactly $r$ ones in **V**.

If $r = 1$, then choose the row with exactly one 1 in **V**.

If $r = 2$ then choose any row with exactly 2 ones in **V** that is part of a maximum size component in the graph defined by $Y$.

If $r > 2$ then choose a row with exactly $r$ ones in **V** with minimum original weight among all such rows.

After the row is chosen in this step the first row of **X** that intersects **V** is exchanged with the chosen row so that the chosen row is the first row that intersects **V**. The columns of **X** among those that intersect **V** are reordered so that one of the $r$ ones in the chosen row appears in the first column **of V** and so that the remaining $r$-1 ones appear in the last columns of **V**. Then, the chosen row is exclusive-ORed into all the other rows **of X** below the chosen row that have a one in the first column of **V**. In other words, we perform a GF(2)-row operation in this step. Finally, $i$ is incremented by 1 and $u$ is incremented by $r$-1, which completes the step.

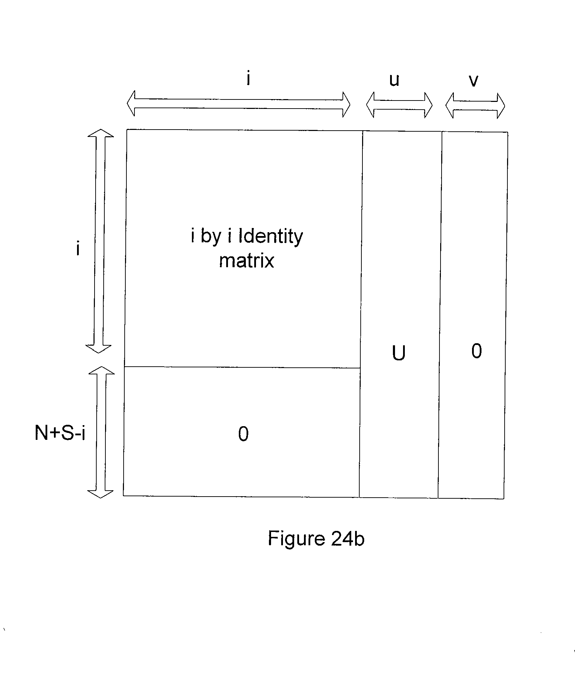

Let $v$ denote the number of columns of the matrix **V** at the end of this phase. After permuting the columns of the matrix **B** so that the columns of **V** correspond to the last $v$ columns of **X**, the matrix **X** will have the form given in Figure 24b.

B.6.2.3 Second Phase

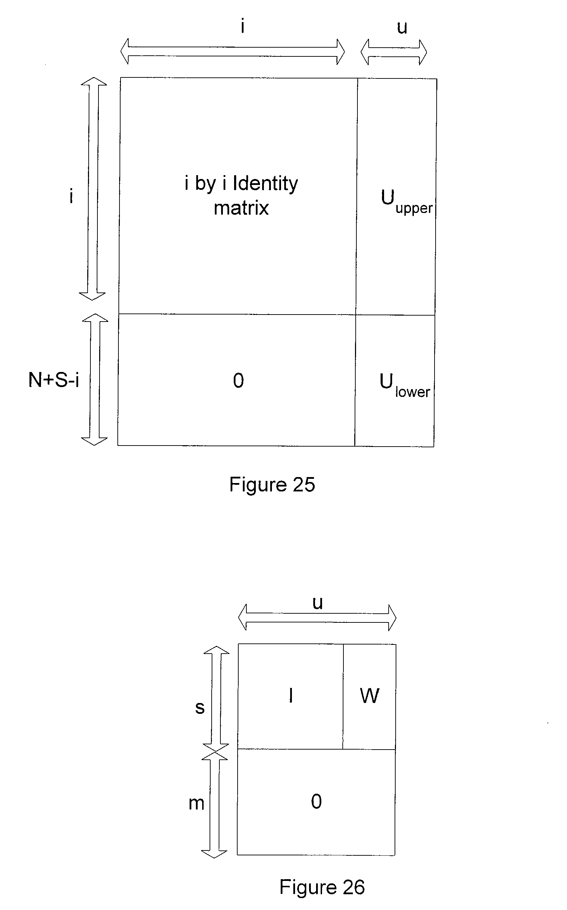

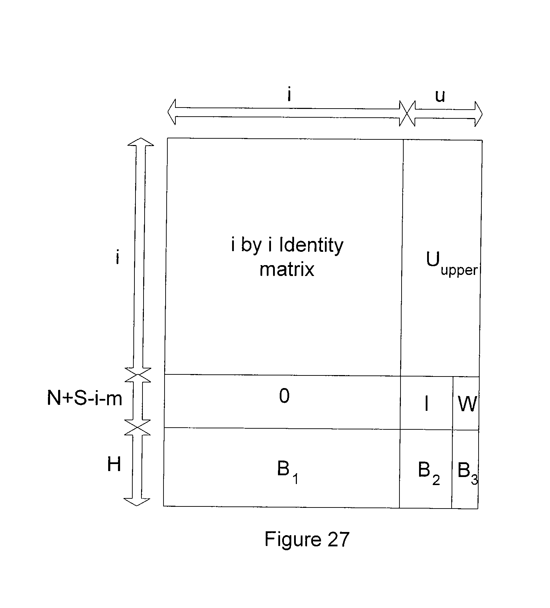

We modify the matrix **U** so it comprises additionally the last $v$ rows of the matrix **X**, and we replace $u$ accordingly by $u+v$. The submatrix **U** is further partitioned into the first $i$ rows, $\mathbf{U}_{upper}$, and the remaining $N+S-i$ rows, $\mathbf{U}_{lower}$, as depicted in Fig. 25. Gaussian elimination is performed in the second phase on $\mathbf{U}_{lower}$. After this step, the matrix $\mathbf{U}_{lower}$ will have the form given in Fig. 26, i.e., after a permutation of the rows and columns, the intersection of the first $s$ rows with the first $s$ columns is an identity matrix, called **I**, the last $m$ rows are zero, and the intersection of the first $s$ rows with the last $u-s$ columns forms the matrix **W**. Note that $s+m$ equals the number $N+S-i$ of rows of the matrix $\mathbf{U}_{lower}$. If the value of $s$ is $u$, then the next phase may be skipped. If the value of $m$ is larger than $H-v$, then a decoding error is returned, since the rank of the matrix **A** is less than $L$ in this case. The last $m$ rows of the matrix **X** are discarded, so that after this phase **A** has the form given in Fig. 27. In this figure, $\mathbf{B}_1, ..., \mathbf{B}_3$ are matrices with $H$ rows each and entries in GF(256). Next, GF(256)-row operations are performed on the matrices $\mathbf{B}_1$ and $\mathbf{B}_2$ to zero them out. This may be done in one of two ways. In a first method, the first $i$ rows of **A** are used to zero out the matrix $\mathbf{B}_1$ by means of GF(256)-row operations. The next $s$ rows of **A** are then used to zero out the matrix $\mathbf{B}_2$. In a second method, rows $i$ to $i+s-l$ inclusive are used to zero out the first s columns of $\mathbf{U}_{upper}$ by means of GF(2)-row operations and then the first $i+s$ rows of **X** are used to zero out both $\mathbf{B}_1$ and $\mathbf{B}_2$ by means of GF(256)-row operations. As is apparent to those of ordinary skill in the art, the method algorithm described above for construction of the HDPC symbols leads to a similar algorithm for zeroing out of the matrix $\mathbf{B}_1$ (in the first method) or both $\mathbf{B}_1$ and $\mathbf{B}_2$ (in the second method). This algorithm requires calculation of the action of a GF(256) element on a symbol only once per matrix column plus once per row of **H**. Thus, the second method described above results in overall fewer operations to zero out the matrices $\mathbf{B}_1$ and $\mathbf{B}_2$.

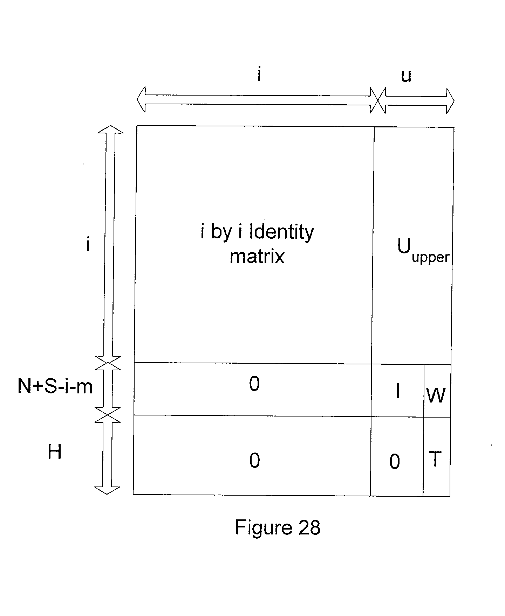

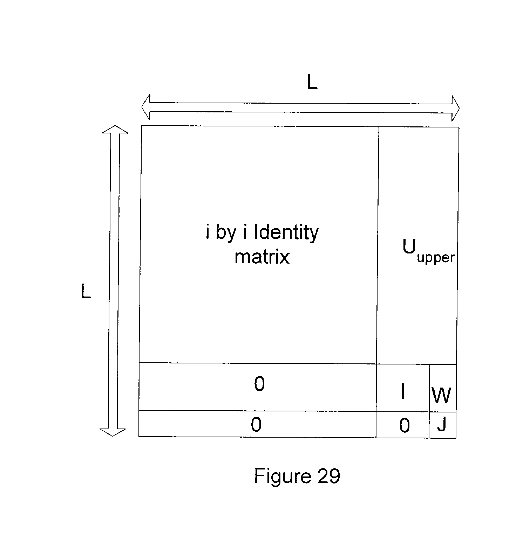

After this step, the matrix **A** has the form given in Fig. 28. The matrix **T** has $H$ rows and $u-s$ columns. Gaussian elimination is performed on the matrix **T** to transform it into an identity matrix, followed by $H-u+s$ rows. If this is not possible, i.e., if the rank **of T** is smaller than $u-s$, then a decoding error is flagged. At the end of this stage the matrix **A** has the form given in Fig. 29, after discarding the last $H-u+s$ rows. In this figure, **I** denotes a $s$ by $s$ identity matrix, and **J** denotes a $u-s$ by $u-s$ identity matrix.

B.6.2.4Third Phase

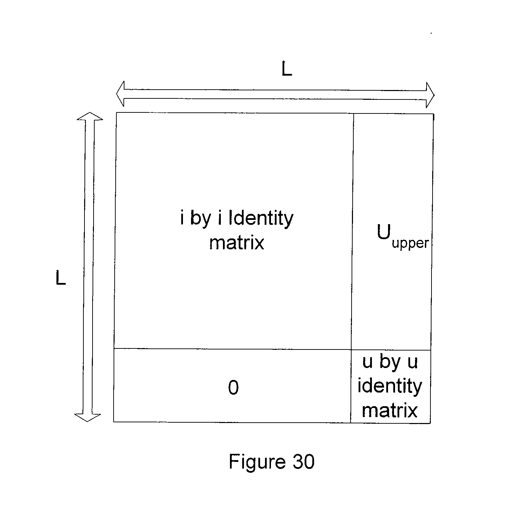

After the second phase the portions of **A** which need to be zeroed out to finish converting **A** into the $L$ by $L$ identity matrix are W and all $u$ columns of $\mathbf{U}_{upper}$, in the case that the first method of zeroing out $\mathbf{B}_1$ and $\mathbf{B}_2$ has been followed, or **W and** the last u-s columns of $\mathbf{U}_{upper}$, in the case that the second method of zeroing out $\mathbf{B}_1$ and $\mathbf{B}_2$ has been followed. In the former case, since the matrix **W** is generally of small size, it can be zeroed out using elementary GF(2)-row operations. After this step, the matrix **A** has the form given in Fig. 30. In both cases, the remaining portion of the matrix to be zeroed out is now rectangular. In the former case it is of size $i$ rows and $u$ columns, in the latter case it is of size $i+s$ rows and $u-s$ columns. In the following we shall use $i'$ for the number of rows in this matrix and $u'$ for the number of columns and denote the matrix by $\hat{\mathbf{U}}$.

The number of rows $i'$ of the remaining submatrix $\hat{\mathbf{U}}$ is generally much larger than the number of columns $u'$. There are several methods which may be used to zero out $\hat{\mathbf{U}}$ efficiently. In one method, the following precomputation matrix **U**' is computed based on, the last u rows and columns of **A**, which we denote $\mathbf{I}_u$ and then **U**' is used to zero out $\hat{\mathbf{U}}$. The $u$ rows of $\mathbf{I}_u$ are partitioned into ceil($u/z$) groups of $z$ rows each, for some integer z. Then, for each group of $z$ rows all non-zero combinations of the z rows are computed, resulting in $2^z - 1$ rows (this can be done with $2^z$-z-1 exclusive-ors of rows per group, since the combinations of Hamming weight one that appear in $\mathbf{I}_u$ do not need to be recomputed). Thus, the resulting precomputation matrix $\mathbf{U}$' has ceil($u/z$) $\cdot 2^z$- 1 rows and $u$ columns. Note that $\mathbf{U}$' is not formally a part of matrix $\mathbf{A}$, but will be used subsequently to zero out $\mathbf{U}_{upper}$. In a preferred embodiment, $z=8$.

For each of the $i$' rows of $\hat{\mathbf{U}}$, for each group of $z$ columns in the $\hat{\mathbf{U}}$ submatrix of this row, if the set of $z$ column entries in $\hat{\mathbf{U}}$ are not all zero then the row of the precomputation matrix $\mathbf{U}$' that matches the pattern in the $z$ columns is exclusive-ORed into the row, thus zeroing out those $z$ columns in the row at the cost of exclusive-oring one row of $\mathbf{U}$' into the row.

After this phase $\mathbf{A}$ is the $L$ by $L$ identity matrix and a complete decoding schedule has been successfully formed. Then, the corresponding decoding comprising exclusive-ORing known encoding symbols can be executed to recover the intermediate symbols based on the decoding schedule.

The triples associated with all source symbols are computed according to B.5.2.2. The triples for received source symbols are used in the decoding. The triples for missing source symbols are used to determine which intermediate symbols need to be exclusive-ORed to recover the missing source symbols.

## Multi-Field, Single-Stage Chain Reaction Encoders/Decoders

Multi-field, single-stage (MFSS) codes have useful properties that are disclosed or suggested herein. Novel arrangements for MFSS codes, encoders and decoders are described herein. In one embodiment, data is encoded for transmission from a source to a destination in which each output symbol is generated as a linear combination of one or more of the input symbols with coefficients taken from finite fields and, for each output symbol:

- selecting according to a random process an integer greater than zero, $d$, known as the degree of the output symbol,

- selecting according to a random process, a set of size $d$ of input symbols, this set of input symbols to be known as the neighbor set of the output symbol,

- selecting a set of finite fields, such that for at least one output symbol this set contains at least two finite fields,

- selecting for each input symbol in the neighbor set of the output symbol a finite field from the selected set of possible finite fields,

- selecting for each input symbols in the neighbor set of the output symbol, according to a random process, a non-zero element from the finite field selected above.

The random process for selecting the degrees of the output symbols may be a process described in Luby I and Luby II in which the degree is selected according to a degree distribution. The random process for selecting the input symbols to associate with each output symbol may be a process described in Luby I and Luby II in which the input symbols are selected randomly and uniformly. As used herein "random" may include "pseudorandom", "biased random" and the like.

The set of possible finite fields may be the set { GF(2), GF(256) }.

The process for selecting the finite field may be based on a parameter $d_l$, such that for output symbols of degree less than $d_l$, the field GF(2) is chosen for all input symbols in the neighbor set of the output symbol and for output symbols of degree $d_l$ or greater than the field GF(256) is chosen for at least one, some or all of the members of the neighbor set of the output symbol and the field GF(2) is chosen for the remaining elements of the neighbor set, if any.

The process for selecting the finite field element from the selected field may the simple random process in which an element is chosen uniformly at random from amongst the non-zero elements of the field.

A decoder receiving data encoded by an MFSS encoder as described above might decode the output symbols to regenerate the input symbols by forming a matrix representation of the code according to the method described above, this matrix including no static rows and one dynamic row for each output symbol of the code, and then applying Gaussian Elimination to find the inverse of this matrix, ensuring that at each stage of the Gaussian Elimination process pivot rows of minimal degree are chosen.

As will be clear to those of ordinary skill in the art, many of the well-known properties of the codes described in Luby I and Luby II are equally applicable to the codes described above and in particular the choice of an appropriate degree distribution can ensure that with high probability the Gaussian Elimination process is able to identify a row of remaining degree one and thus the decoding process operates as a chain reaction process as described in Luby I and Luby II.

This MFSS code has several further advantages over codes known in the art. Firstly, the inclusion of elements from the field GF(256) reduces significantly the probability that any given received output symbol is not information additive with respect to previously received output symbols. As a result, the decoding error probability of this code is much lower than previous codes. For example, in some instances, the failure probability of the codes described in Luby I and Luby II is improved upon.

An advantage of this code over other codes based on large fields is that output symbols of low degree will generally be processed first by the Gaussian Elimination process and as a result the inclusion of elements from GF(256) need not be considered until later in the decoding process. Since operations over GF(256) are relatively expensive compared to those over GF(2), this results in greatly reduced computational complexity compared to codes where many or all of the symbols are constructed using elements from GF(256) or other large finite fields.

A further advantage over other codes based on large fields is that for those output symbols generated using the larger field, only one element of the neighbor set has a coefficient which is taken from the larger field and as a result only one operation between a symbol and a finite field element is required for each such output symbol. This results in low overall computational complexity.

It is known that using inner codes and outer codes to encode input symbols using two (or more) coding procedures leads to a simple code scheme that provides benefits often found in more complex codes. With the use of inner codes and outer codes, source symbols are first encoded using one of the codes and the output of the first encoder is provided to a coder that codes according to the other code and that result is output as the output symbols. Using an MFSS is, of course, different from the use of inner/outer codes. For one, the output symbols are derived from neighbor sets of input codes. In many of the embodiments described herein, each output symbol is a linear combination of input symbols. With multi-stage codes, each output symbol might be a linear combination of input symbols and/or redundant and/or intermediate symbols.

Dense Multi-Field Codes and Encoders/Decoders for Such Codes

In a variation of the teachings described above, the matrix representation of the code is a dense matrix. As is well known, error correction codes can be constructed from dense random matrices over finite fields. For example, a generalized matrix may be constructed in which there are no static rows and each dynamic row comprises elements from $GF(2^q)$, with each element chosen randomly. A fixed rate code may then be constructed in which each output symbol corresponds to one of the dynamic rows and is generated as the linear combination of those input symbols for which there is a non-zero element in the corresponding column of this row of the matrix, using these elements as coefficients in the linear combination process.

It is well known to those of skill in the art that the probability that a randomly chosen matrix with $K$ rows and $K+A$ columns with coefficients that are independently and randomly chosen from $GF(2^q)$ has a rank that is smaller than $K$ is at most $2^{-qA}$. Therefore, the decoding error probability of a code with $K$ input and $K/R$ output symbols in which the output symbols are generated independently and randomly from the input symbols using randomly chosen coefficients from $GF(2^q)$ is at most $2^{-qA}$, if the number of encoded symbols received is $K+A$.

In the case of $q=1$, the code described above has the advantage of reasonable computational complexity, since all operations are within the field GF(2) and thus correspond to conventional XOR operations. However, in this case the lower bound on the failure probability of $2^{-A}$ once $A$ additional symbols have been received is much higher than desirable.

In the case of $q=8$, the code described above has the advantage of a lower failure probability (bounded by $2^{-8A}$ for $A$ additional symbols received). However, in this case all operations are within the field GF(256) and are thus relatively computationally expensive.

A further embodiment allows decoding error probabilities close to those achievable using large values of $q$ to be achieved with computational complexity close to that achievable with small values of $q$. In this embodiment, output symbols are generated as linear combinations of input symbols with coefficients taken from either $GF(2^p)$ or $GF(2^q)$ where $p < q$. In one specific embodiment, exactly $(K-2p/q)/R$ output symbols are generated using coefficients from $GF(2^p)$ and the remaining $2p/(qR)$ output symbols are generated using coefficients from $GF(2^q)$.

Data received at a destination can be decoded by determining the linear relationships between received output symbols and the input symbols of the code and solving this set of linear relationships to determine the input symbols.

The decoding error probability of this code is at most that of the code in which all coefficients are chosen from the field $GF(2^p)$ and may be significantly lower depending on the number of symbols generated using coefficients from the larger field $GF(2^q)$. However, since most of the output symbols are generated using coefficients from $GF(2^p)$, the computational complexity of encoding is only slightly greater than that of a code in which all symbols are generated using coefficients from $GF(2^p)$. Furthermore, the method of decoding may be so arranged that symbols generated with coefficients form $GF(2^p)$ are processed first and thus the majority of the decoding operations are performed with operations exclusively in $GF(2^p)$. As a result, the computational complexity of the decoding method is similarly close to that for codes constructed using only $GF(2^p)$. In a particular preferred embodiment, $p=1$ and $q=8$.

Some Properties of Some Multi-Field Codes

In most of the examples described above, the input and output symbols encode for the same number of bits and each output symbol is placed in one packet (a packet being a unit of transport that is either received in its entirety or lost in its entirety). In some embodiments, the communications system is modified so that each packet contains several output symbols. The size of an output symbol value is then set to a size determined by the size of the input symbol values in the initial splitting of the file or blocks of the stream into input symbols, based on a number of factors. The decoding process remains essentially unchanged, except that output symbols arrive in bunches as each packet is received.

The setting of input symbol and output symbol sizes is usually dictated by the size of the file or block of the stream and the communication system over which the output symbols are to be transmitted. For example, if a communication system groups bits of data into packets of a defined size or groups bits in other ways, the design of symbol sizes begins with the packet or grouping size. From there, a designer would determine how many output symbols will be carried in one packet or group and that determines the output symbol size. For simplicity, the designer would likely set the input symbol size equal to the output symbol size, but if the input data makes a different input symbol size more convenient, it can be used.

The above-described encoding process produces a stream of packets containing output symbols based on the original file or block of the stream. Each output symbol in the stream is generated independently of all other output symbols, and there is no lower or upper bound on the number of output symbols that can be created. A key is associated with each output symbol. That key, and some contents of the input file or block of the stream, determines the value of the output symbol. Consecutively generated output symbols need not have consecutive keys, and in some applications it would be preferable to randomly generate the sequence of keys, or pseudorandomly generate the sequence.

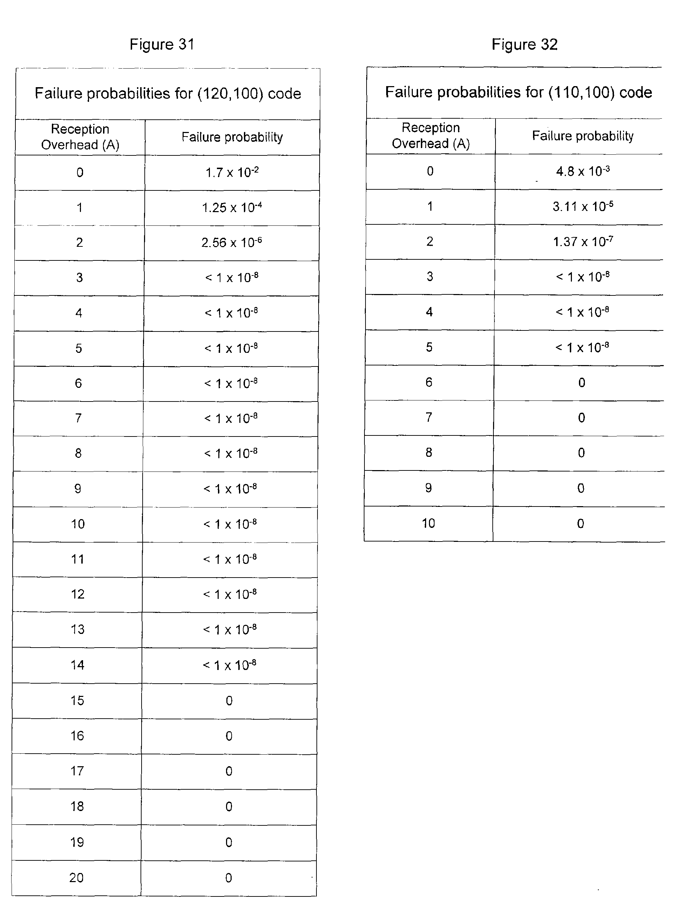

Multi-stage decoding has a property that a block of K equal-sized input symbols can be recovered from K+A output symbols on average, with very high probability, where A is small compared to K. For example, in the preferred embodiment first described above, when K = 100, Fig. 31 shows the probability of failing to decode from K+A output symbols chosen randomly from among the first 120 output symbols generated, and the table of Fig. 32 shows the probability of failing to decode from K+A output symbols chosen randomly from among the first 110 output symbols generated.

Since the particular output symbols are generated in a random or pseudorandom order, and the loss of particular output symbols in transit is generally unrelated to the values of the symbols, there is only a small variance in the actual number of output symbols needed to recover the input file or block. In many cases, where a particular collection of K+A output symbols are not enough to decode the a block, the block is still recoverable if the receiver can receive more output symbols from one or more sources.

Because the number of output symbols is only limited by the resolution of I, well more than K+A output symbols can be generated. For example, if I is a 32-bit number, 4 billion different output symbols could be generated, whereas the file or block of the stream could include K=50,000 input symbols. In some applications, only a small number of those 4 billion output symbols may be generated and transmitted and it is a near certainty that an input file or block of a stream can be recovered with a very small fraction of the possible output symbols and an excellent probability that the input file or block can be recovered with slightly more than K output symbols (assuming that the input symbol size is the same as the output symbol size).

In some applications, it may be acceptable to not be able to decode all of the input symbols, or to be able to decode all of input symbols, but with a relatively low probability. In such applications, a receiver can stop attempting to decode all of the input symbols after receiving K+A output symbols. Or, the receiver can stop receiving output symbols after receiving less than K+A output symbols. In some applications, the receiver may even only receive K or less output symbols. Thus, it is to be understood that in some embodiments of the present invention, the desired degree of accuracy need not be complete recovery of all the input symbols.

Further, in some applications where incomplete recovery is acceptable, the data can be encoded such that all of the input symbols cannot be recovered, or such that complete recovery of the input symbols would require reception of many more output symbols than the number of input symbols. Such an encoding would generally require less computational expense, and may thus be an acceptable way to decrease the computational expense of encoding.

It is to be understood that the various functional blocks in the above-described figures may be implemented by a combination of hardware and/or software, and that in specific implementations some or all of the functionality of some of the blocks may be combined. Similarly, it is also to be understood that the various methods described herein may be implemented by a combination of hardware and/or software.

The above description is illustrative and not restrictive. Many variations of the invention will become apparent to those of skill in the art upon review of this disclosure. The scope of the invention should, therefore, be determined not with reference to the above description, but instead should be determined with reference to the appended claims along with their full scope of equivalents.

APPENDIX A. VALUES FOR SYSTEMATIC INDICES *J(K)*

For each value of *K*, the systematic index *J*(*K*) is designed to have the property that the set of source symbol triples (*d*[0]*, a*[0]*, b*[0]), ..., (*d*[*L*-1], *a*[*L*-1], *b*[*L*-1]) are such that the *L* intermediate symbols are uniquely defined, i.e., the matrix A in Section B.5.2.4.2 has full rank and is therefore invertible. The following is a list of suitable systematic indices for values of K between 4 and 8192 inclusive and is provided by way of example. The order of the values is in reading order, i.e., from the first number on the first line through the last number on the first line, followed by the first number on the second line, and so on.

| | | | | | | | | | | |
|---|---|---|---|---|---|---|---|---|---|---|
| 22, | 1486, | 2151, | 2239, | 4286, | 3887, | 2016, | 3247, | 4531, | 490, | 2223, |
| 705, | 1243, | 2241, | 3457, | 3030, | 1918, | 2349, | 455, | 1745, | 182, | |
| 1130, | 29, | 381, | 1088, | 23, | 1147, | 353, | 951, | 161, | 56, | |
| 421, | 401, | 1141, | 557, | 75, | 611, | 409, | 828, | 1514, | 2722, | |
| 1044, | 718, | 768, | 1696, | 2145, | 2515, | 57, | 43, | 136, | 438, | |
| 815, | 540, | 88, | 270, | 364, | 236, | 158, | 14, | 49, | 160, | |
| 203, | 49, | 93, | 104, | 83, | 567, | 322, | 143, | 77, | 29, | |
| 70, | 37, | 333, | 120, | 5, | 5, | 5, | 408, | 183, | 356, | |
| 110, | 233, | 4, | 251, | 90, | 1170, | 322, | 245, | 664, | 1057, | |
| 95, | 512, | 184, | 1551, | 1477, | 778, | 1038, | 809, | 719, | 1025, | |
| 768, | 1127, | 689, | 76, | 1367, | 172, | 1313, | 1557, | 311, | 311, | |
| 559, | 1145, | 624, | 234, | 172, | 913, | 1555, | 1555, | 1134, | 692, | |
| 687, | 692, | 1501, | 692, | 1106, | 1040, | 195, | 25, | 1127, | 1234, | |
| 1404, | 1125, | 798, | 1511, | 75, | 947, | 671, | 1049, | 385, | 1273, | |
| 834, | 1116, | 1386, | 1386, | 399, | 84, | 1563, | 365, | 1563, | 611, | |
| 611, | 611, | 1020, | 819, | 1688, | 1688, | 1550, | 19, | 1600, | 1600, | |
| 796, | 19, | 1469, | 1571, | 1571, | 1117, | 1059, | 476, | 789, | 1117, | |
| 1207, | 1117, | 1163, | 1163, | 512, | 1719, | 1719, | 1719, | 1719, | 100, | |
| 623, | 623, | 623, | 1567, | 1567, | 623, | 876, | 876, | 876, | 876, | |
| 816, | 816, | 814, | 814, | 431, | 323, | 1, | 220, | 1286, | 1286, | |
| 623, | 1286, | 1286, | 1286, | 228, | 1642, | 1642, | 1642, | 259, | 1410, | |
| 259, | 259, | 259, | 353, | 122, | 826, | 522, | 826, | 485, | 1260, | |
| 1061, | 1061, | 1260, | 1260, | 1260, | 1678, | 353, | 870, | 870, | 870, | |
| 714, | 145, | 3, | 991, | 211, | 1644, | 1644, | 288, | 288, | 857, | |
| 1413, | 1413, | 1677, | 857, | 242, | 242, | 1565, | 1565, | 1677, | 1810, | |
| 714, | 714, | 714, | 714, | 714, | 1757, | 714, | 714, | 964, | 666, | |
| 964, | 964, | 1432, | 219, | 219, | 908, | 365, | 679, | 80, | 1286, | |
| 1432, | 1432, | 579, | 966, | 62, | 62, | 62, | 75, | 62, | 62, | |
| 62, | 1261, | 62, | 62, | 62, | 62, | 62, | 894, | 690, | 690, | |
| 456, | 538, | 538, | 1115, | 1999, | 1999, | 102, | 102, | 1137, | 1115, | |
| 102, | 579, | 579, | 783, | 783, | 96, | 1535, | 1073, | 1073, | 612, | |
| 612, | 1386, | 1197, | 690, | 690, | 690, | 690, | 690, | 690, | 690, | |
| 690, | 968, | 244, | 244, | 1812, | 244, | 968, | 160, | 656, | 160, | |
| 160, | 160, | 656, | 263, | 263, | 815, | 146, | 1099, | 1074, | 1099, | |
| 1099, | 1099, | 972, | 1876, | 222, | 1994, | 222, | 327, | 327, | 1400, | |
| 1441, | 1898, | 1292, | 1400, | 1066, | 1066, | 1755, | 54, | 54, | 54, | |
| 54, | 54, | 54, | 54, | 54, | 1791, | 1791, | 1781, | 554, | 1047, | |
| 1047, | 1047, | 1047, | 1047, | 1047, | 631, | 1219, | 289, | 289, | 1321, | |
| 1191, | 6, | 1781, | 184, | 184, | 6, | 2030, | 1704, | 1704, | 1704, | |
| 1704, | 1088, | 1088, | 1088, | 1088, | 1223, | 1223, | 2053, | 2053, | 8, | |
| 1704, | 2053, | 2053, | 8, | 1704, | 1969, | 770, | 1969, | 1969, | 1371, | |
| 1371, | 1353, | 1810, | 1810, | 1810, | 652, | 652, | 652, | 652, | 652, | |
| 652, | 652, | 652, | 652, | 423, | 652, | 1566, | 1566, | 1566, | 1566, | |
| 1566, | 1566, | 1566, | 1566, | 1617, | 965, | 965, | 965, | 1267, | 1267, | |

(continued)

| | | | | | | | | | |
|---|---|---|---|---|---|---|---|---|---|
| 1267, | 1267, | 1892, | 1699, | 1699, | 1267, | 981, | 1091, | 981, | 981, |
| 2053, | 2053, | 510, | 510, | 510, | 510, | 927, | 1843, | 1843, | 2203, |
| 234, | 234, | 865, | 1800, | 865, | 944, | 927, | 927, | 1693, | 1967, |
| 1379, | 1379, | 1379, | 1379, | 1379, | 843, | 1441, | 499, | 1441, | 160, |
| 601, | 1828, | 675, | 675, | 601, | 675, | 675, | 160, | 2338, | 203, |
| 1138, | 1138, | 1244, | 1244, | 1244, | 1244, | 346, | 323, | 850, | 850, |
| 870, | 870, | 927, | 927, | 927, | 408, | 677, | 677, | 677, | 677, |
| 1166, | 762, | 677, | 131, | 965, | 965, | 965, | 965, | 233, | 965, |
| 540, | 540, | 540, | 540, | 540, | 540, | 540, | 540, | 540, | 540, |
| 411, | 411, | 81, | 411, | 411, | 411, | 943, | 943, | 91, | 1067, |
| 943, | 1067, | 304, | 304, | 949, | 1046, | 916, | 751, | 751, | 1046, |
| 576, | 1193, | 576, | 576, | 1193, | 1208, | 375, | 1089, | 1089, | 375, |
| 945, | 945, | 540, | 540, | 540, | 540, | 540, | 540, | 540, | 540, |
| 540, | 540, | 81, | 41, | 571, | 571, | 571, | 723, | 723, | 723, |
| 723, | 723, | 723, | 723, | 589, | 589, | 403, | 403, | 403, | 1044, |
| 980, | 488, | 698, | 132, | 1187, | 1219, | 1219, | 1219, | 1219, | 1219, |
| 851, | 231, | 929, | 929, | 929, | 929, | 929, | 929, | 929, | 929, |
| 929, | 929, | 929, | 929, | 8, | 8, | 8, | 8, | 540, | 973, |
| 973, | 973, | 973, | 1, | 983, | 1144, | 1071, | 1071, | 37, | 37, |
| 37, | 173, | 173, | 173, | 173, | 665, | 173, | 173, | 918, | 918, |
| 1310, | 1297, | 1297, | 1297, | 699, | 662, | 547, | 882, | 1234, | 1234, |
| 29, | 29, | 1228, | 459, | 547, | 365, | 34, | 34, | 34, | 34, |
| 34, | 34, | 34, | 34, | 317, | 317, | 317, | 317, | 317, | 15, |
| 242, | 242, | 242, | 242, | 437, | 242, | 292, | 292, | 292, | 385, |
| 753, | 1061, | 1061, | 1061, | 1061, | 37, | 906, | 37, | 1191, | 1191, |
| 1012, | 1327, | 869, | 869, | 266, | 769, | 41, | 266, | 120, | 506, |
| 506, | 506, | 943, | 506, | 506, | 715, | 1155, | 142, | 142, | 142, |
| 375, | 375, | 375, | 375, | 375, | 375, | 375, | 375, | 375, | 375, |
| 690, | 375, | 375, | 375, | 548, | 939, | 94, | 94, | 94, | 939, |
| 939, | 939, | 939, | 94, | 1219, | 1219, | 1219, | 1219, | 1219, | 1219, |
| 1253, | 359, | 666, | 666, | 94, | 666, | 666, | 666, | 94, | 666, |
| 666, | 666, | 633, | 477, | 968, | 498, | 968, | 968, | 865, | 8, |
| 165, | 1219, | 1219, | 165, | 165, | 165, | 842, | 842, | 1219, | 1219, |
| 343, | 343, | 987, | 920, | 987, | 987, | 987, | 987, | 139, | 522, |
| 522, | 522, | 522, | 522, | 640, | 640, | 640, | 640, | 173, | 173, |
| 365, | 487, | 487, | 487, | 965, | 120, | 120, | 965, | 120, | 120, |
| 120, | 120, | 965, | 120, | 1269, | 1269, | 965, | 965, | 1187, | 1187, |
| 1187, | 1187, | 481, | 481, | 1209, | 663, | 823, | 823, | 1143, | 46, |
| 46, | 46, | 46, | 46, | 46, | 46, | 46, | 46, | 46, | 46, |
| 46, | 46, | 46, | 46, | 46, | 46, | 46, | 939, | 757, | 757, |
| 757, | 757, | 902, | 902, | 1446, | 902, | 351, | 1446, | 351, | 1446, |
| 1222, | 1222, | 716, | 1222, | 1222, | 1222, | 1222, | 833, | 833, | 833, |
| 912, | 912, | 912, | 912, | 94, | 912, | 915, | 808, | 1163, | 808, |
| 1421, | 443, | 443, | 443, | 443, | 443, | 443, | 432, | 905, | 366, |
| 366, | 366, | 366, | 408, | 408, | 408, | 408, | 408, | 408, | 1156, |
| 1156, | 145, | 1156, | 973, | 973, | 476, | 476, | 867, | 634, | 1077, |
| 1077, | 375, | 375, | 375, | 375, | 375, | 375, | 1371, | 1371, | 1371, |
| 1371, | 1371, | 1371, | 1371, | 1371, | 522, | 383, | 148, | 1267, | 522, |
| 522, | 1298, | 674, | 1298, | 939, | 674, | 674, | 674, | 674, | 1298, |
| 1298, | 1298, | 1298, | 197, | 197, | 197, | 197, | 120, | 918, | 918, |
| 918, | 918, | 918, | 47, | 47, | 1065, | 1308, | 1065, | 1065, | 1308, |

(continued)

| | | | | | | | | | |
|---|---|---|---|---|---|---|---|---|---|
| 1308, | 1308, | 1308, | 1308, | 1308, | 1415, | 1415, | 417, | 417, | 417, |
| 417, | 417, | 417, | 1206, | 613, | 537, | 1437, | 1437, | 476, | 476, |
| 476, | 476, | 1437, | 669, | 669, | 558, | 303, | 303, | 902, | 902, |
| 902, | 902, | 125, | 902, | 10, | 1501, | 1472, | 535, | 535, | 535, |
| 535, | 535, | 535, | 977, | 977, | 977, | 977, | 409, | 1309, | 1309, |
| 1309, | 1309, | 1309, | 1309, | 1309, | 1309, | 1309, | 1309, | 1309, | 1309, |
| 1309, | 796, | 796, | 796, | 716, | 617, | 694, | 973, | 973, | 973, |
| 973, | 1054, | 1054, | 1054, | 1054, | 662, | 662, | 447, | 447, | 447, |
| 447, | 447, | 447, | 634, | 634, | 634, | 634, | 634, | 634, | 634, |
| 37, | 1459, | 949, | 1459, | 1459, | 1459, | 1459, | 634, | 565, | 565, |
| 777, | 634, | 777, | 977, | 977, | 1057, | 1057, | 657, | 657, | 657, |
| 657, | 1057, | 1057, | 1057, | 657, | 657, | 657, | 657, | 657, | 657, |
| 657, | 657, | 657, | 657, | 657, | 1437, | 1500, | 263, | 263, | 263, |
| 70, | 570, | 570, | 70, | 70, | 70, | 70, | 1497, | 1497, | 1497, |
| 1497, | 883, | 364, | 883, | 883, | 1128, | 1390, | 1390, | 1390, | 1390, |
| 1032, | 1032, | 1032, | 1338, | 1338, | 1338, | 1338, | 1338, | 1338, | 1166, |
| 1166, | 1166, | 1166, | 1166, | 1166, | 983, | 983, | 983, | 983, | 71, |
| 983, | 983, | 983, | 1137, | 1137, | 1137, | 1137, | 1137, | 1137, | 1137, |
| 1137, | 1137, | 1137, | 1137, | 871, | 571, | 571, | 571, | 571, | 918, |
| 571, | 918, | 571, | 571, | 571, | 118, | 118, | 118, | 118, | 118, |
| 118, | 809, | 809, | 1437, | 1437, | 1437, | 1437, | 1437, | 1437, | 537, |
| 206, | 206, | 206, | 206, | 537, | 537, | 537, | 537, | 206, | 537, |
| 537, | 498, | 120, | 498, | 120, | 566, | 566, | 1219, | 566, | 1219, |
| 566, | 566, | 1219, | 1219, | 1219, | 1219, | 1219, | 1219, | 1219, | 1219, |
| 1219, | 1219, | 1219, | 95, | 550, | 1367, | 1367, | 1367, | 1367, | 1705, |
| 1230, | 1230, | 1407, | 1230, | 1230, | 363, | 363, | 1539, | 1539, | 1539, |
| 1539, | 1539, | 1539, | 1380, | 1380, | 1380, | 1380, | 1152, | 1455, | 1345, |
| 1345, | 366, | 366, | 1308, | 1308, | 1308, | 1308, | 1308, | 1308, | 1308, |
| 1308, | 1219, | 1219, | 1219, | 1219, | 871, | 871, | 581, | 581, | 581, |
| 581, | 581, | 581, | 1, | 1, | 121, | 1, | 1, | 1, | 121, |
| 1249, | 1, | 1249, | 1249, | 441, | 1249, | 1249, | 1249, | 1249, | 1249, |
| 1495, | 1653, | 1249, | 1249, | 1249, | 615, | 1064, | 1249, | 615, | 615, |
| 1249, | 615, | 221, | 615, | 615, | 615, | 98, | 723, | 723, | 723, |
| 723, | 723, | 723, | 1533, | 1533, | 106, | 106, | 106, | 106, | 1232, |
| 1232, | 1864, | 1232, | 1232, | 1232, | 1864, | 912, | 918, | 273, | 273, |
| 273, | 273, | 273, | 918, | 273, | 273, | 273, | 273, | 273, | 273, |
| 273, | 273, | 273, | 273, | 273, | 1348, | 1348, | 1348, | 1348, | 1348, |
| 1466, | 1348, | 1466, | 1466, | 160, | 1460, | 1460, | 1460, | 1460, | 1460, |
| 1792, | 1792, | 473, | 473, | 473, | 1460, | 473, | 1792, | 1792, | 1009, |
| 1009, | 1009, | 1009, | 106, | 106, | 1434, | 902, | 1434, | 1434, | 1387, |
| 1387, | 1387, | 1387, | 1387, | 1387, | 1042, | 1512, | 1512, | 1512, | 1512, |
| 1047, | 1512, | 1512, | 1588, | 1588, | 1550, | 662, | 927, | 628, | 103, |
| 222, | 103, | 103, | 1313, | 980, | 980, | 662, | 980, | 980, | 980, |
| 980, | 980, | 980, | 632, | 1107, | 1048, | 632, | 1107, | 1107, | 1620, |
| 632, | 1067, | 1620, | 963, | 963, | 94, | 94, | 94, | 514, | 1725, |
| 1257, | 1676, | 1676, | 1676, | 1676, | 1437, | 1437, | 1417, | 1417, | 681, |
| 1437, | 1064, | 1064, | 1117, | 1117, | 1064, | 1064, | 1117, | 1117, | 1117, |
| 1064, | 1117, | 1117, | 453, | 677, | 871, | 871, | 871, | 871, | 871, |
| 871, | 871, | 313, | 313, | 677, | 1259, | 1259, | 118, | 1259, | 1259, |
| 1707, | 441, | 441, | 1766, | 1766, | 1766, | 1766, | 1766, | 1766, | 1766, |
| 1766, | 1766, | 1766, | 1766, | 1766, | 1767, | 1767, | 1767, | 935, | 1767, |

(continued)

| | | | | | | | | | |
|---|---|---|---|---|---|---|---|---|---|
| 935, | 549, | 549, | 549, | 159, | 873, | 1868, | 1868, | 1868, | 1598, |
| 1868, | 1140, | 1587, | 1587, | 1587, | 1587, | 1587, | 1140, | 1140, | 1457, |
| 1457, | 1457, | 1457, | 1937, | 1253, | 1937, | 1937, | 1253, | 1937, | 1195, |
| 1937, | 986, | 986, | 1821, | 1821, | 1797, | 41, | 1439, | 1011, | 1011, |
| 1011, | 1011, | 1011, | 1011, | 1011, | 1439, | 1439, | 1381, | 1381, | 1381, |
| 1381, | 1200, | 1200, | 1200, | 1200, | 1200, | 1200, | 858, | 858, | 1077, |
| 1669, | 1669, | 1669, | 108, | 108, | 968, | 690, | 108, | 968, | 973, |
| 343, | 1313, | 1313, | 1313, | 1313, | 1313, | 1313, | 949, | 949, | 949, |
| 949, | 949, | 949, | 716, | 949, | 716, | 716, | 1581, | 1431, | 1431, |
| 1431, | 1431, | 1431, | 1431, | 1431, | 1581, | 1581, | 1431, | 1431, | 1581, |
| 1581, | 664, | 1581, | 845, | 396, | 664, | 664, | 650, | 650, | 650, |
| 814, | 814, | 1973, | 461, | 461, | 461, | 492, | 1997, | 306, | 1114, |
| 865, | 865, | 1820, | 865, | 865, | 865, | 1104, | 952, | 952, | 1104, |
| 1104, | 1257, | 1306, | 1306, | 968, | 952, | 952, | 175, | 175, | 175, |
| 175, | 1066, | 1632, | 452, | 902, | 902, | 902, | 902, | 1067, | 243, |
| 243, | 1067, | 243, | 1360, | 408, | 408, | 408, | 498, | 498, | 4, |
| 498, | 498, | 498, | 498, | 498, | 1218, | 1218, | 1165, | 6, | 6, |
| 1165, | 6, | 1381, | 1165, | 1165, | 1165, | 1725, | 1725, | 164, | 1725, |
| 1725, | 1725, | 54, | 1725, | 716, | 716, | 1114, | 1114, | 1114, | 1114, |
| 1067, | 1426, | 1426, | 1426, | 1426, | 1426, | 2162, | 2162, | 2162, | 2162, |
| 2162, | 2162, | 243, | 243, | 243, | 243, | 1095, | 243, | 1095, | 243, |
| 243, | 243, | 243, | 243, | 243, | 1982, | 243, | 243, | 243, | 243, |
| 347, | 347, | 347, | 347, | 347, | 347, | 1823, | 1069, | 1823, | 1069, |
| 1671, | 1745, | 2179, | 376, | 623, | 2179, | 376, | 376, | 2179, | 376, |
| 2179, | 2179, | 2179, | 376, | 756, | 571, | 2159, | 2159, | 1125, | 2159, |
| 1125, | 1125, | 2159, | 2159, | 1322, | 180, | 977, | 180, | 180, | 977, |
| 180, | 977, | 180, | 565, | 180, | 977, | 2124, | 857, | 2124, | 857, |
| 2124, | 2124, | 857, | 2124, | 842, | 842, | 842, | 842, | 842, | 842, |
| 62, | 62, | 1390, | 62, | 1390, | 1420, | 62, | 62, | 62, | 62, |
| 1055, | 1055, | 1055, | 1055, | 1055, | 1055, | 175, | 1055, | 1055, | 1055, |
| 1055, | 1055, | 175, | 1055, | 918, | 918, | 718, | 233, | 233, | 718, |
| 1263, | 1263, | 1263, | 1263, | 757, | 2048, | 70, | 1723, | 1723, | 1723, |
| 2154, | 2154, | 1532, | 233, | 1532, | 1532, | 1532, | 1532, | 1532, | 1532, |
| 1532, | 1532, | 888, | 888, | 888, | 888, | 888, | 888, | 689, | 689, |
| 1546, | 1546, | 1546, | 1546, | 1546, | 1546, | 1896, | 1896, | 662, | 662, |
| 450, | 264, | 1430, | 1430, | 1430, | 1430, | 1430, | 1430, | 1430, | 1430, |
| 1430, | 1430, | 1430, | 1430, | 1430, | 30, | 30, | 1710, | 1710, | 1710, |
| 2234, | 2101, | 498, | 432, | 498, | 498, | 1677, | 947, | 947, | 1677, |
| 1677, | 498, | 947, | 498, | 1283, | 498, | 1677, | 498, | 530, | 533, |
| 960, | 960, | 960, | 960, | 960, | 960, | 1099, | 960, | 960, | 1215, |
| 475, | 960, | 960, | 960, | 1215, | 960, | 960, | 960, | 960, | 960, |
| 960, | 960, | 1553, | 1309, | 1553, | 1553, | 1309, | 1309, | 94, | 1647, |
| 94, | 94, | 94, | 94, | 94, | 1647, | 935, | 935, | 140, | 508, |
| 508, | 1511, | 95, | 95, | 95, | 95, | 1306, | 1169, | 1431, | 1431, |
| 1431, | 1431, | 1176, | 1176, | 1176, | 1176, | 1176, | 1176, | 1176, | 1416, |
| 1839, | 1839, | 1839, | 1839, | 2324, | 1839, | 2425, | 1744, | 723, | 2506, |
| 2506, | 2506, | 2506, | 2506, | 2506, | 2506, | 1823, | 1823, | 1079, | 130, |
| 1838, | 1838, | 508, | 1838, | 1838, | 1838, | 1838, | 1838, | 424, | 424, |
| 424, | 424, | 424, | 424, | 424, | 424, | 424, | 424, | 424, | 582, |
| 582, | 1867, | 582, | 582, | 582, | 582, | 2326, | 1091, | 1091, | 1091, |
| 1091, | 1091, | 1462, | 1462, | 1462, | 1462, | 1462, | 1462, | 850, | 1462, |

(continued)

| | | | | | | | | | |
|---|---|---|---|---|---|---|---|---|---|
| 850, | 850, | 850, | 1413, | 2374, | 2374, | 740, | 740, | 740, | 740, |
| 572, | 572, | 1084, | 415, | 2426, | 2426, | 1134, | 2426, | 2426, | 2426, |
| 2426, | 2426, | 270, | 270, | 270, | 270, | 270, | 270, | 270, | 270, |
| 270, | 270, | 270, | 270, | 1165, | 1165, | 975, | 32, | 975, | 975, |
| 32, | 975, | 975, | 975, | 975, | 975, | 975, | 975, | 975, | 975, |
| 975, | 975, | 157, | 1066, | 160, | 669, | 160, | 160, | 160, | 160, |
| 461, | 834, | 834, | 834, | 292, | 36, | 156, | 27, | 27, | 27, |
| 27, | 27, | 27, | 27, | 27, | 27, | 645, | 690, | 690, | 1237, |
| 690, | 1106, | 1106, | 690, | 949, | 550, | 949, | 550, | 949, | 550, |
| 949, | 949, | 949, | 949, | 949, | 949, | 949, | 949, | 949, | 949, |
| 949, | 949, | 273, | 273, | 273, | 273, | 273, | 273, | 273, | 273, |
| 273, | 273, | 273, | 273, | 273, | 273, | 273, | 273, | 273, | 273, |
| 273, | 273, | 273, | 273, | 353, | 353, | 306, | 306, | 306, | 396, |
| 355, | 355, | 355, | 192, | 355, | 355, | 918, | 918, | 918, | 918, |
| 918, | 918, | 918, | 918, | 970, | 970, | 970, | 970, | 970, | 970, |
| 970, | 490, | 970, | 970, | 490, | 490, | 970, | 490, | 490, | 490, |
| 807, | 273, | 374, | 118, | 374, | 374, | 1237, | 675, | 1237, | 675, |
| 1144, | 1144, | 1144, | 675, | 273, | 273, | 1251, | 1251, | 1251, | 1251, |
| 1251, | 1251, | 1251, | 1251, | 1251, | 1251, | 1251, | 1251, | 1251, | 1251, |
| 11, | 11, | 1157, | 1157, | 1157, | 1157, | 784, | 784, | 784, | 784, |
| 784, | 951, | 1259, | 951, | 1012, | 1012, | 1012, | 1012, | 808, | 1012, |
| 812, | 812, | 812, | 812, | 812, | 812, | 1206, | 1206, | 1206, | 1206, |
| 734, | 482, | 482, | 482, | 1043, | 1313, | 166, | 166, | 166, | 166, |
| 675, | 166, | 166, | 675, | 166, | 675, | 675, | 675, | 675, | 675, |
| 675, | 675, | 675, | 166, | 675, | 675, | 166, | 166, | 968, | 968, |
| 968, | 968, | 968, | 968, | 1311, | 1311, | 538, | 538, | 538, | 538, |
| 538, | 538, | 582, | 582, | 582, | 582, | 347, | 347, | 347, | 347, |
| 347, | 347, | 21, | 21, | 21, | 21, | 21, | 21, | 21, | 21, |
| 21, | 21, | 21, | 645, | 645, | 21, | 29, | 29, | 1312, | 1312, |
| 1380, | 1380, | 1411, | 1120, | 1411, | 1411, | 306, | 306, | 806, | 806, |
| 669, | 669, | 669, | 681, | 1253, | 1253, | 876, | 876, | 1036, | 1036, |
| 1036, | 1036, | 1036, | 1036, | 233, | 233, | 233, | 233, | 233, | 233, |
| 233, | 233, | 233, | 233, | 233, | 233, | 271, | 271, | 271, | 271, |
| 271, | 271, | 871, | 871, | 871, | 871, | 871, | 871, | 1268, | 1268, |
| 1268, | 1268, | 1268, | 1268, | 1268, | 1268, | 1268, | 1268, | 1268, | 1268, |
| 1268, | 1268, | 1194, | 1125, | 1125, | 1125, | 353, | 353, | 353, | 353, |
| 353, | 353, | 865, | 865, | 913, | 865, | 865, | 913, | 865, | 865, |
| 865, | 913, | 913, | 913, | 409, | 409, | 409, | 409, | 409, | 409, |
| 409, | 409, | 954, | 954, | 954, | 954, | 954, | 954, | 159, | 159, |
| 159, | 159, | 585, | 585, | 585, | 585, | 585, | 585, | 585, | 585, |
| 585, | 585, | 585, | 585, | 585, | 585, | 585, | 585, | 585, | 585, |
| 585, | 585, | 585, | 585, | 585, | 585, | 585, | 103, | 529, | 529, |
| 529, | 529, | 529, | 529, | 529, | 529, | 529, | 529, | 529, | 529, |
| 529, | 529, | 529, | 529, | 529, | 529, | 871, | 694, | 310, | 871, |
| 871, | 310, | 310, | 310, | 310, | 1526, | 1194, | 1194, | 1194, | 1194, |
| 698, | 1194, | 1194, | 1194, | 770, | 770, | 770, | 1103, | 1367, | 1367, |
| 1367, | 361, | 1367, | 1367, | 850, | 850, | 1420, | 1420, | 1420, | 1420, |
| 1420, | 1420, | 353, | 353, | 353, | 353, | 353, | 353, | 514, | 514, |
| 514, | 353, | 353, | 353, | 353, | 723, | 514, | 11, | 723, | 514, |
| 11, | 11, | 723, | 723, | 538, | 538, | 538, | 538, | 538, | 538, |
| 538, | 538, | 538, | 538, | 538, | 538, | 1379, | 1379, | 1523, | 850, |

(continued)

| | | | | | | | | | |
|---|---|---|---|---|---|---|---|---|---|
| 850, | 850, | 321, | 850, | 850, | 850, | 850, | 1523, | 1523, | 1523, |
| 1523, | 1523, | 1523, | 1523, | 1444, | 1550, | 1550, | 1550, | 70, | 690, |
| 690, | 690, | 415, | 415, | 415, | 415, | 415, | 518, | 725, | 725, |
| 415, | 415, | 415, | 415, | 1036, | 353, | 1036, | 353, | 353, | 353, |
| 1012, | 1036, | 353, | 1036, | 353, | 353, | 1671, | 1671, | 935, | 935, |
| 935, | 935, | 159, | 935, | 935, | 935, | 935, | 935, | 832, | 832, |
| 1283, | 1283, | 1283, | 1283, | 121, | 121, | 121, | 121, | 121, | 121, |
| 121, | 121, | 756, | 756, | 1380, | 756, | 756, | 756, | 1413, | 1413, |
| 1413, | 1413, | 1413, | 1413, | 308, | 308, | 481, | 1219, | 662, | 662, |
| 1512, | 1512, | 1512, | 986, | 21, | 21, | 1144, | 1144, | 21, | 21, |
| 920, | 585, | 585, | 920, | 920, | 920, | 920, | 920, | 871, | 871, |
| 871, | 871, | 582, | 1333, | 353, | 353, | 353, | 353, | 353, | 353, |
| 1244, | 1244, | 1244, | 1244, | 1244, | 1244, | 1244, | 1244, | 1244, | 1244, |
| 316, | 316, | 918, | 918, | 918, | 918, | 918, | 918, | 918, | 918, |
| 918, | 1032, | 1508, | 671, | 671, | 671, | 671, | 819, | 1437, | 1437, |
| 55, | 960, | 960, | 960, | 970, | 481, | 481, | 1114, | 1114, | 1114, |
| 1114, | 481, | 1114, | 481, | 1556, | 1114, | 1556, | 1556, | 627, | 627, |
| 627, | 627, | 627, | 627, | 627, | 627, | 627, | 627, | 871, | 871, |
| 871, | 871, | 871, | 871, | 871, | 871, | 871, | 871, | 871, | 871, |
| 1160, | 1160, | 1448, | 361, | 361, | 396, | 396, | 361, | 994, | 994, |
| 994, | 994, | 717, | 717, | 663, | 663, | 1016, | 663, | 663, | 663, |
| 663, | 496, | 663, | 663, | 663, | 663, | 161, | 161, | 230, | 230, |
| 230, | 1348, | 230, | 230, | 1149, | 230, | 230, | 1348, | 1348, | 1348, |
| 1348, | 1348, | 1197, | 1197, | 1197, | 1197, | 1429, | 1429, | 1429, | 1429, |
| 36, | 36, | 1707, | 1707, | 1707, | 1707, | 1707, | 1707, | 1707, | 1707, |
| 1586, | 1586, | 1174, | 1174, | 1174, | 1586, | 681, | 1707, | 681, | 681, |
| 1314, | 1314, | 1314, | 1314, | 1512, | 1314, | 1314, | 1512, | 1314, | 31, |
| 1512, | 1314, | 1314, | 1512, | 1314, | 1314, | 1314, | 1314, | 1434, | 1434, |
| 1434, | 1434, | 1434, | 1434, | 1434, | 1434, | 353, | 1592, | 1592, | 1592, |
| 1592, | 1592, | 30, | 62, | 62, | 62, | 62, | 62, | 1485, | 1485, |
| 1485, | 740, | 807, | 1485, | 963, | 963, | 963, | 963, | 832, | 832, |
| 963, | 963, | 1444, | 1591, | 1444, | 1444, | 1444, | 1444, | 1444, | 1591, |
| 1591, | 1591, | 842, | 1586, | 842, | 842, | 1586, | 842, | 842, | 1586, |
| 1586, | 1776, | 1586, | 1586, | 968, | 968, | 968, | 968, | 968, | 968, |
| 968, | 968, | 968, | 968, | 968, | 968, | 968, | 968, | 992, | 1362, |
| 992, | 992, | 983, | 983, | 983, | 983, | 983, | 983, | 1521, | 1521, |
| 1521, | 1521, | 1521, | 1165, | 1158, | 1158, | 91, | 91, | 91, | 91, |
| 91, | 91, | 91, | 820, | 91, | 91, | 1069, | 1069, | 1069, | 1069, |
| 91, | 91, | 91, | 91, | 91, | 91, | 91, | 91, | 91, | 91, |
| 91, | 91, | 91, | 91, | 1825, | 1825, | 1432, | 1432, | 1432, | 1432, |
| 1432, | 1432, | 1432, | 1432, | 1432, | 1432, | 30, | 30, | 30, | 30, |
| 30, | 30, | 30, | 30, | 1675, | 1508, | 1675, | 1508, | 1620, | 1620, |
| 1620, | 1620, | 1620, | 1620, | 1620, | 1620, | 1620, | 1620, | 1620, | 1620, |
| 1620, | 1620, | 1221, | 1620, | 1221, | 935, | 334, | 334, | 334, | 231, |
| 334, | 334, | 952, | 952, | 952, | 952, | 554, | 952, | 1164, | 952, |
| 952, | 952, | 1338, | 952, | 1832, | 1832, | 1832, | 1832, | 1832, | 1832, |
| 355, | 355, | 355, | 355, | 355, | 355, | 355, | 355, | 355, | 355, |
| 355, | 355, | 1741, | 383, | 1741, | 1741, | 1748, | 1748, | 1748, | 1748, |
| 1748, | 1748, | 550, | 550, | 550, | 550, | 550, | 550, | 550, | 550, |
| 550, | 550, | 550, | 1669, | 1669, | 1669, | 1669, | 1669, | 550, | 1669, |
| 1669, | 550, | 1588, | 1588, | 1588, | 1588, | 1588, | 1588, | 1588, | 1588, |

(continued)

| | | | | | | | | | |
|---|---|---|---|---|---|---|---|---|---|
| 1588, | 1588, | 1669, | 1669, | 368, | 368, | 368, | 368, | 1313, | 1313, |
| 368, | 1313, | 1313, | 1313, | 1313, | 1313, | 1221, | 1221, | 1221, | 1221, |
| 1221, | 1221, | 1221, | 1221, | 1221, | 1221, | 1221, | 1221, | 1221, | 1221, |
| 1221, | 1221, | 1221, | 1221, | 1221, | 1221, | 1221, | 1221, | 1221, | 1221, |
| 1221, | 1221, | 1671, | 1671, | 1671, | 1671, | 832, | 832, | 963, | 963, |
| 963, | 963, | 1822, | 963, | 1381, | 963, | 522, | 963, | 963, | 522, |
| 6, | 6, | 6, | 6, | 6, | 6, | 1009, | 1009, | 1009, | 1009, |
| 1839, | 1839, | 1839, | 1707, | 1839, | 1839, | 1707, | 1839, | 1839, | 1707, |
| 1839, | 1707, | 1827, | 1916, | 1089, | 1457, | 1827, | 1089, | 64, | 64, |
| 64, | 64, | 64, | 64, | 64, | 64, | 22, | 22, | 22, | 22, |
| 740, | 1087, | 740, | 740, | 35, | 35, | 740, | 740, | 1221, | 1221, |
| 1706, | 1706, | 1706, | 1221, | 1011, | 1706, | 1706, | 1011, | 1706, | 1011, |
| 1706, | 1706, | 1706, | 1706, | 1706, | 1706, | 1706, | 1011, | 1011, | 1403, |
| 265, | 265, | 121, | 1099, | 121, | 1099, | 582, | 2018, | 1972, | 1373, |
| 1373, | 1972, | 415, | 415, | 1256, | 1256, | 1256, | 1936, | 1936, | 1256, |
| 1797, | 1797, | 1797, | 740, | 740, | 935, | 935, | 1797, | 935, | 1797, |
| 935, | 935, | 1797, | 1797, | 1797, | 1797, | 1797, | 1797, | 1797, | 1797, |
| 6, | 1797, | 1797, | 1797, | 1797, | 1797, | 1797, | 1797, | 1795, | 1795, |
| 1727, | 1727, | 1727, | 1727, | 1727, | 582, | 375, | 375, | 375, | 375, |
| 1176, | 67, | 81, | 1915, | 81, | 81, | 81, | 81, | 740, | 740, |
| 740, | 740, | 1564, | 1564, | 1564, | 1564, | 158, | 158, | 136, | 136, |
| 136, | 136, | 1598, | 1598, | 1598, | 1598, | 1875, | 1505, | 1598, | 1875, |
| 1773, | 1773, | 1773, | 175, | 461, | 780, | 1952, | 1952, | 312, | 312, |
| 1219, | 1219, | 1219, | 312, | 312, | 1952, | 1947, | 1727, | 492, | 30, |
| 492, | 492, | 492, | 492, | 492, | 388, | 492, | 492, | 388, | 388, |
| 388, | 388, | 492, | 492, | 1382, | 1382, | 424, | 424, | 424, | 424, |
| 424, | 424, | 424, | 424, | 1592, | 554, | 424, | 1592, | 424, | 424, |
| 1592, | 1592, | 516, | 516, | 516, | 516, | 516, | 516, | 625, | 625, |
| 625, | 625, | 625, | 625, | 625, | 625, | 625, | 625, | 625, | 625, |
| 625, | 625, | 625, | 625, | 625, | 625, | 625, | 625, | 1809, | 183, |
| 1809, | 183, | 183, | 183, | 1809, | 1562, | 1562, | 1562, | 1562, | 1562, |
| 1562, | 1562, | 1562, | 1779, | 1779, | 1779, | 1779, | 1779, | 1779, | 1779, |
| 1779, | 1158, | 1158, | 1158, | 1158, | 1592, | 1592, | 63, | 63, | 63, |
| 63, | 1448, | 1448, | 538, | 751, | 538, | 538, | 751, | 751, | 538, |
| 538, | 538, | 751, | 751, | 751, | 751, | 751, | 538, | 751, | 538, |
| 538, | 538, | 538, | 538, | 538, | 1089, | 1089, | 1089, | 1089, | 1089, |
| 1089, | 1089, | 1089, | 948, | 948, | 948, | 948, | 948, | 948, | 948, |
| 948, | 948, | 948, | 948, | 948, | 1617, | 1617, | 1617, | 1617, | 1617, |
| 1617, | 1958, | 1958, | 1958, | 1958, | 1958, | 1958, | 1958, | 1958, | 1958, |
| 1958, | 409, | 409, | 1362, | 1661, | 1362, | 1362, | 2283, | 850, | 2283, |
| 2283, | 2283, | 2283, | 865, | 1464, | 1592, | 2174, | 1592, | 784, | 784, |
| 784, | 1060, | 1060, | 1060, | 1060, | 1060, | 1060, | 241, | 1060, | 241, |
| 1060, | 736, | 736, | 442, | 442, | 442, | 442, | 442, | 442, | 442, |
| 442, | 442, | 442, | 442, | 442, | 271, | 271, | 271, | 271, | 271, |
| 271, | 271, | 271, | 271, | 271, | 353, | 353, | 1222, | 2224, | 1222, |
| 1222, | 1222, | 1222, | 1222, | 1222, | 1222, | 1222, | 755, | 755, | 755, |
| 755, | 755, | 755, | 1331, | 1331, | 1331, | 1331, | 1331, | 1331, | 1331, |
| 1331, | 1569, | 1569, | 1569, | 1569, | 1569, | 1569, | 1219, | 2138, | 1219, |
| 1219, | 35, | 265, | 409, | 409, | 409, | 35, | 22, | 22, | 812, |
| 812, | 154, | 1023, | 812, | 409, | 1916, | 1916, | 1916, | 1916, | 1916, |
| 1916, | 2047, | 2047, | 2047, | 2047, | 1448, | 1448, | 299, | 299, | 299, |

(continued)

| | | | | | | | | | |
|---|---|---|---|---|---|---|---|---|---|
| 299, | 299, | 299, | 299, | 299, | 299, | 1745, | 299, | 299, | 299, |
| 299, | 299, | 299, | 1764, | 1764, | 1764, | 1764, | 1764, | 1764, | 1764, |
| 1764, | 1764, | 1764, | 1764, | 1764, | 1514, | 1514, | 552, | 552, | 552, |
| 552, | 1687, | 1687, | 1687, | 1687, | 1687, | 1687, | 1687, | 1687, | 1687, |
| 1687, | 1687, | 1687, | 1687, | 1687, | 172, | 172, | 172, | 172, | 172, |
| 172, | 2115, | 2115, | 2115, | 2115, | 196, | 1858, | 196, | 1858, | 1858, |
| 1858, | 1858, | 1858, | 364, | 364, | 364, | 364, | 364, | 364, | 364, |
| 364, | 1517, | 364, | 646, | 646, | 646, | 646, | 646, | 646, | 646, |
| 646, | 128, | 128, | 128, | 128, | 128, | 128, | 1163, | 1163, | 427, |
| 427, | 427, | 427, | 1371, | 1371, | 1371, | 1868, | 1868, | 1868, | 960, |
| 1868, | 1868, | 1371, | 960, | 694, | 1371, | 425, | 694, | 694, | 694, |
| 694, | 425, | 1540, | 694, | 694, | 1466, | 1466, | 1466, | 1466, | 1466, |
| 1466, | 1604, | 1604, | 334, | 334, | 334, | 334, | 334, | 334, | 30, |
| 30, | 30, | | 1851, | 83, | 83, | 1629, | 1851, | 1629, | 784, |
| 1629, | 1629, | 1629, | 1629, | 1629, | 1629, | 1629, | 391, | 178, | 178, |
| 2044, | 398, | 1947, | 398, | 398, | 398, | 398, | 1641, | 1641, | 1641, |
| 1641, | 1641, | 1641, | 1641, | 1641, | 30, | 30, | 30, | 30, | 30, |
| 1779, | 30, | 1779, | 1779, | 1779, | 1707, | 1707, | 1128, | 1128, | 1128, |
| 1128, | 1128, | 1128, | 1128, | 1128, | 1128, | 1128, | 1569, | 420, | 1569, |
| 420, | 1569, | 420, | 420, | 420, | 420, | 420, | 420, | 420, | 420, |
| 420, | 1592, | 2086, | 1429, | 1347, | 2011, | 2011, | 2161, | 1448, | 1448, |
| 1448, | 1448, | 1448, | 1448, | 1448, | 1448, | 1448, | 1457, | 1457, | 1457, |
| 1457, | 1457, | 1457, | 1457, | 1457, | 1457, | 1457, | 1457, | 1457, | 1457, |
| 1457, | 998, | 998, | 998, | 998, | 749, | 749, | 749, | 2305, | 295, |
| 2441, | 2441, | 2441, | 159, | 159, | 886, | 886, | 886, | 886, | 159, |
| 2201, | 886, | 886, | 886, | 159, | 2201, | 886, | 2201, | 2201, | 886, |
| 2201, | 2346, | 2131, | 2131, | 2131, | 514, | 2075, | 2075, | 2075, | 2075, |
| 2075, | 1188, | 1188, | 1444, | 1444, | 1444, | 1444, | 2263, | 2263, | 2263, |
| 2263, | 2263, | 2263, | 1125, | 1125, | 933, | 933, | 933, | 933, | 933, |
| 933, | 364, | 933, | 1128, | 933, | 933, | 933, | 818, | 1926, | 1926, |
| 1926, | 1128, | 2440, | 1128, | 1128, | 1128, | 1128, | 1128, | 1128, | 1128, |
| 1128, | 1128, | 1128, | 1128, | 1128, | 1128, | 1128, | 1128, | 1128, | 1128, |
| 1128, | 2174, | 1651, | 1651, | 1651, | 1651, | 1651, | 1651, | 2174, | 2174, |
| 1651, | 1651, | 1651, | 1651, | 1651, | 1651, | 1651, | 1651, | 1651, | 22, |
| 22, | 22, | 22, | 2263, | 22, | 22, | 2263, | 2263, | 22, | 22, |
| 22, | 2548, | 2548, | 2665, | 1998, | 2427, | 2053, | 920, | 920, | 920, |
| 920, | 920, | 36, | 13, | 19, | 1790, | 2471, | 1197, | 1197, | 2502, |
| 2502, | 266, | 266, | 266, | 266, | 266, | 266, | 521, | 521, | 521, |
| 521, | 521, | 521, | 521, | 521, | 521, | 521, | 521, | 521, | 521, |
| 521, | 521, | 521, | 521, | 521, | 521, | 521, | 521, | 521, | 1418, |
| 1418, | 2232, | 2232, | 2232, | 2232, | 2232, | 2232, | 2806, | 2806, | 2806, |
| 2806, | 2878, | 2806, | 2806, | 2878, | 174, | 2636, | 2636, | 2878, | 1450, |
| 2878, | 2806, | 2878, | 253, | 253, | 253, | 253, | 253, | 253, | 979, |
| 979, | 979, | 979, | 979, | 979, | 979, | 979, | 979, | 979, | 979, |
| 979, | 552, | 552, | 295, | 295, | 295, | 295, | 295, | 295, | 1707, |
| 2465, | 1707, | 1707, | 1707, | 978, | 1707, | 1707, | 1707, | 2465, | 1707, |
| 1707, | 132, | 132, | 2842, | 130, | 132, | 132, | 130, | 130, | 130, |
| 132, | 132, | 130, | 132, | 132, | 132, | 132, | 1495, | 1495, | 1973, |
| 1973, | 1973, | 1973, | 723, | 912, | 2482, | 2482, | 2482, | 723, | 89, |
| 89, | 89, | 89, | 89, | 89, | 1671, | 89, | 89, | 89, | 1767, |
| 89, | 1009, | 1009, | 1177, | 1177, | 1177, | 1177, | 1177, | 1177, | 1177, |

(continued)

| | | | | | | | | | |
|---|---|---|---|---|---|---|---|---|---|
| 1177, | 1177, | 1177, | 1177, | 1177, | 1177, | 1177, | 1177, | 1177, | 1177, |
| 1744, | 2076, | 2076, | 2076, | 2076, | 2811, | 2076, | 2076, | 2076, | 2811, |
| 2076, | 607, | 2076, | 2076, | 2076, | 2076, | 2076, | 2076, | 2076, | 607, |
| 2076, | 2076, | 2076, | 2076, | 2076, | 2306, | 2306, | 2306, | 2306, | 2306, |
| 2306, | 2306, | 2306, | 2306, | 2306, | 770, | 1514, | 1514, | 770, | 1514, |
| 1514, | 1421, | 1616, | 2110, | 2110, | 2110, | 2110, | 2110, | 2110, | 2110, |
| 2110, | 2110, | 2110, | 127, | 127, | 2521, | 2521, | 2521, | 2521, | 2521, |
| 2521, | 2521, | 2521, | 2521, | 2521, | 1588, | 1588, | 1505, | 1505, | 272, |
| 272, | 1505, | 1505, | 1505, | 1505, | 1505, | 1505, | 2961, | 695, | 695, |
| 1174, | 1174, | 695, | 2135, | 2135, | 838, | 838, | 2155, | 2155, | 2155, |
| 2155, | 2155, | 2122, | 2122, | 2122, | 465, | 465, | 583, | 583, | 583, |
| 583, | 583, | 583, | 583, | 583, | 583, | 583, | 2451, | 1845, | 1845, |
| 1617, | 2451, | 1845, | 978, | 978, | 978, | 978, | 978, | 978, | 978, |
| 978, | 1197, | 1197, | 1197, | 1197, | 1197, | 1197, | 1197, | 1197, | 1197, |
| 1197, | 1197, | 1197, | 1197, | 1197, | 1197, | 1197, | 3017, | 1197, | 1197, |
| 1197, | 3017, | 1197, | 3017, | 1197, | 1197, | 1197, | 1197, | 1197, | 1197, |
| 1197, | 2863, | 2863, | 2863, | 2863, | 2863, | 2863, | 2863, | 2863, | 2863, |
| 2863, | 852, | 852, | 1168, | 1168, | 1168, | 1168, | 1168, | 1168, | 2748, |
| 1168, | 1168, | 1168, | 1495, | 1495, | 1495, | 1495, | 1495, | 1669, | 1669, |
| 1669, | 1329, | 1329, | 1329, | 1329, | 1329, | 1329, | 1727, | 1727, | 2441, |
| 1532, | 1532, | 1532, | 1727, | 2441, | 1727, | 1727, | 550, | 550, | 550, |
| 550, | 550, | 550, | 550, | 550, | 550, | 550, | 550, | 2263, | 550, |
| 2263, | 550, | 550, | 550, | 550, | 353, | 353, | 353, | 353, | 353, |
| 353, | 2245, | 1592, | 1612, | 2245, | 1834, | 2245, | 1612, | 1822, | 1612, |
| 2826, | 2245, | 1592, | 477, | 477, | 477, | 477, | 477, | 477, | 477, |
| 477, | 477, | 477, | 477, | 477, | 2724, | 2724, | 353, | 209, | 486, |
| 353, | 1485, | 2113, | 353, | 353, | 2113, | 1485, | 353, | 353, | 353, |
| 1485, | 1485, | 2113, | 2113, | 2113, | 2811, | 2811, | 2811, | 2811, | 2811, |
| 2811, | 2308, | 1587, | 3336, | 1587, | 1401, | 1285, | 1285, | 1285, | 1099, |
| 1099, | 1099, | 1099, | 1099, | 1099, | 21, | 21, | 21, | 21, | 21, |
| 21, | 21, | 21, | 21, | 21, | 21, | 21, | 21, | 21, | 21, |
| 21, | 21, | 21, | 2071, | 2071, | 1188, | 1188, | 1188, | 1188, | 1188, |
| 1188, | 1188, | 1188, | 2494, | 2494, | 2963, | 2963, | 2963, | 2963, | 2963, |
| 2963, | 2963, | 2963, | 2963, | 2963, | 2963, | 2963, | 2963, | 2963, | 398, |
| 398, | 398, | 398, | 398, | 398, | 3153, | 3102, | 3153, | 169, | 2089, |
| 2089, | 2273, | 1530, | 1530, | 3307, | 1222, | 1222, | 1222, | 1222, | 1222, |
| 1222, | 1222, | 1222, | 1222, | 1222, | 1222, | 1222, | 1222, | 1222, | 1222, |
| 1222, | 1222, | 1222, | 1222, | 1222, | 1222, | 1222, | 1222, | 1222, | 1118, |
| 1118, | 492, | 492, | 492, | 492, | 492, | 1489, | 1489, | 1489, | 555, |
| 555, | 2645, | 555, | 555, | 555, | 555, | 555, | 555, | 555, | 555, |
| 555, | 555, | 555, | 555, | 555, | 2656, | 2656, | 2656, | 2656, | 2656, |
| 1015, | 1015, | 1015, | 2619, | 2619, | 2619, | 2619, | 2619, | 2619, | 1401, |
| 1118, | 1401, | 2780, | 1118, | 1118, | 1778, | 1778, | 1778, | 1778, | 1778, |
| 1778, | 1778, | 1778, | 1778, | 1778, | 1778, | 1778, | 1778, | 1778, | 1778, |
| 1778, | 1778, | 1778, | 1263, | 1263, | 1263, | 1263, | 1263, | 1263, | 1263, |
| 1263, | 1263, | 1263, | 1263, | 1263, | 1263, | 1263, | 3649, | 1263, | 2860, |
| 2860, | 2924, | 1592, | 1592, | 3223, | 1490, | 9, | 2620, | 954, | 1490, |
| 954, | 785, | 785, | 2627, | 772, | 772, | 2627, | 772, | 772, | 2347, |
| 2347, | 2347, | 2347, | 2347, | 2347, | 2534, | 2534, | 2534, | 2534, | 2534, |
| 2534, | 2534, | 2534, | 2534, | 2534, | 1260, | 1260, | 1260, | 1260, | 1260, |
| 1260, | 647, | 647, | 647, | 647, | 647, | 647, | 647, | 647, | 647, |

(continued)

647, 647, 647, 2282, 2282, 2282, 2282, 2282, 2282, 2282,
2282, 2282, 2282, 2282, 2282, 960, 960, 960, 960, 960,
960, 960, 960, 960, 960, 960, 960, 960, 960, 960,
960, 960, 960, 2263, 2263, 287, 287, 287, 287, 287,
287, 1797, 1797, 572, 1797, 1179, 1179, 1179, 1179, 1179,
1179, 1179, 1179, 1179, 1179, 1179, 1179, 1179, 1179, 1179,
1179, 3355, 1179, 784, 784, 784, 364, 1381, 1381, 1381,
364, 647, 647, 647, 647, 647, 647, 647, 647, 647,
647, 647, 647, 647, 647, 647, 647, 647, 647, 647,
647, 647, 647, 647, 647, 112, 112, 112, 2626, 1490,
2179, 2041, 2041, 2041, 2041, 481, 2094, 2094, 2094, 514,
2094, 2455, 2455, 582, 306, 306, 306, 306, 306, 306,
306, 306, 306, 306, 2076, 3103, 3103, 3103, 3103, 488,
488, 488, 488, 488, 488, 488, 488, 488, 488, 488,
488, 82, 82, 241, 241, 241, 241, 241, 241, 3535,
241, 241, 241, 241, 241, 241, 241, 241, 241, 241,
241, 3535, 241, 241, 3535, 241, 241, 241, 241, 241,
241, 241, 241, 891, 285, 285, 285, 1188, 1188, 1188,
1188, 1188, 1188, 3011, 1325, 1325, 567, 1325, 3549, 1367,
1367, 1367, 1367, 1367, 1367, 1367, 1367, 1367, 1367, 1367,
1367, 2665, 23, 23, 3017, 3017, 3017, 3017, 3017, 3017,
3017, 3017, 3017, 3017, 3017, 1423, 2897, 1423, 1423, 918,
918, 166, 166, 166, 166, 166, 166, 2815, 166, 166,
166, 2282, 2282, 2282, 2282, 2282, 2282, 2282, 2282, 2282,
2282, 2282, 2282, 2619, 2619, 2161, 2161, 2161, 2161, 2696,
2814, 3336, 3336, 2814, 2696, 2452, 2452, 2452, 3482, 2452,
1392, 2452, 2452, 1229, 1229, 2627, 303, 2263, 2263, 3346,
838, 838, 3346, 838, 3346, 838, 2583, 2583, 2583, 3232,
3232, 1596, 1720, 1720, 1720, 2044, 2044, 409, 2044, 2044,
2044, 2044, 2044, 409, 21, 409, 2044, 409, 2044, 21,
21, 21, 21, 21, 21, 3268, 3268, 1727, 1727, 3994,
3268, 1335, 1335, 1335, 1335, 3547, 3547, 393, 1069, 3547,
1260, 465, 465, 2041, 2656, 2656, 2656, 2656, 2656, 2656,
2656, 2656, 2656, 1355, 2185, 1260, 1260, 1260, 1260, 1260,
1260, 1260, 1260, 1260, 1571, 1778, 1778, 1778, 1571, 1260,
1260, 2294, 2294, 2294, 2294, 2294, 2294, 2294, 2294, 2294,
2294, 2294, 2294, 516, 2214, 1811, 1811, 1811, 1811, 1811,
1811, 420, 420, 420, 420, 420, 420, 420, 420, 420,
420, 420, 420, 420, 420, 420, 420, 1086, 1086, 1086,
1086, 1104, 1610, 1610, 1610, 1610, 1610, 1404, 1404, 1404,
1404, 1404, 1404, 1404, 1404, 1404, 1404, 1404, 3811, 4368,
4368, 1338, 1338, 1338, 1338, 1338, 1338, 1260, 1260, 550,
1260, 1260, 550, 920, 2161, 920, 2161, 920, 920, 3641,
3357, 3641, 3641, 3641, 3641, 3641, 3357, 3357, 3641, 3641,
3641, 3641, 3641, 3641, 998, 3641, 3641, 3641, 3641, 3641,
3641, 3641, 3641, 3641, 3641, 3641, 3641, 231, 231, 231,
231, 231, 231, 1457, 1457, 1457, 1457, 3525, 1457, 3525,
1457, 1457, 1457, 1457, 1457, 1457, 409, 409, 409, 1423,
409, 4075, 409, 2968, 2968, 2968, 2968, 2968, 2968, 2968,
2968, 2968, 2968, 3676, 3676, 2386, 3676, 3676, 3676, 3676,
3676, 1129, 1129, 1129, 1129, 1129, 1129, 1129, 1129, 1129,

(continued)

| | | | | | | | | | |
|---|---|---|---|---|---|---|---|---|---|
| 1129, | 1129, | 1129, | 1650, | 1650, | 1650, | 1650, | 4246, | 4246, | 4246, |
| 4246, | 1650, | 1650, | 1650, | 4246, | 4246, | 4246, | 4246, | 4246, | 4246, |
| 4246, | 2224, | 2224, | 2224, | 425, | 2220, | 826, | 663, | 663, | 663, |
| 2423, | 2707, | 2707, | 2707, | 2707, | 2707, | 2707, | 2707, | 2707, | 2707, |
| 2707, | 2707, | 2707, | 2707, | 2707, | 2707, | 2707, | 2707, | 2707, | 2707, |
| 2707, | 2707, | 2707, | 2707, | 2707, | 3178, | 2519, | 2519, | 3178, | 3178, |
| 3178, | 51, | 3178, | 51, | 3178, | 4507, | 4507, | 2437, | 2437, | 2521, |
| 231, | 231, | 2521, | 2854, | 2854, | 3019, | 3019, | 3611, | 3611, | 3019, |
| 918, | 3019, | 3545, | 3545, | 3545, | 3545, | 3545, | 3611, | 3611, | 3611, |
| 3611, | 2514, | 2514, | 2514, | 2514, | 2514, | 2514, | 4151, | 4151, | 4151, |
| 4151, | 4151, | 4151, | 586, | 586, | 4343, | 2664, | 2664, | 2664, | 586, |
| 2664, | 2664, | 2664, | 2679, | 2664, | 2664, | 2664, | 1017, | 1423, | 1423, |
| 1423, | 1017, | 1423, | 1017, | 1017, | 1423, | 2665, | 1888, | 1888, | 788, |
| 788, | 788, | 788, | 788, | 788, | 1888, | 788, | 788, | 1888, | 788, |
| 788, | 871, | 871, | 954, | 871, | 1477, | 4453, | 4241, | 4453, | 1477, |
| 4453, | 4453, | 4241, | 4453, | 4453, | 4241, | 838, | 4241, | 4453, | 4453, |
| 4241, | 4241, | 3726, | 838, | 4241, | 3726, | 1477, | 1477, | 1477, | 4968, |
| 3726, | 4968, | 4968, | 1477, | 4968, | 2444, | 2444, | 2444, | 2444, | 2444, |
| 2444, | 1429, | 1429, | 1429, | 1429, | 1429, | 1429, | 893, | 893, | 893, |
| 893, | 893, | 893, | 4101, | 2263, | 4101, | 4101, | 2263, | 4101, | 2263, |
| 2263, | 4173, | 4173, | 4173, | 4173, | 4173, | 4173, | 4620, | 3269, | 3461, |
| 4394, | 3830, | 3830, | 423, | 423, | 423, | 423, | 423, | 423, | 423, |
| 423, | 423, | 423, | 423, | 423, | 3220, | 3220, | 3220, | 3220, | 3220, |
| 2081, | 1599, | 3780, | 1599, | 3780, | 2311, | 2311, | 2632, | 2632, | 2632, |
| 2632, | 2632, | 2632, | 3360, | 1158, | 3360, | 3085, | 3085, | 1158, | 3360, |
| 3085, | 3085, | 3085, | 2464, | 3085, | 2464, | 3085, | 2464, | 2464, | 3085, |
| 3085, | 3085, | 3085, | 3085, | 3085, | 734, | 3285, | 920, | 920, | 920, |
| 920, | 364, | 364, | 364, | 364, | 364, | 364, | 364, | 364, | 364, |
| 364, | 364, | 364, | 364, | 364, | 364, | 364, | 364, | 364, | 4978, |
| 4978, | 4131, | 4131, | 4131, | 4131, | 2903, | 303, | 303, | 303, | 1189, |
| 303, | 1189, | 1189, | 1189, | 303, | 1189, | 303, | 2263, | 2263, | 2599, |
| 2599, | 2599, | 2599, | 2599, | 3029, | 1060, | 1060, | 1060, | 1060, | 1727, |
| 1727, | 1727, | 1727, | 1727, | 1727, | 1727, | 1727, | 1727, | 1727, | 1727, |
| 1727, | 1727, | 1727, | 1727, | 1727, | 1727, | 1727, | 1727, | 1727, | 1727, |
| 1727, | 1727, | 1727, | 1727, | 1727, | 2831, | 2728, | 2831, | 3421, | 3421, |
| 3421, | 2582, | 2582, | 2582, | 2582, | 1333, | 1965, | 465, | 465, | 465, |
| 465, | 5182, | 5182, | 5182, | 5182, | 5182, | 5182, | 73, | 5182, | 398, |
| 398, | 3619, | 398, | 398, | 398, | 398, | 398, | 398, | 398, | 4554, |
| 4554, | 5110, | 5110, | 5110, | 5110, | 4554, | 5110, | 5110, | 5110, | 5110, |
| 5110, | 5110, | 5110, | 2907, | 2907, | 2907, | 2907, | 2907, | 2907, | 2907, |
| 2907, | 2907, | 2907, | 2907, | 2907, | 5110, | 2907, | 2907, | 2907, | 2907, |
| 2907, | 784, | 784, | 784, | 3138, | 3138, | 784, | 3138, | 3138, | 3138, |
| 1710, | 3138, | 1710, | 3138, | 3138, | 1710, | 1710, | 1367, | 1367, | 4114, |
| 4114, | 1614, | 4114, | 4114, | 4114, | 5082, | 1778, | 1778, | 1778, | 2562, |
| 2562, | 780, | 780, | 780, | 780, | 2843, | 2843, | 4642, | 3355, | 3355, |
| 3355, | 3355, | 3355, | 3355, | 4478, | 3355, | 3355, | 2665, | 2665, | 4274, |
| 4274, | 4274, | 2665, | 4274, | 4274, | 4274, | 4274, | 4274, | 4274, | 4274, |
| 4274, | 325, | 325, | 325, | 325, | 325, | 325, | 1222, | 1222, | 1222, |
| 1222, | 2665, | 2665, | 2665, | 2665, | 3351, | 2665, | 2665, | 2665, | 2359, |
| 1053, | 2359, | 2294, | 2359, | 3599, | 3599, | 2359, | 2359, | 2359, | 2831, |
| 2831, | 3672, | 2831, | 3672, | 1335, | 2160, | 2160, | 2160, | 4009, | 4240, |

(continued)

| | | | | | | | | | |
|---|---|---|---|---|---|---|---|---|---|
| 4240, | 4240, | 4240, | 4240, | 4240, | 4009, | 4240, | 4240, | 4240, | 4009, |
| 4240, | 4009, | 4240, | 2160, | 2160, | 2386, | 681, | 681, | 2386, | 3270, |
| 3270, | 2631, | 2631, | 2631, | 2631, | 2631, | 2631, | 2434, | 2434, | 2434, |
| 2434, | 2434, | 2434, | 2434, | 2434, | 2434, | 2434, | 2434, | 2434, | 2434, |
| 2434, | 2434, | 2434, | 2434, | 2434, | 2434, | 1514, | 2434, | 2434, | 2434, |
| 2434, | 2434, | 2434, | 2434, | 2434, | 2434, | 4465, | 3926, | 3926, | 3926, |
| 3926, | 3926, | 3926, | 3926, | 3926, | 1275, | 266, | 266, | 1275, | 1275, |
| 1275, | 266, | 1275, | 266, | 1275, | 5397, | 1879, | 1879, | 1879, | 1879, |
| 1879, | 1331, | 681, | 681, | 1331, | 1275, | 1275, | 5208, | 5208, | 5208, |
| 5208, | 3399, | 3399, | 3399, | 5208, | 327, | 327, | 327, | 327, | 327, |
| 327, | 496, | 496, | 496, | 496, | 496, | 496, | 496, | 496, | 496, |
| 496, | 496, | 496, | 691, | 4587, | 4642, | 691, | 3767, | 2607, | 2607, |
| 4527, | 4527, | 3767, | 3946, | 3946, | 960, | 2194, | 2194, | 2194, | 2194, |
| 960, | 4282, | 55, | 55, | 55, | 920, | 550, | 920, | 920, | 957, |
| 920, | 822, | 822, | 5031, | 5031, | 5031, | 5031, | 5031, | 5031, | 5031, |
| 4850, | 5031, | 5031, | 5164, | 5332, | 3277, | 3277, | 3277, | 3277, | 3277, |
| 3277, | 3277, | 3277, | 3277, | 3277, | 3277, | 3277, | 3277, | 3277, | 3277, |
| 3277, | 2116, | 2116, | 2116, | 4467, | 4418, | 4467, | 1896, | 1596, | 1596, |
| 1596, | 1596, | 1596, | 1596, | 1896, | 1896, | 4129, | 4129, | 4129, | 4129, |
| 4129, | 4129, | 4129, | 4129, | 4129, | 4129, | 4129, | 1780, | 1780, | 1780, |
| 1780, | 1367, | 1367, | 1367, | 2162, | 1367, | 2162, | 2162, | 2162, | 2162, |
| 2162, | 2162, | 2162, | 238, | 238, | 238, | 238, | 238, | 238, | 238, |
| 238, | 238, | 238, | 238, | 238, | 238, | 238, | 3830, | 3830, | 3533, |
| 3533, | 3533, | 3732, | 3533, | 3533, | 3533, | 3533, | 3533, | 3533, | 3533, |
| 3533, | 3533, | 3533, | 3533, | 3533, | 3533, | 3533, | 3533, | 3533, | 3533, |
| 3533, | 3533, | 3533, | 3470, | 3533, | 4588, | 355, | 3591, | 3591, | 355, |
| 355, | 355, | 355, | 355, | 355, | 355, | 355, | 355, | 355, | 355, |
| 355, | 355, | 355, | 355, | 355, | 3268, | 1877, | 1877, | 1877, | 4001, |
| 4001, | 4001, | 4001, | 4001, | 4001, | 4001, | 4001, | 4001, | 4001, | 4001, |
| 4001, | 4001, | 4001, | 4001, | 4001, | 4001, | 4001, | 656, | 656, | 4713, |
| 4713, | 656, | 4713, | 4713, | 4713, | 322, | 322, | 322, | 322, | 322, |
| 322, | 4218, | 4218, | 4218, | 4218, | 5182, | 5182, | 2845, | 5182, | 5182, |
| 5182, | 4518, | 4518, | 4518, | 2069, | 4518, | 4518, | 4518, | 4518, | 4518, |
| 2069, | 2069, | 2069, | 2069, | 2069, | 4650, | 759, | 4650, | 759, | 759, |
| 4650, | 552, | 552, | 552, | 552, | 552, | 552, | 2331, | 2331, | 2331, |
| 2331, | 2331, | 2331, | 2331, | 2331, | 2331, | 2331, | 6187, | 6187, | 5172, |
| 5842, | 5842, | 5842, | 5842, | 5842, | 5842, | 5842, | 5842, | 5842, | 2162, |
| 2162, | 2162, | 2162, | 2162, | 5031, | 2162, | 2162, | 2162, | 2162, | 2162, |
| 2162, | 3832, | 2386, | 5945, | 6126, | 3832, | 5945, | 5945, | 5945, | 1283, |
| 1283, | 1283, | 1283, | 1283, | 1283, | 1283, | 1283, | 1283, | 1592, | 4352, |
| 4352, | 3349, | 3349, | 6917, | 6917, | 3349, | 6917, | 3349, | 2751, | 3349, |
| 3349, | 6135, | 2837, | 2837, | 6135, | 6135, | 6135, | 2794, | 6135, | 4780, |
| 4780, | 4780, | 4780, | 4780, | 4780, | 4780, | 4780, | 4780, | 4780, | 4780, |
| 4780, | 1060, | 1060, | 1060, | 1060, | 1060, | 2764, | 1060, | 1060, | 1060, |
| 1060, | 1489, | 308, | 1423, | 1423, | 1423, | 1423, | 1423, | 1423, | 1423, |
| 1423, | 1423, | 1423, | 1423, | 1423, | 1423, | 1423, | 1423, | 1423, | 1423, |
| 1423, | 1423, | 1423, | 1423, | 1423, | 4558, | 4330, | 1654, | 1654, | 1654, |
| 1654, | 5061, | 5061, | 5061, | 5061, | 1425, | 5061, | 1425, | 1425, | 971, |
| 971, | 971, | 716, | 971, | 971, | 2814, | 2616, | 2814, | 2814, | 308, |
| 308, | 308, | 308, | 308, | 308, | 308, | 308, | 5380, | 785, | 5380, |
| 5380, | 5380, | 5380, | 5380, | 1592, | 5380, | 5380, | 5380, | 5380, | 5380, |

(continued)

| | | | | | | | | | |
|---|---|---|---|---|---|---|---|---|---|
| 5380, | 5380, | 3464, | 4468, | 4468, | 2244, | 2244, | 2244, | 2244, | 2244, |
| 2244, | 2244, | 2244, | 2244, | 2244, | 3880, | 3880, | 3880, | 3880, | 3880, |
| 3880, | 60, | 60, | 60, | 60, | 60, | 60, | 734, | 734, | 5647, |
| 5647, | 5647, | 5647, | 5647, | 5647, | 3145, | 6661, | 3145, | 3145, | 3145, |
| 3145, | 3145, | 3145, | 3145, | 3145, | 2071, | 2071, | 2071, | 2071, | 2071, |
| 2071, | 4680, | 4680, | 676, | 676, | 676, | 676, | 676, | 676, | 676, |
| 676, | 676, | 676, | 2641, | 2641, | 2641, | 2641, | 2641, | 2641, | 6532, |
| 6532, | 6532, | 6532, | 6532, | 6532, | 5098, | 5098, | 5098, | 5098, | 1628, |
| 5098, | 1592, | 1592, | 1592, | 1592, | 1592, | 1592, | 1592, | 1592, | 55, |
| 6221, | 6221, | 6221, | 6221, | 6221, | 3977, | 550, | 550, | 550, | 550, |
| 550, | 3977, | 550, | 550, | 3977, | 4055, | 3651, | 3651, | 3651, | 3651, |
| 550, | 21, | 21, | 2639, | 2639, | 2639, | 2639, | 2639, | 2639, | 863, |
| 863, | 863, | 863, | 863, | 1086, | 4557, | 4557, | 4557, | 4557, | 5449, |
| 5449, | 277, | 1497, | 1497, | 277, | 1497, | 1497, | 277, | 277, | 1497, |
| 277, | 2432, | 2432, | 2432, | 2432, | 2432, | 2432, | 2432, | 2432, | 2603, |
| 2603, | 3041, | 3041, | 3041, | 3041, | 2603, | 3041, | 3041, | 2702, | 2702, |
| 2603, | 2603, | 2603, | 2603, | 2603, | 2603, | 3041, | 3041, | 3041, | 2702, |
| 3041, | 3041, | 3041, | 6043, | 6043, | 6043, | 6043, | 6043, | 6043, | 2365, |
| 784, | 784, | 2365, | 2365, | 2365, | 2365, | 2365, | 2365, | 784, | 784, |
| 784, | 2365, | 784, | 784, | 4718, | 4718, | 4718, | 4718, | 4718, | 4718, |
| 4718, | 55, | 681, | 681, | 5658, | 5658, | 5658, | 5658, | 5658, | 681, |
| 5658, | 681, | 5658, | 5658, | 5658, | 681, | 681, | 5658, | 5658, | 5658, |
| 6510, | 6510, | 6510, | 7236, | 5014, | 5014, | 5014, | 5014, | 5014, | 5014, |
| 5014, | 5014, | 4116, | 4116, | 4116, | 4116, | 4116, | 4116, | 4116, | 4116, |
| 4116, | 4116, | 4885, | 5997, | 4885, | 4885, | 5997, | 5997, | 4885, | 4885, |
| 4885, | 7266, | 7266, | 7266, | 7266, | 7266, | 7266, | 4885, | 4885, | 5997, |
| 4885, | 4885, | 5997, | 4885, | 4885, | 4885, | 4885, | 4885, | 4885, | 4885, |
| 4885, | 4885, | 327, | 327, | 327, | 327, | 327, | 327, | 327, | 327, |
| 4650, | 4650, | 4650, | 2396, | 4650, | 4650, | 4650, | 4650, | 4650, | 4650, |
| 4650, | 3676, | 4650, | 4650, | 3676, | 4650, | 4650, | 4650, | 6481, | 7188, |
| 6481, | 7188, | 1195, | 4368, | 5475, | 4518, | 4518, | 4518, | 4518, | 4518, |
| 4518, | 4518, | 4518, | 4518, | 425, | 425, | 425, | 425, | 4272, | 4272, |
| 6009, | 6009, | 4650, | 4650, | 4650, | 4650, | 4650, | 4650, | 1267, | 1267, |
| 1267, | 1267, | 1229, | 1229, | 1229, | 1229, | 1229, | 1229, | 1229, | 1229, |
| 1229, | 1229, | 1229, | 1229, | 3357, | 1229, | 1229, | 1229, | 1229, | 3357, |
| 6476, | 6476, | 6476, | 6476, | 6476, | 6476, | 6476, | 6476, | 6305, | 6305, |
| 6305, | 6305, | 6305, | 6305, | 6305, | 6305, | 6305, | 6305, | 6305, | 6305, |
| 8903, | 8903, | 8903, | 8903, | 8903, | 36, | 8903, | 36, | 36, | 36, |
| 36, | 36, | 36, | 36, | 36, | 36, | 8903, | 425, | 425, | 425, |
| 425, | 425, | 425, | 425, | 425, | 425, | 425, | 425, | 425, | 425, |
| 425, | 425, | 6380, | 6380, | 6380, | 367, | 6380, | 2877, | 1916, | 1916, |
| 4512, | 4195, | 4195, | 4512, | 4195, | 4195, | 4195, | 4512, | 4512, | 4771, |
| 4771, | 4771, | 7692, | 7692, | 7692, | 7692, | 7692, | 7692, | 1839, | 1839, |
| 1839, | 1839, | 5201, | 1839, | 5201, | 5201, | 5201, | 1953, | 1413, | 1413, |
| 5740, | 5957, | 5740, | 5740, | 5740, | 5740, | 5957, | 5957, | 5957, | 5740, |
| 3017, | 4290, | 759, | 759, | 759, | 1066, | 1066, | 759, | 6569, | 6569, |
| 6569, | 7782, | 6569, | 6569, | 6569, | 6569, | 7782, | 7782, | 3651, | 3651, |
| 3651, | 3651, | 427, | 427, | 427, | 3651, | 427, | 427, | 427, | 427, |
| 427, | 427, | 2622, | 2107, | 2107, | 2107, | 7035, | 7035, | 7035, | 7334, |
| 7334, | 7035, | 7334, | 7334, | 7035, | 7035, | 7035, | 7035, | 7035, | 7035, |
| 7035, | 6186, | 3300, | 3300, | 7031, | 3300, | 3300, | 7031, | 3300, | 3300, |

(continued)

| | | | | | | | | | |
|---|---|---|---|---|---|---|---|---|---|
| 3300, | 3300, | 3300, | 3300, | 7031, | 3300, | 3300, | 3300, | 6835, | 6835, |
| 5164, | 5164, | 5164, | 7092, | 7092, | 5164, | 5164, | 5164, | 5164, | 5164, |
| 3722, | 3722, | 869, | 869, | 869, | 869, | 869, | 869, | 869, | 869, |
| 869, | 869, | 5122, | 5122, | 5122, | 5122, | 5122, | 4840, | 5122, | 5122, |
| 5122, | 5122, | 5122, | 5122, | 5122, | 5122, | 4840, | 4840, | 5122, | 5122, |
| 3743, | 5122, | 5658, | 5658, | 5658, | 5658, | 2388, | 5475, | 4805, | 4805, |
| 4805, | 4805, | 2597, | 2597, | 2597, | 6009, | 6009, | 6009, | 3606, | 6009, |
| 1778, | 1778, | 1778, | 1778, | 1778, | 1778, | 1778, | 1778, | 1778, | 1778, |
| 4645, | 1778, | 1778, | 1778, | 1778, | 2751, | 4364, | 4364, | 4094, | 4364, |
| 4094, | 4094, | 1222, | 1222, | 1222, | 1222, | 1222, | 1222, | 5041, | 5041, |
| 5110, | 5110, | 5110, | 5110, | 1335, | 5110, | 5110, | 5110, | 5110, | 5110, |
| 383, | 5110, | 3610, | 3610, | 3610, | 3610, | 3610, | 3610, | 3610, | 3610, |
| 7965, | 7965, | 7965, | 7965, | 7965, | 3610, | 7965, | 3610, | 2814, | 2814, |
| 2814, | 8731, | 2814, | 2814, | 2814, | 2814, | 1335, | 1026, | 1026, | 1026, |
| 6683, | 2129, | 6683, | 6683, | 2129, | 2129, | 827, | 827, | 827, | 827, |
| 827, | 827, | 827, | 827, | 827, | 827, | 827, | 827, | 827, | 827, |
| 827, | 827, | 827, | 827, | 827, | 827, | 827, | 827, | 5723, | 5017, |
| 5723, | 5723, | 5723, | 5723, | 5723, | 5017, | 4055, | 4055, | 3756, | 3756, |
| 3756, | 3756, | 3756, | 3756, | 3756, | 3756, | 3756, | 3756, | 616, | 6933, |
| 7871, | 7871, | 7871, | 7871, | 7871, | 7871, | 5846, | 5846, | 5846, | 5846, |
| 2019, | 2019, | 2019, | 2019, | 2019, | 2019, | 5261, | 5261, | 5261, | 5261, |
| 5261, | 5261, | 1737, | 1737, | 2041, | 1737, | 6532, | 6532, | 6532, | 5676, |
| 442, | 442, | 442, | 1859, | 1859, | 442, | 3101, | 3101, | 3101, | 3101, |
| 4143, | 4143, | 4143, | 4143, | 4143, | 4143, | 4143, | 4143, | 4143, | 4143, |
| 4143, | 4143, | 5726, | 3102, | 3102, | 3102, | 3102, | 3102, | 4880, | 4880, |
| 4880, | 4880, | 4880, | 4880, | 2595, | 2595, | 7052, | 7052, | 7052, | 4885, |
| 7052, | 7052, | 7052, | 7052, | 5177, | 7052, | 7052, | 7052, | 691, | 691, |
| 691, | 691, | 2000, | 2000, | 2000, | 2000, | 2000, | 2000, | 5999, | 2000, |
| 2000, | 2000, | 2000, | 2000, | 2000, | 2000, | 3692, | 3692, | 3692, | 3692, |
| 3692, | 3692, | 6111, | 6111, | 3692, | 6111, | 3692, | 3692, | 5741, | 5741, |
| 5741, | 5741, | 5741, | 5741, | 5741, | 5741, | 5741, | 5741, | 8670, | 10473, |
| 8670, | 8670, | 8670, | 10473, | 8670, | 4035, | 4035, | 8670, | 5261, | 8670, |
| 4035, | 4035, | 5261, | 4035, | 4035, | 8670, | 4035, | 5261, | 5261, | 4035, |
| 6497, | 10666, | 734, | 734, | 734, | 734, | 734, | 734, | 9318, | 9318, |
| 8980, | 8980, | 9155, | 9155, | 9155, | 9318, | 5991, | 9318, | 314, | 9318, |
| 2378, | 2378, | 3102, | 2378, | 3102, | 2378, | 2854, | 5416, | 2889, | 2889, |
| 2889, | 2889, | 2889, | 2889, | 2889, | 2889, | 2889, | 2889, | 2889, | 2889, |
| 2889, | 2889, | 2889, | 2889, | 2931, | 2931, | 2889, | 2889, | 2889, | 2889, |
| 4240, | 4240, | 4240, | 4240, | 4240, | 2162, | 9862, | 2162, | 7246, | 7246, |
| 7246, | 7246, | 7434, | 7246, | 7246, | 7246, | 7246, | 7246, | 7246, | 7246, |
| 7246, | 7246, | 7246, | 7246, | 7246, | 7246, | 4333, | 4333, | 4333, | 4333, |
| 4333, | 4333, | 4333, | 4333, | 4333, | 4333, | 5244, | 5244, | 5244, | 5244, |
| 5244, | 5244, | 51, | 51, | 51, | 51, | 51, | 51, | 51, | 51, |
| 51, | 51, | 51, | 51, | 51, | 51, | 6447, | 6810, | 6810, | 6447, |
| 2921, | 2921, | 2046, | 2046, | 3424, | 2046, | 2046, | 2046, | 6599, | 1911, |
| 6599, | 6599, | 1911, | 1911, | 6599, | 1911, | 6599, | 1911, | 327, | 327, |
| 327, | 327, | 327, | 327, | 327, | 327, | 2678, | 4094, | 4094, | 4094, |
| 4094, | 4094, | 5633, | 5633, | 5633, | 5985, | 7152, | 7152, | 7152, | 7152, |
| 7152, | 7152, | 8279, | 5283, | 5283, | 32, | 5283, | 32, | 32, | 32, |
| 32, | 32, | 32, | 32, | 32, | 32, | 32, | 32, | 32, | 32, |
| 32, | 32, | 5283, | 32, | 32, | 32, | 5283, | 32, | 32, | 32, |

(continued)

| | | | | | | | | | |
|---|---|---|---|---|---|---|---|---|---|
| 32, | 32, | 3634, | 3634, | 3634, | 3634, | 1158, | 3634, | 3634, | 3634, |
| 3634, | 3634, | 3634, | 3634, | 3634, | 3634, | 3101, | 3101, | 3101, | 1392, |
| 1392, | 1392, | 3101, | 3101, | 3101, | 1392, | 4929, | 4929, | 4929, | 4929, |
| 4929, | 4929, | 4929, | 4929, | 4929, | 4929, | 4929, | 4929, | 1803, | 1803, |
| 1803, | 9232, | 9232, | 9232, | 9232, | 1803, | 9232, | 9232, | 7228, | 7228, |
| 2129, | 3435, | 2129, | 2129, | 2129, | 2641, | 9158, | 3351, | 2641, | 9158, |
| 9158, | 3351, | 7167, | 9158, | 2129, | 2129, | 10358, | 10358, | 4330, | 4330, |
| 3814, | 4330, | 6012, | 6012, | 6012, | 6012, | 6012, | 3814, | 3814, | 6012, |
| 6012, | 4330, | 4330, | 7264, | 4330, | 6012, | 1446, | 1446, | 1446, | 1446, |
| 1446, | 1446, | 1446, | 1446, | 1446, | 1446, | 1446, | 1446, | 11793, | 1446, |
| 1446, | 1446, | 1446, | 1446, | 1446, | 1446, | 1446, | 1446, | 1446, | 1446, |
| 8729, | 8729, | 427, | 8729, | 8729, | 8729, | 8729, | 427, | 8729, | 8729, |
| 8729, | 8729, | 8729, | 8729, | 8729, | 8729, | 7741, | 7741, | 7741, | 7741, |
| 4400, | 4400, | 4400, | 4400, | 4400, | 4400, | 4400, | 4400, | 4400, | 4400, |
| 4400, | 4400, | 4400, | 4400, | 4400, | 4400, | 11052, | 5355, | 5355, | 11052, |
| 11052, | 11052, | 11052, | 5355, | 11052, | 11052, | 11052, | 11052, | 11052, | 11052, |
| 11052, | 11052, | 11052, | 11052, | 3090, | 2757, | 3090, | 3090, | 5310, | 5310, |
| 7829, | 7829, | 4155, | 4155, | 5740, | 5740, | 4155, | 5740, | 4155, | 5740, |
| 4155, | 4155, | 4155, | 4155, | 4155, | 4155, | 4155, | 4155, | 5740, | 5740, |
| 3017, | 3017, | 3017, | 3017, | 5920, | 2420, | 4001, | 5920, | 4001, | 4001, |
| 1641, | 1641, | 6807, | 6807, | 6807, | 6807, | 6807, | 6807, | 6807, | 6807, |
| 6807, | 6807, | 4460, | 4460, | 4460, | 4460, | 4460, | 4460, | 4460, | 4460, |
| 9860, | 9860, | 9860, | 9860, | 9860, | 9860, | 9860, | 9860, | 9860, | 9860, |
| 6596, | 6596, | 6596, | 6596, | 5190, | 5190, | 2599, | 3921, | 2599, | 2599, |
| 6569, | 6569, | 8982, | 8982, | 8982, | 8982, | 8982, | 8982, | 8982, | 8982, |
| 10063, | 1655, | 10063, | 10063, | 11787, | 11787, | 11787, | 11787, | 11787, | 11787, |
| 85, | 85, | 550, | 550, | 550, | 550, | 550, | 550, | 550, | 550, |
| 550, | 550, | 4328, | 1089, | 10623, | 10623, | 10623, | 10623, | 10623, | 10623, |
| 10623, | 10623, | 10623, | 10623, | 8757, | 8757, | 5876, | 6540, | 4682, | 4682, |
| 2308, | 2308, | 6219, | 2308, | 2308, | 4664, | 3360, | 3360, | 3360, | 3360, |
| 3360, | 3360, | 7152, | 7152, | 6024, | 6024, | 6024, | 6024, | 6024, | 6024, |
| 6024, | 6024, | 6024, | 6024, | 6024, | 6024, | 5319, | 5319, | 5319, | 5319, |
| 713, | 713, | 713, | 713, | 713, | 713, | 10037, | 713, | 10037, | 10037, |
| 10037, | 10037, | 10950, | 10900, | 10950, | 10950, | 10900, | 10950, | 10950, | 10950, |
| 10950, | 10950, | 10950, | 10950, | 10950, | 10950, | 10950, | 10950, | 10950, | 10950, |
| 4518, | 4518, | 4518, | 4518, | 2263, | 2263, | 9473, | 9473, | 9473, | 7371, |
| 3818, | 3818, | 3818, | 3818, | 3818, | 7505, | 3818, | 3818, | 3818, | 3818, |
| 7505, | 3818, | 3818, | 3818, | 7505, | 3818, | 3818, | 3818, | 3818, | 3818, |
| 6810, | 6810, | 6810, | 6810, | 1790, | 1118, | 1118, | 1790, | 1118, | 1790, |
| 1118, | 1790, | 8982, | 8982, | 8982, | 8982, | 1165, | 8982, | 9317, | 9317, |
| 9317, | 9317, | 173, | 173, | 173, | 173, | 173, | 173, | 173, | 173, |
| 5069, | 5069, | 5069, | 5069, | 8058, | 8058, | 8058, | 8058, | 8058, | 8058, |
| 8058, | 8058, | 8058, | 8058, | 8058, | 8058, | 8058, | 8058, | 6230, | 6574, |
| 6574, | 6574, | 6574, | 6574, | 6574, | 6574, | 6574, | 6574, | 6574, | 6574, |
| 3101, | 3101, | 3101, | 3101, | 3101, | 3101, | 3101, | 3101, | 3101, | 3101, |
| 3101, | 3101, | 7502, | 7502, | 7502, | 7502, | 6313, | 6313, | 4518, | 4518, |
| 4518, | 1606, | 1606, | 1606, | 1606, | 1606, | 9284, | 9284, | 9284, | 9837, |
| 3830, | 3269, | 3269, | 1606, | 1606, | 1606, | 9284, | 1606, | 6912, | 9284, |
| 6912, | 6912, | 9284, | 9284, | 1606, | 9284, | 6545, | 9284, | 8502, | 8502, |
| 8502, | 8502, | 398, | 398, | 398, | 398, | 398, | 398, | 398, | 398, |
| 398, | 398, | 398, | 398, | 398, | 398, | 398, | 398, | 398, | 398, |

(continued)

| | | | | | | | | | |
|---|---|---|---|---|---|---|---|---|---|
| 398, | 398, | 398, | 398, | 398, | 398, | 9158, | 5275, | 5275, | 5275, |
| 5275, | 5275, | 8169, | 8169, | 8169, | 8169, | 8169, | 8169, | 8962, | 11967, |
| 11967, | 11967, | 8962, | 8962, | 8962, | 8962, | 11967, | 11967, | 8962, | 8962, |
| 12618, | 12618, | 12618, | 12618, | 12618, | 12618, | 12618, | 12618, | 12618, | 12618, |
| 12618, | 12618, | 7414, | 7414, | 7414, | 7414, | 7414, | 7414, | 7414, | 7414, |
| 7414, | 7414, | 7414, | 7414, | 7414, | 7414, | 1426, | 1426, | 1426, | 1426, |
| 1426, | 1426, | 7020, | 8968, | 8731, | 8968, | 6251, | 6251, | 327, | 327, |
| 327, | 327, | 3649, | 3649, | 3649, | 4765, | 4765, | 4765, | 4765, | 7688, |
| 4765, | 7688, | 4765, | 4765, | 4765, | 4765, | 4765, | 4765, | 3267, | 7688, |
| 4682, | 3115, | 3115, | 3115, | 3115, | 3115, | 5929, | 5929, | 5929, | 5929, |
| 5929, | 5929, | 5929, | 5929, | 5929, | 5929, | 9332, | 5929, | 5321, | 5321, |
| 5321, | 5321, | 5321, | 5321, | 5321, | 8753, | 4410, | 4410, | 4410, | 4410, |
| 4410, | 4410, | 3300, | 3300, | 3300, | 3300, | 4069, | 4069, | 4069, | 818, |
| 818, | 818, | 4069, | 4069, | 4069, | 4069, | 4069, | 10900, | 656, | 656, |
| 3830, | 3830, | 3830, | 3830, | 3830, | 3830, | 3830, | 3830, | 3830, | 3830, |
| 3830, | 3830, | 9632, | 9632, | 9632, | 9632, | 9632, | 7871, | 9632, | 7871, |
| 9632, | 9632, | 7871, | 7871, | 7871, | 7871, | 7871, | 9632, | 7871, | 7871, |
| 7871, | 7871, | 7871, | 7871, | 7871, | 7871, | 7871, | 7871, | 7871, | 7871, |
| 7871, | 7871, | 5261, | 10356, | 5261, | 5261, | 5261, | 5261, | 5261, | 5261, |
| 5261, | 5261, | 5261, | 5261, | 6979, | 10356, | 10010, | 10356, | 5846, | 10089, |
| 5267, | 5267, | 5267, | 5267, | 4823, | 5267, | 10958, | 11674, | 11674, | 11674, |
| 11674, | 11674, | 11674, | 11674, | 10958, | 10958, | 11674, | 11674, | 11674, | 11674, |
| 8410, | 11674, | 8410, | 734, | 734, | 734, | 1885, | 8410, | 7020, | 7020, |
| 7020, | 7020, | 7020, | 7020, | 7020, | 7020, | 7020, | 7020, | 7020, | 7020, |
| 7020, | 7020, | 1055, | 1055, | 1055, | 1055, | 1055, | 1055, | 7167, | 7167, |
| 7167, | 7167, | 7167, | 7167, | 7167, | 7167, | 7167, | 7167, | 8443, | 8443, |
| 7471, | 7471, | 7471, | 7471, | 8443, | 8443, | 7471, | 8443, | 8443, | 8443, |
| 3269, | 3269, | 3269, | 3269, | 3269, | 3269, | 8286, | 8286, | 5925, | 5925, |
| 5925, | 5925, | 4901, | 4901, | 4901, | 4901, | 4901, | 4901, | 4901, | 4901, |
| 13343, | 13343, | 13343, | 13343, | 13343, | 13343, | 13343, | 13343, | 13343, | 13343, |
| 8111, | 8111, | 8111, | 8111, | 8952, | 6978, | 2484, | 7742, | 2484, | 7742, |
| 2484, | 7742, | 1953, | 1953, | 1953, | 1953, | 1953, | 1953, | 1953, | 1953, |
| 1953, | 1953, | 1953, | 1953, | 1953, | 1953, | 1953, | 1953, | 1953, | 1953, |
| 1953, | 1953, | 1953, | 1964, | 1201, | 1964, | 1501, | 1501, | 9004, | 1501, |
| 1501, | 1501, | 1501, | 1501, | 1501, | 1501, | 1501, | 1501, | 1501, | 1501, |
| 9497, | 9497, | 9497, | 9497, | 9497, | 9497, | 7751, | 7751, | 7751, | 7751, |
| 13738, | 13738, | 13738, | 13738, | 13738, | 13738, | 13738, | 13738, | 2387, | 2387, |
| 2387, | 2387, | 2387, | 2387, | 10089, | 10245, | 10245, | 10245, | 10245, | 10245, |
| 14486, | 767, | 8427, | 767, | 767, | 8427, | 1099, | 8427, | 8427, | 8427, |
| 8427, | 8427, | 767, | 8427, | 767, | 767, | 767, | 767, | 450, | 15435, |
| 8482, | 8482, | 8482, | 4195, | 18171, | 15435, | 15435, | 450, | 6203, | 6203, |
| 13051, | 13051, | 6143, | 13051, | 13051, | 13051, | 13051, | 7956, | 7218, | 7218, |
| 14111, | 14111, | 8643, | 8643, | 8643, | 8643, | 5832, | 5832, | 5832, | 5832, |
| 5832, | 5832, | 12089, | 12089, | 12089, | 12089, | 12089, | 12089, | 12089, | 12089, |
| 12089, | 12089, | 12089, | 12089, | 12089, | 12089, | 12089, | 12089, | 12089, | 12089, |
| 12089, | 12089, | 585, | 585, | 585, | 585, | 585, | 585, | 6468, | 6468, |
| 6468, | 6468, | 795, | 10272, | 10272, | 1620, | 10272, | 12097, | 12097, | 12097, |
| 12097, | 12097, | 10272, | 12097, | 10272, | 12097, | 1997, | 5561, | 5474, | 5474, |
| 14969, | 14969, | 11391, | 11391, | 11391, | 11391, | 2518, | 2518, | 2518, | 2518, |
| 2518, | 2518, | 2518, | 2518, | 2518, | 2518, | 2518, | 2518, | 2518, | 2518, |
| 6594, | 6594, | 6594, | 6594, | 6594, | 6594, | 6170, | 16423, | 6170, | 6170, |

(continued)

| | | | | | | | | | |
|---|---|---|---|---|---|---|---|---|---|
| 16423, | 16423, | 16423, | 6170, | 16423, | 16423, | 6170, | 16423, | 5601, | 5601, |
| 5601, | 5601, | 5601, | 5601, | 5601, | 5601, | 1934, | 5601, | 5601, | 5601, |
| 5601, | 5601, | 5601, | 5601, | 5601, | 5601, | 5601, | 5601, | 5601, | 8349, |
| 8349, | 8349, | 10612, | 3223, | 10612, | 10612, | 10612, | 10612, | 10612, | 7965, |
| 10612, | 3223, | 3830, | 3830, | 3830, | 3830, | 3830, | 3830, | 10583, | 10583, |
| 10583, | 10583, | 10583, | 10583, | 516, | 10583, | 11222, | 11222, | 11222, | 1373, |
| 11222, | 11222, | 11222, | 11222, | 11222, | 11222, | 7871, | 7871, | 17470, | 17470, |
| 17470, | 17470, | 17470, | 17470, | 17470, | 17431, | 17431, | 17431, | 17470, | 17470, |
| 17470, | 8502, | 17470, | 17431, | 17470, | 17470, | 17431, | 17431, | 17431, | 17470, |
| 17470, | 17431, | 17470, | 17431, | 17470, | 17470, | 17431, | 17470 | | |

## APPENDIX B.1 VALUES FOR TABLE $V_0$

These values represent an example set of values for Table $V_0$ described in the application above, in Section B.5.4.1. Each entry is a 32-bit integer in decimal representation. The values should be read from the first column, top to bottom, then the second column, top to bottom, and so on.

| | | | | |
|---|---|---|---|---|
| 251291136 | 2581671944 | 1521339547 | 2068983570 | 2859178611 |
| 3952231631 | 3312220480 | 3041843489 | 2247491078 | 3284308411 |
| 3370958628 | 681232419 | 420130494 | 3669524410 | 3819792700 |
| 4070167936 | 307306866 | 10677091 | 1575146607 | 3557526733 |
| 123631495 | 4112503940 | 515623176 | 828029864 | 451874476 |
| 3351110283 | 1158111502 | 3457502702 | 3732001371 | 1740576081 |
| 3218676425 | 709227802 | 2115821274 | 3422026452 | 3592838701 |
| 2011642291 | 2724140433 | 2720124766 | 3370954177 | 1709429513 |
| 774603218 | 4201101115 | 3242576090 | 4006626915 | 3702918379 |
| 2402805061 | 4215970289 | 854310108 | 543812220 | 3533351328 |
| 1004366930 | 4048876515 | 425973987 | 1243116171 | 1641660745 |
| 1843948209 | 3031661061 | 325832382 | 3928372514 | 179350258 |
| 428891132 | 1909085522 | 1796851292 | 2791443445 | 2380520112 |
| 3746331984 | 510985033 | 2462744411 | 4081325272 | 3936163904 |
| 1591258008 | 1361682810 | 1976681690 | 2280435605 | 3685256204 |
| 3067016507 | 129243379 | 1408671665 | 885616073 | 3156252216 |
| 1433388735 | 3142379587 | 1228817808 | 616452097 | 1854258901 |
| 504005498 | 2569842483 | 3917210003 | 3188863436 | 2861641019 |
| 2032657933 | 3033268270 | 263976645 | 2780382310 | 3176611298 |
| 3419319784 | 1658118006 | 2593736473 | 2340014831 | 834787554 |
| 2805686246 | 932109358 | 2471651269 | 1208439576 | 331353807 |
| 3102436986 | 1982290045 | 4291353919 | 258356309 | 517858103 |
| 3808671154 | 2983082771 | 650792940 | 3837963200 | 3010168884 |
| 2501582075 | 3007670818 | 1191583883 | 2075009450 | 4012642001 |
| 3978944421 | 3448104768 | 3046561335 | 3214181212 | 2217188075 |
| 246043949 | 683749698 | 2466530435 | 3303882142 | 3756943137 |
| 4016898363 | 778296777 | 2545983082 | 880813252 | 3077882590 |
| 649743608 | 1399125101 | 969168436 | 1355575717 | 2054995199 |
| 1974987508 | 1939403708 | 2019348792 | 207231484 | 3081443129 |
| 2651273766 | 1692176003 | 2268075521 | 2420803184 | 3895398812 |
| 2357956801 | 3868299200 | 1169345068 | 358923368 | 1141097543 |
| 689605112 | 1422476658 | 3250240009 | 1617557768 | 2376261053 |
| 715807172 | 593093658 | 3963499681 | 3272161958 | 2626898255 |
| 2722736134 | 1878973865 | 2560755113 | 1771154147 | 2554703076 |

(continued)

| | | | | |
|---|---|---|---|---|
| 191939188 | 2526292949 | 911182396 | 2842106362 | 401233789 |
| 3535520147 | 1591602827 | 760842409 | 1751209208 | 1460049922 |
| 3277019569 | 3986158854 | 3569308693 | 1421030790 | 678083952 |
| 1470435941 | 3964389521 | 2687243553 | 658316681 | 1064990737 |
| 3763101702 | 2695031039 | 381854665 | 194065839 | 940909784 |
| 3232409631 | 1942050155 | 2613828404 | 3241510581 | 1673396780 |
| 122701163 | 424618399 | 2761078866 | 38625260 | 528881783 |
| 3920852693 | 1347204291 | 1456668111 | 301875395 | 1712547446 |
| 782246947 | 2669179716 | 883760091 | 4176141739 | 3629685652 |
| 372121310 | 2434425874 | 3294951678 | 297312930 | 1358307511 |
| 2995604341 | 2540801947 | 1604598575 | 2137802113 | |
| 2045698575 | 1384069776 | 1985308198 | 1502984205 | |
| 2332962102 | 4123580443 | 1014570543 | 3669376622 | |
| 4005368743 | 1523670218 | 2724959607 | 3728477036 | |
| 218596347 | 2708475297 | 3062518035 | 234652930 | |
| 3415381967 | 1046771089 | 3115293053 | 2213589897 | |
| 4207612806 | 2229796016 | 138853680 | 2734638932 | |
| 861117671 | 1255426612 | 4160398285 | 1129721478 | |
| 3676575285 | 4213663089 | 3322241130 | 3187422815 | |

## APPENDIX B.2 VALUES FOR TABLE $V_1$

These values repressent an example set of values for Table $V_1$ described in the application above, in Section B.5.4.1. Each entry is a 32-bit integer in decimal representation. The values should be read from the first column, top to bottom, then the second column, top to bottom, and so on.

| | | | | |
|---|---|---|---|---|
| 807385413 | 3843885867 | 3545667983 | 644189126 | 922673938 |
| 2043073223 | 4201106668 | 332038910 | 226475395 | 3877430102 |
| 3336749796 | 415906198 | 976628269 | 307789415 | 3422391938 |
| 1302105833 | 19296841 | 3123492423 | 1196105631 | 1414347295 |
| 2278607931 | 2402488407 | 3041418372 | 3191691839 | 1971054608 |
| 541015020 | 2137119134 | 2258059298 | 782852669 | 3061798054 |
| 1684564270 | 1744097284 | 2139377204 | 1608507813 | 830555096 |
| 372709334 | 579965637 | 3243642973 | 1847685900 | 2822905141 |
| 3508252125 | 2037662632 | 3226247917 | 4069766876 | 167033190 |
| 1768346005 | 852173610 | 3674004636 | 3931548641 | 1079139428 |
| 1270451292 | 2681403713 | 2698992189 | 2526471011 | 4210126723 |
| 2603029534 | 1047144830 | 3453843574 | 766865139 | 3593797804 |
| 2049387273 | 2982173936 | 1963216666 | 2115084288 | 429192890 |
| 3891424859 | 910285038 | 3509855005 | 4259411376 | 372093950 |
| 2152948345 | 4187576520 | 2358481858 | 3323683436 | 1779187770 |
| 4114760273 | 2589870048 | 747331248 | 568512177 | 3312189287 |
| 915180310 | 989448887 | 1957348676 | 3736601419 | 204349348 |
| 3754787998 | 3292758024 | 1097574450 | 1800276898 | 452421568 |
| 700503826 | 506322719 | 2435697214 | 4012458395 | 2800540462 |
| 2131559305 | 176010738 | 3870972145 | 1823982 | 3733109044 |
| 1308908630 | 1865471968 | 1888833893 | 27980198 | 1235082423 |
| 224437350 | 2619324712 | 2914085525 | 2023839966 | 1765319556 |
| 4065424007 | 564829442 | 4161315584 | 869505096 | 3174729780 |
| 3638665944 | 1996870325 | 1273113343 | 431161506 | 3762994475 |
| 1679385496 | 339697593 | 3269644828 | 1024804023 | 3171962488 |

(continued)

| | | | | |
|---|---|---|---|---|
| 3431345226 | 4071072948 | 3681293816 | 1853869307 | 442160826 |
| 1779595665 | 3618966336 | 412536684 | 3393537983 | 198349622 |
| 3068494238 | 2111320126 | 1156034077 | 1500703614 | 45942637 |
| 1424062773 | 1093955153 | 3823026442 | 3019471560 | 1324086311 |
| 1033448464 | 957978696 | 1066971017 | 1351086955 | 2901868599 |
| 4050396853 | 892010560 | 3598330293 | 3096933631 | 678860040 |
| 3302235057 | 1854601078 | 1979273937 | 3034634988 | 3812229107 |
| 420600373 | 1873407527 | 2079029895 | 2544598006 | 19936821 |
| 2868446243 | 2498544695 | 1195045909 | 1230942551 | 1119590141 |
| 311689386 | 2694156259 | 1071986421 | 3362230798 | 3640121682 |
| 259047959 | 1927339682 | 2712821515 | 159984793 | 3545931032 |
| 4057180909 | 1650555729 | 3377754595 | 491590373 | 2102949142 |
| 1575367248 | 183933047 | 2184151095 | 3993872886 | 2828208598 |
| 4151214153 | 3061444337 | 750918864 | 3681855622 | 3603378023 |
| 110249784 | 2067387204 | 2585729879 | 903593547 | 4135048896 |
| 3006865921 | 228962564 | 4249895712 | 3535062472 | |
| 4293710613 | 3904109414 | 1832579367 | 1799803217 | |
| 3501256572 | 1595995433 | 1192240192 | 772984149 | |
| 998007483 | 1780701372 | 946734366 | 895863112 | |
| 499288295 | 2463145963 | 31230688 | 1899036275 | |
| 1205710710 | 307281463 | 3174399083 | 4187322100 | |
| 2997199489 | 3237929991 | 3549375728 | 101856048 | |
| 640417429 | 3852995239 | 1642430184 | 234650315 | |
| 3044194711 | 2398693510 | 1904857554 | 3183125617 | |
| 486690751 | 3754138664 | 861877404 | 3190039692 | |
| 2686640734 | 522074127 | 3277825584 | 525584357 | |
| 2394526209 | 146352474 | 4267074718 | 1286834489 | |
| 2521660077 | 4104915256 | 3122860549 | 455810374 | |
| 49993987 | 3029415884 | 666423581 | 1869181575 | |

**Claims**

1. A method of encoding data for transmission from a source (101, 105) to a destination (170) over a communications channel (145), the method comprising:

   obtaining an ordered set of input symbols representing data to be encoded;
   selecting a plurality of field arrays of values, wherein each field array is a finite field array and the plurality of field arrays include at least two different finite field arrays;
   the method **characterized by** generating a data structure that represents a coefficient matrix having entries from at least two of the plurality of field arrays that are different finite field arrays;
   generating output symbols as linear combinations of input symbols with coefficients taken from the data structure that represents the coefficient matrix; and
   using the generated output symbols and an encoding for the data for transmission from the source to the destination.

2. The method of claim 1, wherein the data structure that represents a coefficient matrix is a two-dimensional array of cell values, each cell value representing a coefficient of one input symbol in the generation of one output symbol such that when a coefficient is not zero or zero modulo some base, the value of the corresponding output symbol depends on the value of the corresponding input symbol.

3. The method of claim 1, wherein the data structure that represents a coefficient matrix is a set of rules that specify coefficient values, and further wherein when a rule indicates that a coefficient is not zero or zero modulo some base, the value of the corresponding output symbol depends on the value of the corresponding input symbol.

4. The method of claim 1, wherein the generation of a data structure that represents a coefficient matrix having entries of at least two of the field arrays that are different finite field arrays is a generation that uses a first field array that is a first finite field array and a second field array that is a second finite field array, wherein the first finite field array and the second finite field array are different, and further wherein the first finite field and the second finite field are each selected from the field set consisting of Galois Fields GF(2), GF(4), GF(16), GF(256).

5. The method of claim 1, further comprising:

generating a plurality of redundant symbols from the ordered set of input symbols, wherein each redundant symbol is generated based on a set of linear constraints over one or more of the input symbols and other redundant symbols with coefficients over finite fields; and
generating a plurality of output symbols from the combined set of input and redundant symbols, wherein each output symbol is generated as a linear combination of one or more of the combined set of input and redundant symbols with coefficients chosen from finite fields.

6. A method (1000, 1025, 1050) of decoding data from a transmission received at a destination from a source over a communications channel (145), the method comprising:

receiving (1005, 1055) at least some of a plurality of output symbols generated from an ordered set of input symbols that were encoded into the plurality of output symbols wherein each output symbol was generated as a linear combination of one or more of the input symbols with coefficients chosen from a coefficient matrix having entries from at least two finite field arrays that are different finite field arrays, wherein at least one coefficient is a member of a first finite field and at least one other coefficient is a member of a second finite field and is not a member of the first finite field; and
regenerating (1010, 1020, 1060, 1075) the ordered set of input symbols to a desired degree of accuracy from reception of any predetermined number of the output symbols.

7. The method of claim 6, wherein the plurality of output symbols includes output symbols generated from a combined set of input symbols and a plurality of redundant symbols, wherein each output symbol is generated as a linear combination of one or more of a combined set of input and redundant symbols with coefficients chosen from finite fields, and wherein the plurality of redundant symbols is generated from the ordered set of input symbols, wherein each redundant symbol is generated based on a set of linear constraints over one or more of the input symbols and other redundant symbols with coefficients over finite fields.

8. The method of claim 6, wherein the finite fields are such that a first finite field array and a second finite field array are different and the first finite field and the second finite field are each selected from the field set consisting of Galois Fields GF(2), GF(4), GF(16), GF(256).

9. The method of claims 1 or 6, wherein the number of unique output symbols that can be generated from the set of input symbols, for any set of fixed values for the input symbols, is independent of the field array sizes.

10. The method of claims 4 or 8, wherein the first finite field array is GF(2) and the second finite field array is GF(256).

11. The method of claims 4 or 8, wherein the first finite field array is GF(2) and the second finite field array is GF(4).

12. The method of claims 4 or 8, wherein the first finite field array is GF(4) and the second finite field array is GF(16).

13. The method of claims 4 or 8, wherein the first finite field array is GF(16) and the second finite field array is GF(256).

14. The method of claims 4 or 8, wherein the first finite field array is smaller than the second finite field array.

15. The method of claims 4 or 8, wherein the first finite field array is larger than the second finite field array.

16. A device for encoding data for transmission from a source (101, 105) to a destination (170) over a communications channel (145), the device comprising:

means for obtaining an ordered set of input symbols representing data to be encoded;
means for selecting a plurality of field arrays of values, wherein each field array is a finite field array and the plurality of field arrays include at least two different finite field arrays;
the device **characterized by** further comprising
means for generating a data structure that represents a coefficient matrix having entries from at least two of the plurality of field arrays that are different finite field arrays;
means for generating output symbols as linear combinations of input symbols with coefficients taken from the data structure that represents the coefficient matrix; and
means for using the generated output symbols and an encoding for the data for transmission from the source to the destination.

17. A device for decoding data from a transmission received at a destination from a source over a communications channel (145), the device comprising:

means for receiving (1005, 1055) at least some of a plurality of output symbols generated from an ordered set of input symbols that were encoded into the plurality of output symbols wherein each output symbol was generated as a linear combination of one or more of the input symbols with coefficients chosen from a coefficient matrix having entries from at least two finite field arrays that are different finite field arrays, wherein at least one coefficient is a member of a first finite field and at least one other coefficient is a member of a second finite field and is not a member of the first finite field; and
means for regenerating (1010, 1020, 1060, 1075) the ordered set of input symbols to a desired degree of accuracy from reception of any predetermined number of the output symbols.

**Patentansprüche**

1. Ein Verfahren zum Codieren von Daten zur Sendung von einer Quelle (101, 105) an ein Ziel (170) über einen Kommunikationskanal (145), wobei das Verfahren Folgendes aufweist:

Erlangen eines geordneten Satzes von Eingabesymbolen, die Daten darstellen, die codiert werden sollen;
Auswählen einer Vielzahl von Feld- bzw. Körperanordnungen von Werten, wobei jede Körperanordnung eine endliche Körperanordnung ist und die Vielzahl von Körperanordnungen wenigstens zwei unterschiedliche finite bzw. endliche Körperanordnungen beinhaltet;
wobei das Verfahren **gekennzeichnet ist durch** Erzeugen einer Datenstruktur, die eine Koeffizientenmatrix darstellt mit Einträgen aus wenigstens zwei der Vielzahl von Körperanordnungen, die unterschiedliche endliche Körperanordnungen sind;
Erzeugen von Ausgabesymbolen als lineare Kombinationen von Eingabesymbolen mit Koeffizienten, die aus der Datenstruktur entnommen sind, die die Koeffizientenmatrix darstellt; und
Verwenden der erzeugten Ausgabesymbole und einer Codierung für die Daten zur Sendung von der Quelle an das Ziel.

2. Verfahren nach Anspruch 1, wobei die Datenstruktur, die eine Koeffizientenmatrix darstellt, eine zweidimensionale Anordnung von Zellwerten ist, wobei jeder Zellwert einen Koeffizienten eines Eingabesymbols bei der Erzeugung eines Ausgabesymbols darstellt, so dass, wenn ein Koeffizient nicht Null oder Null modulo irgendeiner Basis ist, der Wert des entsprechenden Ausgangssymbols von dem Wert des entsprechenden Eingabesymbols abhängt.

3. Verfahren nach Anspruch 1, wobei die Datenstruktur, die eine Koeffizientenmatrix darstellt, ein Satz von Regeln ist, die Koeffizientenwerte spezifizieren, und wobei weiter, wenn eine Regel anzeigt, dass ein Koeffizient nicht Null oder Null modulo irgendeiner Basis ist, der Wert des entsprechenden Ausgabesymbols von dem Wert des entsprechenden Eingabesymbols abhängt.

4. Verfahren nach Anspruch 1, wobei die Erzeugung einer Datenstruktur, die eine Koeffizientenmatrix darstellt, welche Einträge von wenigstens zwei der Körperanordnungen hat, die unterschiedliche endliche Körperanordnungen sind, eine Erzeugung ist, die eine erste Körperanordnung, welche eine erste endliche Körperanordnung ist, und eine zweite Körperanordnung, welche eine zweite endliche Körperanordnung ist, nutzt, wobei die erste endliche Körperanordnung und die zweite endliche Körperanordnung unterschiedlich sind, und wobei weiter der erste endliche Körper und der zweite endliche Körper jeweils aus dem Satz von Körpern ausgewählt sind der aus den Galois-Körpern bzw. -Feldern GF(2), GF(4), GF(16), GF(256) besteht.

5. Verfahren nach Anspruch 1, das weiter Folgendes aufweist:

Erzeugen einer Vielzahl von redundanten Symbolen aus dem geordneten Satz von Eingabesymbolen, wobei jedes redundante Symbol basierend auf einem Satz von linearen Bedingungen erzeugt wird, und zwar über ein oder mehrere der Eingabesymbole und andere redundante Symbole mit Koeffizienten über endliche Körper; und

Erzeugen einer Vielzahl von Ausgabesymbolen aus dem kombinierten Satz von Eingabesymbolen und redundanten Symbolen, wobei jedes Ausgabesymbol als eine lineare Kombination von ein oder mehreren des kombinierten Satzes von Eingabesymbolen und redundanten Symbolen mit Koeffizienten, die aus den endlichen Körpern ausgewählt sind.

6. Ein Verfahren (1000, 1025, 1050) zum Decodieren von Daten aus einer Sendung bzw. Übertragung, die an einem Ziel von einer Quelle über einen Kommunikationskanal (145) empfangen wird, wobei das Verfahren Folgendes aufweist:

Empfangen (1005, 1055) wenigstens einiger einer Vielzahl von Ausgabesymbolen, die aus einem geordneten Satz von Eingabesymbolen erzeugt wurden, die in die Vielzahl von Ausgabesymbolen codiert worden sind, wobei jedes Ausgabesymbol erzeugt wurde als eine lineare Kombination eines oder mehrerer der Eingabesymbole mit Koeffizienten, die aus einer Koeffizientenmatrix ausgewählt sind, welche Einträge aus wenigstens zwei endlichen Feld- bzw. Körperanordnungen hat, welche unterschiedliche endliche Körperanordnungen sind, wobei wenigstens ein Koeffizient ein Element eines ersten endlichen Körpers ist und wenigstens ein anderer Koeffizient ein Element eines zweiten endlichen Körpers ist und kein Element des ersten endlichen Körpers ist; und

Wiederherstellen (1010, 1020, 1060, 1075) des geordneten Satzes von Eingabesymbolen zu einem erwünschten Grad an Genauigkeit aus dem Empfang jeglicher vorbestimmen Anzahl der Ausgabesymbole.

7. Verfahren nach Anspruch 6, wobei die Vielzahl von Ausgabesymbolen Ausgabesymbole beinhaltet, die aus einem kombinierten Satz von Eingabesymbolen und einer Vielzahl von redundanten Symbolen erzeugt wurden, wobei jedes Ausgabesymbol als eine lineare Kombination von ein oder mehreren von einem kombinierten Satz von Eingabesymbolen und redundanten Symbolen mit Koeffizienten erzeugt wird, die aus endlichen Körpern ausgewählt sind, und wobei die Vielzahl redundanter Symbole aus dem geordneten Satz von Eingabesymbolen erzeugt wird, wobei jedes redundante Symbole erzeugt wird basierend auf einem Satz von linearen Bedingungen über ein oder mehrere Eingabesymbole und andere redundante Symbole mit Koeffizienten über endliche Körper.

8. Verfahren nach Anspruch 6, wobei die endlichen Körper derart sind, dass eine erste endliche Körperanordnung und eine zweite endliche Körperanordnung unterschiedlich sind und der erste endliche Körper und der zweite endliche Körper jeweils aus dem Satz von Körpern ausgewählt sind, der aus Galois-Körpern bzw. -Feldern GF(2), GF(4), GF(16), GF(256) besteht.

9. Verfahren nach Ansprüchen 1 oder 6, wobei die Anzahl eindeutiger Ausgabesymbole, die aus dem Satz von Eingabesymbolen erzeugt werden kann, und zwar für jeglichen Satz von festen Werten für die Eingabesymbole, unabhängig von der Größe der Körperanordnungen ist.

10. Verfahren nach Ansprüchen 4 oder 8, wobei die erste endliche Körperanordnung GF(2) ist und die zweite endliche Körperanordnung GF(256) ist.

11. Verfahren nach Ansprüchen 4 oder 8, wobei die erste endliche Körperanordnung GF(2) ist und die zweite endliche Körperanordnung GF(4) ist.

12. Verfahren nach Ansprüchen 4 oder 8, wobei die erste endliche Körperanordnung GF(4) ist und die zweite endliche Körperanordnung GF(16) ist.

13. Verfahren nach Ansprüchen 4 oder 8, wobei die erste endliche Körperanordnung GF(16) ist und die zweite endliche Körperanordnung GF(256) ist.

14. Verfahren nach Ansprüchen 4 oder 8, wobei die erste endliche Körperanordnung kleiner ist als die zweite endliche Körperanordnung.

**15.** Verfahren nach Ansprüchen 4 oder 8, wobei die erste endliche Körperanordnung größer ist als die zweite endliche Körperanordnung.

**16.** Eine Einrichtung zum Codieren von Daten zur Sendung bzw. Übertragung von einer Quelle (101, 105) an ein Ziel (170) über einen Kommunikationskanal (145), wobei die Einrichtung Folgendes aufweist:

Mittel zum Erlangen eines geordneten Satzes von Eingabesymbolen, die Daten darstellen, die codiert werden sollen;

Mittel zum Auswählen einer Vielzahl von Feld- bzw. Körperanordnungen von Werten, wobei jede Körperanordnung eine endliche Körperanordnung ist und die Vielzahl von Körperanordnungen wenigstens zwei unterschiedliche endliche Körperanordnungen beinhaltet;

wobei die Vorrichtung **dadurch gekennzeichnet ist, dass** sie weiter Folgendes aufweist:

Mittel zum Erzeugen einer Datenstruktur, die eine Koeffizientenmatrix darstellt mit Einträgen aus wenigstens zwei der Vielzahl von Körperanordnungen, die unterschiedliche endliche Körperanordnungen sind;

Mittel zum Erzeugen von Ausgabesymbolen als lineare Kombinationen von Eingabesymbolen mit Koeffizienten, die aus der Datenstruktur entnommen sind, die die Koeffizientenmatrix darstellt; und

Mittel zum Verwenden der erzeugten Ausgabesymbole und einer Codierung für die Daten zur Sendung von der Quelle an das Ziel.

**17.** Eine Einrichtung zum Decodieren von Daten aus einer Sendung bzw. Übertragung, die an einem Ziel von einer Quelle über einen Kommunikationskanal (145) empfangen wird, wobei die Vorrichtung Folgendes aufweist:

Mittel zum Empfangen (1005, 1055) wenigstens einiger einer Vielzahl von Ausgabesymbolen, die aus einem geordneten Satz von Eingabesymbolen erzeugt wurden, die in die Vielzahl von Ausgabesymbolen codiert worden sind, wobei jedes Ausgabesymbol erzeugt wurde als eine lineare Kombination eines oder mehrerer der Eingabesymbole mit Koeffizienten, die aus einer Koeffizientenmatrix ausgewählt wurden, welche Einträge aus wenigstens zwei endlichen Feld- bzw. Körperanordnungen hat, welche unterschiedliche endliche Körperanordnungen sind, wobei wenigstens ein Koeffizient ein Element eines ersten endlichen Körpers ist und wenigstens ein anderer Koeffizient ein Element eines zweiten endlichen Körpers ist und kein Element des ersten endlichen Körpers ist; und

Mittel zum Wiederherstellen (1010, 1020, 1060, 1075) des geordneten Satzes von Eingabesymbolen zu einem erwünschten Grad an Genauigkeit aus dem Empfang jeglicher vorbestimmen Anzahl der Ausgabesymbole.

**Revendications**

**1.** Procédé de codage de données pour transmission à partir d'une source (101, 105) vers une destination (170) sur un canal de communication (145), le procédé comprenant :

obtenir un ensemble ordonné de symboles d'entrée représentant des données à coder ;

sélectionner une pluralité de tableaux de champs de valeurs, chaque tableau de champ étant un tableau de champ fini et la pluralité de tableaux de champs comprenant au moins deux tableaux de champs finis différents ;

le procédé étant **caractérisé par** la génération d'une structure de données qui représente une matrice de coefficients ayant des éléments provenant d'au moins deux des tableaux de la pluralité de tableaux de champs qui sont des tableaux de champs finis différents ;

générer des symboles de sortie par combinaisons linéaires de symboles d'entrée avec des coefficients pris dans la structure de données qui représente la matrice de coefficients ; et

utiliser les symboles de sortie générés et un codage pour les données pour transmission à partir de la source vers la destination.

**2.** Procédé selon la revendication 1, dans lequel la structure de données qui représente une matrice de coefficients est un tableau bidimensionnel de valeurs de cellule, chaque valeur de cellule représentant un coefficient d'un symbole d'entrée dans la génération d'un symbole de sortie de telle sorte que lorsqu'un coefficient est non nul ou est nul modulo une certaine base, la valeur du symbole de sortie correspondant dépend de la valeur du symbole d'entrée correspondant.

**3.** Procédé selon la revendication 1, dans lequel la structure de données qui représente une matrice de coefficients est un ensemble de règles qui spécifient des valeurs de coefficients, et en outre dans lequel lorsqu'une règle indique qu'un coefficient est non nul ou nul modulo une certaine base, la valeur du symbole de sortie correspondant dépend de la valeur du symbole d'entrée correspondant.

4. Procédé selon la revendication 1, dans lequel la génération d'une structure de données qui représente une matrice de coefficients ayant des éléments d'au moins deux des tableaux qui sont des tableaux de champs finis différents est une génération qui utilise un premier tableau de champ qui est un premier tableau de champ fini et un deuxième tableau de champ qui est un deuxième tableau de champ fini, le premier tableau de champ fini et le deuxième tableau de champ fini étant différents, et en outre dans lequel chacun du premier champ fini et du deuxième champ fini est sélectionné dans l'ensemble de champs constitués des corps de Gallois GF(2), GF(4), GF(16), GF(256).

5. Procédé selon la revendication 1, comprenant en outre :

générer une pluralité de symboles redondants à partir de l'ensemble ordonné de symboles d'entrée,
dans lequel chaque symbole redondant est généré sur la base d'un ensemble de contraintes linéaires sur un ou plusieurs des symboles d'entrée et d'autres symboles redondants avec des coefficients sur des champs finis ; et
générer une pluralité de symboles de sortie à partir de l'ensemble combiné de symboles d'entrée et de symboles redondants, chaque symbole de sortie étant généré par une combinaison linéaire d'un plusieurs symboles de l'ensemble combiné de symboles d'entrée et de symboles redondants avec des coefficients choisis dans des champs finis.

6. Procédé (1000, 1025, 1050) de décodage de données à partir d'une transmission reçue au niveau d'une destination, provenant d'une source sur un canal de communication (145), le procédé comprenant :

recevoir (1005, 1055) au moins certains d'une pluralité de symboles de sortie générés à partir d'un ensemble ordonné de symboles d'entrées qui ont été codés en la pluralité de symboles de sortie, dans lequel chaque symbole de sortie a été généré par une combinaison linéaire d'un ou plusieurs des symboles d'entrée avec des coefficients choisis dans une matrice de coefficients ayant des éléments provenant d'au moins deux tableaux de champs finis qui sont des tableaux de champs finis différents, dans lequel au moins un coefficient est membre d'un premier champ fini et au moins un autre coefficient est membre d'un deuxième champ fini et n'est pas membre du premier champ fini ; et
régénérer (1010, 1020, 1060, 1075) l'ensemble ordonné de symboles d'entrée avec un degré souhaité de précision à partir de la réception d'un nombre prédéterminé quelconque des symboles de sortie.

7. Procédé selon la revendication 6, dans lequel la pluralité de symboles de sortie comprend des symboles de sortie générés à partir d'un ensemble combiné de symboles d'entrée et d'une pluralité de symboles redondants, dans lequel chaque symbole de sortie est généré par une combinaison linéaire d'un ou plusieurs symboles d'un ensemble combiné de symboles d'entrée et de symboles redondants avec des coefficients choisis dans des champs finis, dans lequel la pluralité de symboles redondants est générée à partir de l'ensemble ordonné de symboles d'entrée, dans lequel chaque symbole redondant est généré sur la base d'un ensemble de contraintes linéaires sur un ou plusieurs des symboles d'entrée et d'autres symboles redondants avec des coefficients sur des champs finis.

8. Procédé selon la revendication 6, dans lequel les champs finis sont tels qu'un premier tableau de champ fini et un deuxième tableau de champ fini sont différents et chacun du premier champ fini et du deuxième champ fini est sélectionné parmi l'ensemble de champs constitués des corps de Gallois GF(2), GF(4), GF(16), GF(256).

9. Procédé selon les revendications 1 ou 6, dans lequel le nombre de symboles de sortie uniques qui peuvent être générés à partir de l'ensemble de symboles d'entrée, pour tout ensemble de valeurs fixes des symboles d'entrée, est indépendant des tailles des tableaux de champs.

10. Procédé selon les revendications 4 ou 8, dans lequel le premier tableau de champ fini est GF(2), et le deuxième tableau de champ fini est GF(256).

11. Procédé selon les revendications 4 ou 8, dans lequel le premier tableau de champ fini est GF(2), et le deuxième tableau de champ fini est GF(4).

12. Procédé selon les revendications 4 ou 8, dans lequel le premier tableau de champ fini est GF(4), et le deuxième tableau de champ fini est GF(16).

13. Procédé selon les revendications 4 ou 8, dans lequel le premier tableau de champ fini est GF(16), et le deuxième tableau de champ fini est GF(256).

14. Procédé selon les revendications 4 ou 8, dans lequel le premier tableau de champ fini est plus petit que le deuxième tableau de champ fini.

15. Procédé selon les revendications 4 ou 8, dans lequel le premier tableau de champ fini est plus grand que le deuxième tableau de champ fini.

16. Dispositif pour coder des données pour transmission à partir d'une source (101, 105) vers une destination (170) sur un canal de communication (145), le dispositif comprenant :

   des moyens pour obtenir un ensemble ordonné de symboles d'entrée représentant des données à coder ;
   des moyens pour sélectionner une pluralité de tableaux de champs de valeurs, chaque tableau de champ étant un tableau de champ fini et la pluralité de tableaux de champs comprenant au moins deux tableaux de champs finis différents ;
   le dispositif étant **caractérisé en ce qu'**il comprend en outre
   des moyens pour générer une structure de données qui représente une matrice de coefficients ayant des éléments provenant d'au moins deux des tableaux de champ de la pluralité de tableaux de champs qui sont des tableaux de champs finis différents ;
   des moyens pour générer des symboles de sortie par combinaisons linéaires de symboles d'entrée avec des coefficients pris dans la structure de données qui représente la matrice de coefficients ; et
   des moyens pour utiliser les symboles de sortie générés et un codage pour les données pour transmission à partir de la source vers la destination.

17. Dispositif pour décoder des données à partir d'une transmission reçue au niveau d'une destination, provenant d'une source sur un canal de communication (145), le dispositif comprenant :

   des moyens pour recevoir (1005, 1055) au moins certains d'une pluralité de symboles de sortie générés à partir d'un ensemble ordonné de symboles d'entrées qui ont été codés en la pluralité de symboles de sortie, dans lequel chaque symbole de sortie a été généré par une combinaison linéaire d'un ou plusieurs des symboles d'entrée avec des coefficients choisis dans une matrice de coefficients ayant des éléments provenant d'au moins deux tableaux de champs finis qui sont des tableaux de champs finis différents, dans lequel au moins un coefficient est membre d'un premier champ fini et au moins un autre coefficient est membre d'un deuxième champ fini et n'est pas membre du premier champ fini ; et
   des moyens pour régénérer (1010, 1020, 1060, 1075) l'ensemble ordonné de symboles d'entrée avec un degré souhaité de précision à partir de la réception d'un nombre prédéterminé quelconque des symboles de sortie.

100

RANDOM NUMBER GENERATOR — 135

STATIC KEY GENERATOR — 130

DYNAMIC KEY GENERATOR — 120

$S_0, S_1, ....$

$I_0, I_1, I_2, ...$

INPUT FILE — 101

INPUT FILE STREAM — 105

INPUT SYMBOL GENERATOR — 110

$IS(0), IS(1), IS(2),...$

ENCODER — 115

K

$B(I_0), B(I_1), B(I_2), ...$

TRANSMIT MODULE — 140

CHANNEL — 145

RECEIVE MODULE — 150

STATIC KEY GENERATOR — 130

RANDOM NUMBER GENERATOR — 135

$S_0, S_1, ....$

INPUT FILE REASSEMBLER — 165

$IS(0), IS(1), IS(2),...$

DECODER — 155

$B(I_a), B(I_b), B(I_c), ...$

K, R

DYNAMIC KEY REGENERATOR — 160

$I_a, I_b, I_c, ...$

INPUT FILE — 170

Figure 1

115

205

| IS(0), IS(1), IS (2), ... , IS(K-1) |

$I_0$, $I_1$, $I_2$, ...

$S_0$, $S_1$, ....

210

STATIC
ENCODER

K

RE(0), RE(1),
...., RE(R-1)

220

DYNAMIC
ENCODER

R

230

REDUNDANCY
CALCULATOR

K

K+R

$B(I_0)$, $B(I_1)$, $B(I_2)$, ...

Figure 2

300

305

j = 0

310

$RE(0) = F_0(IS(0), ..., IS(K-1))$

315

j = j + 1

320

j > R - 1 ?

YES

END

NO

325

$RE(j) = F_j(IS(0), ..., IS(K-1), RE(0), ... RE(j-1))$

Figure 3

| IS(0) | IS(1) | ....... | IS(K-1) | RE(0) | ....... | RE(j-1) | ? | ...... | ? | 205 |

$$F_j$$

RE(j)

| IS(0) | IS(1) | ....... | IS(K-1) | RE(0) | ....... | RE(j-1) | RE(j) | ...... | ? | 205 |

# Figure 4

500

POSITIONS

| 0 | 1 | 2 | | K-1 | K | | K+R-1 |
|---|---|---|---|---|---|---|---|
| IS(0) | IS(1) | IS(2) | ....... | IS(K-1) | RE(0) | .......... | RE(R-1) |

505

SYMBOL BUFFER

515

I →
K+R → **ASSOCIATOR** AL(I)

↑ W(I)

I →
K+R → **WEIGHT SELECTOR** W(I)   510

I →
K+R → **VALUE FUNCTION SELECTOR** F(I)

525

**CALCULATOR**

B(I)

Output Symbols

Figure 5

POSITION

| 0 | 1 | 2 | 3 | 4 | ... | K+R-2 | K+R-1 |
|---|---|---|---|---|---|---|---|
VALUE | IS(0) | IS(1) | IS(2) | IS(3) | IS(4) | ... | RE(R-2) | RE(R-1) |

505

XOR

B(I)

Figure 6

600

625

| IS(0), IS(1), IS (2), ... , IS(K-1) |
|---|

$S_0, S_1, ....$

610

620

**HAMMING ENCODER**

K →

HA(0), HA(1), ...., HA(D)

**LDPC ENCODER**

LD(0), LD(1), ...., LD(E-1)

D (number of redundant symbols to generate minus 1)

605

K →

**PARAMETER CALCULATOR**

K + D

R →

E (number of redundant symbols to generate)

**Figure 7**

Figure 8

700

705

D = 1

710

$2^D$-D-1 < K?

730

NO → E = R-D-1

YES

720

D = D+1

END

Figure 9

800

805

i = 0

810

COMPUTE t AS THE
SMALLEST ODD INTEGER
LARGER THAN K/2

815

DETERMINE $P_1$, $P_2$, ..., $P_t$ BASED
ON t, K, and $S_i$

820

RE(i) = IS($P_1$) $\oplus$ ... $\oplus$ IS($P_t$)

825

i = i+1

830

NO

i > R-1?

YES

END

Figure 10

900

$B(I_a)$, $B(I_b)$, $B(I_c)$, ...

$I_a$, $I_b$, $I_c$, ...

K+R

905

DYNAMIC
DECODER

915

IS(0), ? , IS (2), ... , IS(K-1), RE(0), ? . ... RE(R-1)

910

K+R

STATIC
DECODER

$S_0$, $S_1$, ...

Figure 11

1000

1005

RECEIVE Q OUTPUT SYMBOLS

1010

REGENERATE INPUT SYMBOLS
AND REDUNDANT SYMBOLS
WITH DYNAMIC DECODER

1015

DONE
DECODING?

YES

NO

1020

REGENERATE INPUT SYMBOLS
WITH STATIC DECODER

END

Figure 12

Figure 13

1050

1055

RECEIVE OUTPUT SYMBOLS

1060

REGENERATE INPUT SYMBOLS
AND REDUNDANT SYMBOLS
WITH DYNAMIC DECODER

1065

NO — STOP DECODING?

YES

1070

DESIRED ACCURACY REACHED? — YES

NO

1075

REGENERATE INPUT SYMBOLS
WITH STATIC DECODER

END

Figure 14

1100

KEY I

K+R

B(I)

510
WEIGHT SELECTOR

520
FUNCTION SELECTOR

W(I)

515
ASSOC.

F(I)

AL(I)

| I | W(I) | AL(I) | F(I) | B(I) |
|---|------|-------|------|------|
| ... | ... | ... | ... | ... |

I, W(I), AL(I), B(I), F(I)

1115
Reducer

IS(AL(I))

RE(AL(I))

I, W(I), AL(I), B(I), F(I)

1120
Reconstructor

IS(AL(I))= B(I)

RE(AL(I)) =B(I)

B(I), AL(I), F(I) for W(I)=1

1105

OUTPUT SYMBOL BUFFER

1125

| IS(0) |
| ? |
| IS(2) |
| ? |
| ? |
| IS(5) |
| IS(6) |
| ... |
| IS(K-1) |
| RE(0) |
| ? |
| RE(2) |
| ... |

RECONSTRUCTION BUFFER

Figure 15

1200

1215

| |
|---|
| IS(0) |
| ? |
| IS(2) |
| ? |
| ? |
| IS(5) |
| IS(6) |
| ... |
| ? |
| RE(0) |
| ? |
| RE(2) |
| ... |
| ? |

RECONSTRUCTION
BUFFER

$S_0, S_1, ....$

K, D, E

1205

LDPC DECODER

K, D

1210

HAMMING
DECODER

Figure 16

| 0 | 1 | 2 | ... | ... | ... | ... | $K$-1 |
|---|---|---|---|---|---|---|---|
| $K$ | $K$+1 | $K$+2 | ... | ... | ... | ... | 2·$K$-1 |
| 2·$K$ | 2·$K$+1 | 2·$K$+2 | ... | ... | ... | ... | 3·$K$-1 |
| ... | ... | ... | ... | ... | ... | ... | |
| ($N$-1)·$K$ | ... | ... | ... | ... | ... | ... | $N$·$K$-1 |

**Fig. 17**

| File size $F$ | $G$ | Symbol size $T$ | $G*T$ | $K_t$ | Source blocks $Z$ | Sub-blocks $N$ | $K_L$ | $K_S$ | $T_L \cdot A$ | $T_S \cdot A$ |
|---|---|---|---|---|---|---|---|---|---|---|
| 100 KB | 1 | 512 | 512 | 200 | 1 | 1 | 200 | 200 | N/A | N/A |
| 300 KB | 1 | 512 | 512 | 600 | 1 | 2 | 600 | 600 | 128 | 128 |
| 1,000 KB | 1 | 512 | 512 | 2,000 | 1 | 5 | 2,000 | 2,000 | 104 | 100 |
| 3,000 KB | 1 | 512 | 512 | 6,000 | 1 | 12 | 6,000 | 6,000 | 44 | 40 |
| 10,000 KB | 1 | 512 | 512 | 20,000 | 3 | 14 | 6,666 | 6,667 | 40 | 36 |

**Fig. 18**

| Max source block size $B$ | $P_{30}$ | $G$ | Symbol size $T$ |
|---|---|---|---|
| 16KB | 1424 | 1 | 1424 |
| 32KB | 1424 | 1 | 1424 |
| 128KB | 700 | 2 | 712 |

**Fig. 19**

| 1. | 2.K | 3.S | 4.H |
|---|---|---|---|
| 5.S | 6.$\mathbf{G}_{\text{LDPC}}$ | 7.$\mathbf{I}_S$ | 8.$\mathbf{Z}_{SxH}$ |
| 9.H | 10.$\mathbf{G}_{\text{Half}}$ | | 11.$\mathbf{I}_H$ |
| 12.K | 13.$\mathbf{G}_{\text{LT}}$ | | |

**Fig. 20**

| Index $j$ | $f[j]$ | $d[j]$ |
|---|---|---|
| 0 | 0 | -- |
| 1 | 10241 | 1 |
| 2 | 491582 | 2 |
| 3 | 712794 | 3 |
| 4 | 831695 | 4 |
| 5 | 948446 | 10 |
| 6 | 1032189 | 11 |
| 7 | 1048576 | 40 |

**Fig. 21**

Fig. 22

Figure 23

Figure 24a

Figure 24b

i

u

i

i by i Identity
matrix

U$_{upper}$

N+S-i

0

U$_{lower}$

Figure 25

u

s

I

W

m

0

Figure 26

Figure 27

Figure 28

Figure 29

L

i by i Identity
matrix

$U_{upper}$

L

0

u by u
identity
matrix

Figure 30

Figure 31

Figure 32

| Failure probabilities for (120,100) code | |
|---|---|
| Reception Overhead (A) | Failure probability |
| 0 | $1.7 \times 10^{-2}$ |
| 1 | $1.25 \times 10^{-4}$ |
| 2 | $2.56 \times 10^{-6}$ |
| 3 | $< 1 \times 10^{-8}$ |
| 4 | $< 1 \times 10^{-8}$ |
| 5 | $< 1 \times 10^{-8}$ |
| 6 | $< 1 \times 10^{-8}$ |
| 7 | $< 1 \times 10^{-8}$ |
| 8 | $< 1 \times 10^{-8}$ |
| 9 | $< 1 \times 10^{-8}$ |
| 10 | $< 1 \times 10^{-8}$ |
| 11 | $< 1 \times 10^{-8}$ |
| 12 | $< 1 \times 10^{-8}$ |
| 13 | $< 1 \times 10^{-8}$ |
| 14 | $< 1 \times 10^{-8}$ |
| 15 | 0 |
| 16 | 0 |
| 17 | 0 |
| 18 | 0 |
| 19 | 0 |
| 20 | 0 |

| Failure probabilities for (110,100) code | |
|---|---|
| Reception Overhead (A) | Failure probability |
| 0 | $4.8 \times 10^{-3}$ |
| 1 | $3.11 \times 10^{-5}$ |
| 2 | $1.37 \times 10^{-7}$ |
| 3 | $< 1 \times 10^{-8}$ |
| 4 | $< 1 \times 10^{-8}$ |
| 5 | $< 1 \times 10^{-8}$ |
| 6 | 0 |
| 7 | 0 |
| 8 | 0 |
| 9 | 0 |
| 10 | 0 |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2005219070 A1

**Non-patent literature cited in the description**

- **BLOEMER ; KALFANE ; KARPINKSI ; KARP ; LUBY ; ZUCKERMAN.** An XOR-based erasure resilient coding scheme. *Technical Report Number TR-95-048 of the International Computer Science Institute in Berkeley,* 1995

- **V. ROCA ; C. NEUMANN.** Design, Evaluation and Comparison of Four Large Block FEC Codecs, LDPC, LDGM, LDGM Staircase and LDGM Triangle, plus a Reed-Solomon Small Block FEC Codec. *INRIA Research Report RR-5225,* June 2004, www.inri-alpes.fr
- **M.C. DAVEY ; D.J.C. MACKAY.** Low Density Parity Check Codes over GF(q). *IEEE Communications Letters,* 1998, vol. 2 (6), 165-167